# EUROPEAN PATENT APPLICATION

(11) **EP 4 837 735 A1**
(43) Date of publication of application: **11.11.2026**
(21) Application number: 25752266.4
(22) Date of filing: 07.02.2025
(51) Int. Cl.: B32B 9/00, B32B 17/06, B32B 27/00, C09K 3/18, G02B 1/04, G02B 1/18

(54) **LAMINATE**

(30) Priority: 09.02.2024 JP 2024018921
(71) Applicant: DAIKIN INDUSTRIES, LTD., Osaka-shi, Osaka 530-0001 (JP)
(72) Inventor: TAKANO, Shinya, Osaka-Shi, Osaka 530-0001 (JP); KATSUMA, Nozomi, Osaka-Shi, Osaka 530-0001 (JP); HARA, Manami, Osaka-Shi, Osaka 530-0001 (JP); NOMURA, Takashi, Osaka-Shi, Osaka 530-0001 (JP)
(74) Representative: Hoffmann Eitle
(86) International application number: PCT/JP2025/004143
(87) International publication number: WO 2025/170043

(57) **Abstract**

A laminate comprising a substrate and a water-repellent layer located on the substrate, wherein a nitrogen concentration on a surface of the water-repellent layer is 0.01 atomic% or more and 10 atomic% or less, and a fluorine concentration on the surface of the water-repellent layer is less than 5 atomic%.

## Description

### Technical Field

The present disclosure relates to a laminate.

### Background Art

Certain types of silane compounds are known to be capable of providing excellent water- and oil-repellency when used in surface treatment of a substrate (Patent Literature 1).

### Citation List

### Patent Literature

Patent Literature 1: JP 2019-44179 A

### Summary of Invention

### Technical Problem

An object of the present disclosure is to provide a laminate including a water-repellent layer having better water-repellency, lubricity, and abrasion durability.

### Solution to Problem

The present disclosure includes the following embodiments.
[1] A laminate comprising a substrate and a water-repellent layer located on the substrate,
   wherein a nitrogen concentration on a surface of the water-repellent layer is 0.01 atomic% or more and 10 atomic% or less, and
   a fluorine concentration on the surface of the water-repellent layer is less than 5 atomic%.
[2] The laminate according to item 1,
   wherein a silicon concentration on the surface of the water-repellent layer is 0.1 atomic% or more and 50 atomic% or less.
[3] The laminate according to item 1 or 2,
   wherein a silicon concentration on the surface of the water-repellent layer is 15 atomic% or more and 25 atomic% or less.
[4] The laminate according to any one of items 1 to 3, wherein the water-repellent layer is a cured product of a compound represented by the following formula (1):
   [Formula 1]

   R^{S}- X¹-(R^{Si})_{α} (1)

   wherein
   R^{S} is a monovalent group containing one or more Si atoms to which neither a hydroxyl group nor a hydrolyzable group is directly bonded,
   X¹ is a di- to decavalent group,
   R^{Si} is a monovalent group containing a Si atom to which a hydroxyl group or a hydrolyzable group is bonded, and
   α is an integer of 1 to 9.
[5] The laminate according to item 4,
   wherein R^{S} is a group represented by R¹-(R^{S1})ₛ₁-(SiR²₂)ₛ₂-(R^{Ar})ₛ₃-,
   wherein R¹ is a hydrocarbon group, or the following group A or group B,
   the group A and the group B are groups represented by the following formulae:
      [Formula 2] R⁵¹ₙₐR⁵²₃₋ₙₐSi-(O)_{z}- (A) 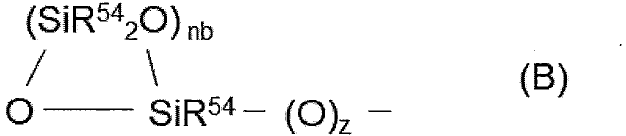 [wherein
   R⁵¹ is each independently a group represented by R⁵³-(SiR⁵³₂-R⁶¹)ₘₐ-,
      R⁶¹ is each independently a single bond, an oxygen atom or a C₁₋₆ alkylene group,
      R⁵³ is each independently a hydrocarbon group or R^{51'},
         R^{51'} has the same meaning as R⁵¹,
      ma is each independently an integer of 1 to 5,
      provided that the number of R^{51'} in R⁵¹ is 20 or less,
      R⁵² is each independently a hydrocarbon group,
      na is an integer of 1 to 3,
      R⁵⁴ is each independently a hydrocarbon group,
      nb is an integer of 1 to 5, and
      z is 0 or 1],
   R^{S1} is each independently a single bond, or a group represented by the following formula: 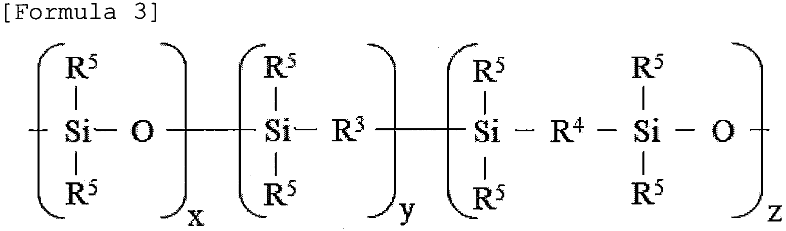 [wherein
   R³ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
   R⁴ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
   R⁶ is each independently a C₁₋₆ alkylene group,
   R⁷ is each independently an optionally substituted arylene group,
   R⁸ is each independently a single bond or a C₁₋₆ alkylene group,
   R⁹ is each independently a single bond or an oxygen atom,
   R⁵ is each independently a hydrocarbon group,
   x is an integer of 0 to 500,
   y is an integer of 0 to 500,
   z is an integer of 0 to 500,
   x + y + z is 1 or more, and
   the occurrence order of the respective repeating units enclosed in parentheses provided with x, y, or z is not limited in the formula],
   R² is each independently a hydrocarbon group, and
   s1, s2, and s3 are 0 or 1.
[6] The laminate according to item 4,
   wherein the compound represented by the formula (1) is any one of the following compounds:
   CH₃-[Si(CH₃)₂O]ₙ₁Si(CH₃)₂-(CH₂)_{H1}-C (=O)NHCH₂CH₂CH₂Si(OCH₃)₃
   CH₃CH₂CH₂CH₂-[Si(CH₃)₂O]ₙ₁Si(CH₃)₂-(CH₂)_{H1}-C (=O)NHCH₂CH₂CH₂Si(OCH₃)₃
   [(CH₃)₃SiO)]₂(CH₃)Si-O- [Si(CH₃)₂O]ₙ₁Si(CH₃)₂-(CH₂)_{H1}-C(=O)NHCH₂CH₂CH₂Si(OCH₃)₃
   [(CH₃)₃SiO)]₃Si-O-[Si(CH₃)₂O]ₙ₁Si(CH₃)₂-(CH₂)_{H1}-C(=O)NHCH₂CH₂CH₂Si(OCH₃)₃
   CH₃-[Si(CH₃)₂O]ₙ₁Si(CH₃)₂-(CH₂)_{H1}-O-(CH₂)_{H2}-C (=O)NHCH₂CH₂CH₂Si(OCH₃)₃
   CH₃CH₂CH₂CH₂-[Si(CH₃)₂O]ₙ₁Si(CH₃)₂-(CH₂)_{H1}-O-(CH₂)_{H2}-C (=O)NHCH₂CH₂CH₂Si(OCH₃)₃
   CH₃-[Si(CH₃)₂O]ₙ₁Si(CH₃)₂-(CH₂)_{H1}-C (=O)NHCH₂CH[CH₂CH₂CH₂Si(OCH₃)₃]₂
   CH₃CH₂CH₂CH₂-[Si(CH₃)₂O]ₙ₁Si(CH₃)₂-(CH₂)_{H1}-C (=O)NHCH₂CH[CH₂CH₂CH₂Si(OCH₃)₃]₂
   [(CH₃)₃SiO)]₂(CH₃)Si-O-[Si(CH₃)₂O]ₙ₁Si(CH₃)₂-(CH₂)_{H1}-C(=O)NHCH₂CH[CH₂CH₂CH₂Si(OCH₃)₃]₂
   [(CH₃)₃SiO)]₃Si-O-[Si(CH₃)₂O]ₙ₁Si(CH₃)₂-(CH₂)_{H1}-C(=O)NHCH₂CH[CH₂CH₂CH₂Si(OCH₃)₃]₂
   CH₃-[Si(CH₃)₂O]ₙ₁Si(CH₃)₂-(CH₂)_{H1}-O-(CH₂)_{H2}-C(=O)NHCH₂CH[CH₂CH₂CH₂Si(OCH₃)₃]₂
   CH₃CH₂CH₂CH₂-[Si(CH₃)₂O]ₙ₁Si(CH₃)₂-(CH₂)_{H1}-O-(CH₂)_{H2}-C(=O)NHCH₂CH[CH₂CH₂CH₂Si(OCH₃)₃]₂
   CH₃-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
   CH₃CH₂CH₂CH₂-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
   [(CH₃)₃SiO)]₂(CH₃)Si-O-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
   [(CH₃)₃SiO)]₃Si-O-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
   CH₃-[Si(CH₃)₂O]ₙ₁Si(CH₃)₂-(CH₂)_{H1}-O-(CH₂)_{H2}-C(=O)NHCH₂CH[CH₂CH₂CH₂CH₂CH₂CH₂CH₂CH₂CH₂CH₂CH₂Si(OCH₃)₃]₂
   CH₃CH2CH₂CH₂-[Si(CH₃)₂O]ₙ₁Si(CH₃)₂-(CH₂)_{H1}-O-(CH₂)_{H2}-C (=O)NHCH₂CH[CH₂CH₂CH₂CH₂CH₂CH₂CH₂CH₂CH₂CH₂CH₂Si(OCH₃)₃]₂
   CH₃-[Si(CH₃)₂O]ₙ₁Si(CH₃)₂-(CH₂)_{H1}-C(=O)N[CH₂CH₂CH₂Si(OCH₃)₃]₂
   CH₃CH₂CH₂CH₂-[Si(CH₃)₂O]ₙ₁Si(CH₃)₂-(CH₂)_{H1}-C(=O)N[CH₂CH₂CH₂Si(OCH₃)₃]₂
   [(CH₃)₃SiO)]₂(CH₃)Si-O-[Si(CH₃)₂O]ₙ₁Si(CH₃)₂-(CH₂)_{H1}-C(=O)N[CH₂CH₂CH₂Si(OCH₃)₃]₂
   [(CH₃)₃SiO)]₃Si-O-[Si(CH₃)₂O]ₙ₁Si(CH₃)₂-(CH₂)_{H1}-C(=O)N[CH₂CH₂CH₂Si(OCH₃)₃]₂
   CH₃-[Si(CH₃)₂O]ₙ₁Si(CH₃)₂-(CH₂)_{H1}-O-(CH₂)_{H2}-C(=O)N[CH₂CH₂CH₂Si(OCH₃)₃]₂
   CH₃CH₂CH₂CH₂-[Si(CH₃)₂O]ₙ₁Si(CH₃)₂-(CH₂)_{H1}-O-(CH₂)_{H2}-C(=O)N[CH₂CH₂CH₂Si(OCH₃)₃]2
   CH₃-[Si(CH₃)₂O]ₙ₁Si(CH₃)₂-(CH₂)_{H1}-N[CH₂CH₂CH₂Si(OCH₃)₃]₂
   CH₃CH₂CH₂CH₂-[Si(CH₃)₂O]ₙ₁Si(CH₃)₂-(CH₂)_{H1}-N[CH₂CH₂CH₂Si(OCH₃)₃]₂
   [(CH₃)₃SiO)]₂(CH₃)Si-O-[Si(CH₃)₂O]ₙ₁Si(CH₃)₂-(CH₂)_{H1}-N[CH₂CH₂CH₂Si(OCH₃)₃]₂
   [(CH₃)₃SiO)]₃Si-O-[Si(CH₃)₂O]ₙ₁Si(CH₃)₂-(CH₂)_{H1}-N[CH₂CH₂CH₂Si(OCH₃)₃]₂
   CH₃-[Si(CH₃)₂O]ₙ₁Si(CH₃)₂-(CH₂)_{H1}-C(=O)NHCH₂C[CH₂CH₂CH₂Si(OCH₃)₃]₃
   CH₃CH₂CH₂CH₂-[Si(CH₃)₂O]ₙ₁Si(CH₃)₂-(CH₂)_{H1}-C(=O)NHCH₂C[CH₂CH₂CH₂Si(OCH₃)₃]₃
   [(CH₃)₃SiO)]₂(CH₃)Si-O-[Si(CH₃)₂O]ₙ₁Si(CH₃)₂-(CH₂)_{H1}-C(=O)NHCH₂C[CH₂CH₂CH₂Si(OCH₃)₃]₃
   [(CH₃)₃SiO)]₃Si-O-[Si(CH₃)₂O]ₙ₁Si(CH₃)₂-(CH₂)_{H1}-C(=O)NHCH₂C[CH₂CH₂CH₂Si(OCH₃)₃]₃
   CH₃-[Si(CH₃)₂O]ₙ₁Si(CH₃)₂-(CH₂)_{H1}-O-(CH₂)_{H2}-C(=O)NHCH₂C[CH₂CH₂CH₂Si(OCH₃)₃]₃
   CH₃CH₂CH₂CH₂-[Si(CH₃)₂O]ₙ₁Si(CH₃)₂-(CH₂)_{H1}-O-(CH₂)_{H2}-C(=O)NHCH₂C[CH₂CH₂CH₂Si(OCH₃)₃]₃
   [(CH₃)₃SiO)]₂(CH₃)Si-(CH₂)_{H1}-C(=O)NHCH₂CH₂CH₂Si(OCH₃)₃
   [(CH₃)₃SiO)]₃Si-(CH₂)_{H1}-C(=O)NHCH₂CH₂CH₂Si(OCH₃)₃
   [(CH₃)₃SiO)]₂(CH₃)Si-(CH₂)_{H1}-C(=O)NHCH₂CH[CH₂CH₂CH₂Si(OCH₃)₃]₂
   [(CH₃)₃SiO)]₃Si-(CH₂)_{H1}-C(=O)NHCH₂CH[CH₂CH₂CH₂Si(OCH₃)₃]₂
   [(CH₃)₃SiO)]₂(CH₃)Si-(CH₂)_{.H1}-C(=O)NHCH₂CH[CH₂CH₂CH₂CH₂CH₂CH₂CH₂CH₂CH₂CH₂CH₂Si(OCH₃)₃]₂
   [(CH₃)₃SiO)]₃Si-(CH₂)_{H1}-C(=O)NHCH₂CH[CH₂CH₂CH₂CH₂CH₂CH₂CH₂CH₂CH₂CH₂CH₂Si(OCH₃)₃]₂
   [(CH₃)₃SiO)]₂(CH₃)Si-(CH₂)_{H1}-C(=O)N[CH₂CH₂CH₂Si(OCH₃)₃]₂
   [(CH₃)₃SiO)]₃Si-(CH₂)_{H1}-C(=O)N[CH₂CH₂CH₂Si(OCH₃)₃]₂
   [(CH₃)₃SiO)]₂(CH₃)Si-(CH₂)_{H1}-N[CH₂CH₂CH₂Si(OCH₃)₃]₂
   [(CH₃)₃SiO)]₃Si-(CH₂)_{H1}-N[CH₂CH₂CH₂Si(OCH₃)₃]₂
   [(CH₃)₃SiO)]₂(CH₃)Si-(CH₂)_{H1}-C(=O)NHCH₂C[CH₂CH₂CH₂Si(OCH₃)₃]₃
   [(CH₃)₃SiO)]₃Si-(CH₂)_{H1}-C(=O)NHCH₂C[CH₂CH₂CH₂Si(OCH₃)₃]₃ 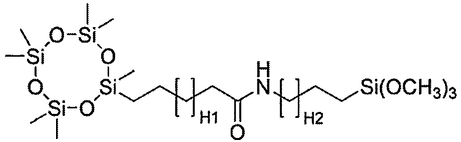 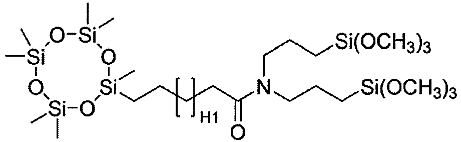 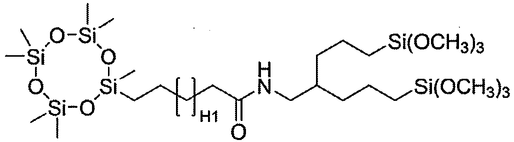 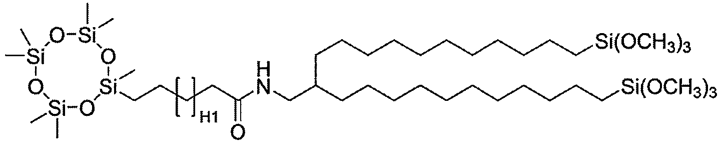 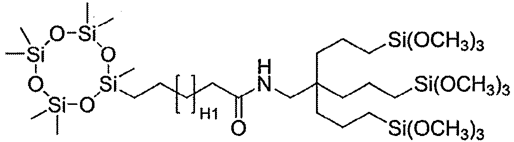
   CH₃CH₂CH₂CH₂-[Si(CH₃)₂O]ₙ₁Si(CH₃)₂-(CH₂)_{H1}-O-(CH₂)_{H2}-C(CH₂CH₃)[CH₂OC(=O)NHCH₂CH₂CH₂Si(OCH₃)₃]₂
   CH₃-[Si(CH₃)₂O]ₙ₁Si(CH₃)₂-(CH₂)_{H1}-O-(CH₂)_{H2}-C(CH₂CH₃)[CH₂OC(=O)NHCH₂CH₂CH₂Si(OCH₃)₃]₂
   CH₃CH₂CH₂CH₂-[Si(CH₃)₂O]ₙ₁Si(CH₃)₂-(CH₂)_{H1}-O-(CH₂)_{H2}-C(CH₂CH₃)[CH₂OC(=O)NHCH₂CH₂OC(=O)CH(CH₃)CH₂Si(OCH₃)₃]₂
   CH₃-[Si(CH₃)₂O]ₙ₁Si(CH₃)2-(CH₂)_{H1}-O-(CH₂)_{H2}-C(CH₂CH₃)[CH₂OC(=O)NHCH₂CH₂OC(=O)CH(CH₃)CH₂Si(OCH₃)₃]₂
   CH₃CH₂CH₂CH₂-[Si(CH₃)₂O]ₙ₁Si(CH₃)₂-(CH₂)_{H1}-O-(CH₂)_{H2}-C[CH₂OC(=O)NHCH₂CH₂CH₂Si(OCH₃)₃]₃
   CH₃-[(Si(CH₃)₂O)]ₙ₁Si(CH₃)₂-(CH₂)_{H1}-O-(CH₂)_{H2}-C[CH₂OC(=O)NHCH₂CH₂CH₂Si(OCH₃)₃]₃
   [CH₃CH₂CH₂CH₂-[(Si(CH₃)₂O)]ₙ₁Si(CH₃)₂-(CH₂)_{H1}-O-(CH₂)_{H2}-]₂-C[CH₂OC(=O)NHCH₂CH₂CH₂Si(OCH₃)₃]₂
   [CH₃-[(Si(CH₃)₂O)]ₙ₁Si(CH₃)₂-(CH2)_{H1}-O-(CH₂)_{H2}-]₂-C[CH₂OC(=O)NHCH₂CH₂CH₂Si(OCH₃)₃]₂
   CH₃CH₂CH₂CH₂-[Si(CH₃)₂O]ₙ₁Si(CH₃)₂-(CH₂)_{H1}-O-(CH₂)_{H2}-OC(=O)NHCH₂CH₂CH₂Si(OCH₃)₃
   CH₃-[Si(CH₃)₂O]ₙ₁Si(CH₃)₂-(CH₂)_{H1}-O-(CH₂)_{H2}-OC(=O)NHCH₂CH₂CH₂Si(OCH₃)₃
   CH₃CH₂CH₂CH₂-[Si(CH₃)₂O]ₙ₁Si(CH₃)₂-(CH₂)_{H1}-O-(CH₂)_{H2}-OC(=O)NHCH₂CH₂OC(=O)CH(CH₃)CH₂Si(OCH₃)₃
   CH₃-[Si(CH₃)₂O]ₙ₁Si(CH₃)₂-(CH2)_{H1}-O-(CH₂)_{H2}-OC(=O)NHCH₂CH₂OC(=O)CH(CH₃)CH₂Si(OCH₃)₃
   [CH₃CH₂CH₂CH₂-[Si(CH₃)₂O]ₙ₁Si(CH₃)₂-(CH₂)_{H1}-O-(CH₂)_{H2}-]₃C-CH₂OC(=O)NHCH₂CH₂CH₂Si(OCH₃)₃
   [CH₃-[Si(CH₃)₂O]n₁Si(CH₃)₂-(CH₂)_{H1}-O-(CH₂)_{H2}-]₃C-CH₂OC(=O)NHCH₂CH₂CH₂Si(OCH₃)₃
   [CH₃CH2CH₂CH₂-[(Si(CH₃)₂O)]ₙ₁Si(CH₃)₂-(CH₂)_{H1}-O-(CH₂)_{H2}-]₂C(CH₂CH₃)[CH₂OC(=O)NHCH₂CH₂CH₂Si(OCH₃)₃]
   [CH₃-[(Si(CH₃)₂O)]ₙ₁Si(CH₃)₂-(CH₂)_{H1}-O-(CH₂)_{H2}-]₂C(CH₂CH₃)[CH₂OC(=O)NHCH₂CH₂CH₂Si(OCH₃)₃] wherein
   n1 is each independently an integer of 0 to 100, and
   H1 and H2 are each independently an integer of 1 to 50.
[7] The laminate according to item 6,
   wherein n1 is each independently 0 or 1,
   H1 is each independently an integer of 8 to 40, and
   H2 is each independently an integer of 1 to 10.
[8] The laminate according to item 6,
   wherein n1 is each independently an integer of 5 to 100,
   H1 is each independently an integer of 8 to 40, and
   H2 is each independently an integer of 1 to 10.
[9] The laminate according to item 4, wherein the compound represented by the formula (1) is any one of the following compounds:
   CH₃CH₂CH₂CH₂Si(CH₃)₂O(Si(CH₃)₂O)ₙSi(CH₃)₂CH₂CH₂CH₂OCH₂CON HCH₂CH₂CH₂Si(OCH₃)₃ (wherein n is an integer of 40 to 70);
   CH₃CH₂CH₂CH₂Si(CH₃)₂-(OSi(CH₃)₂)ₙ-(CH₂)₃-OCH₂-CONH-CH₂C{CH₂CH₂CH₂Si(OCH₃)₃}₃ (wherein n is an integer of 40 to 70); 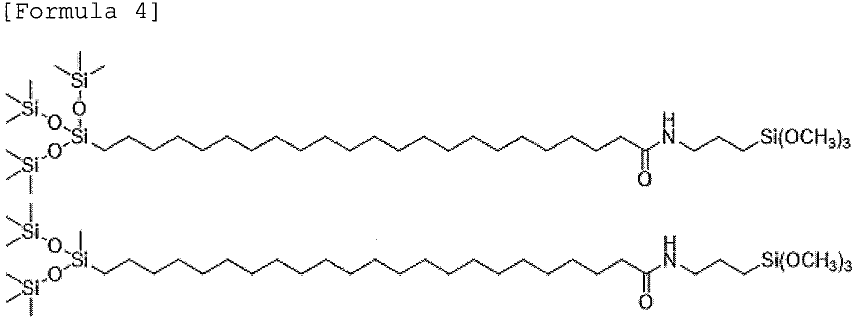
   CH₃Si(CH₃)₂O(Si(CH₃)₂O)ₙSi(CH₃)₂(CH₂)₁₀CONHCH₂CH₂CH₂Si(OC H₃)₃ (wherein n is an integer of 10 to 30);
   (CH₃)₃Si-(OSi(CH₃)₂)ₙ-(CH₂)₁₀-CON[CH₂CH₂CH₂Si(OCH₃)₃]₂ (wherein n is an integer of 10 to 30);
   [(CH₃)₃SiO]₂CH₃SiO(Si(CH₃)₂O)ₙSi(CH₃)₂CH₂CH₂CH₂CH₂CH₂CH₂C H₂CH₂CH₂CH₂CH₂CH₂CH₂CH₂CH₂CH₂CH₂CH₂CH₂CH₂CH₂CH₂CONHCH₂CH[CH₂CH₂ CH₂Si(OCH₃)₃]₂ (wherein n is an integer of 20 to 40);
   CH₃[Si(CH₃)₂O]ₙSi(CH₃)₂(CH₂)₂₂CONH-CH₂CH[CH₂CH₂CH₂Si(OCH₃)₃]₂ (wherein n is an integer of 40 to 70);
   CH₃CH₂CH₂CH₂-[Si(CH₃)₂O]ₙSi(CH₃)₂-CH₂CH₂CH₂-O-CH₂-C(CH₂CH₃)[CH₂OC(=O)NHCH₂CH₂CH₂Si(OCH₃)₃]₂ (wherein n is an integer of 40 to 80);
   CH₃CH₂CH₂CH₂-[Si(CH₃)₂O]ₙSi(CH₃)₂-CH₂CH₂CH₂-O-CH₂CH₂O-C(=O)NHCH₂CH₂CH₂Si(OCH₃)₃ (wherein n is an integer of 40 to 80); 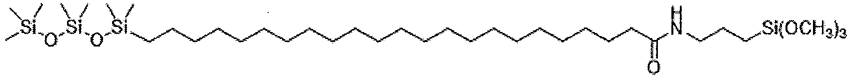 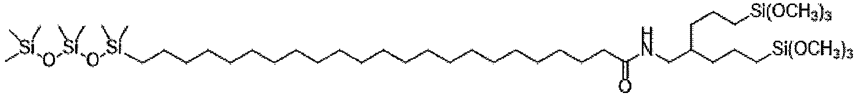
   CH₃[Si(CH₃)₂O]ₙSi(CH₃)₂(CH₂)₂₂CON[CH₂CH₂CH₂Si(OCH₃)₃]₂ (wherein n is an integer of 20 to 40);
   CH₃(Si(CH₃)₂O)ₙSi(CH₃)₂(CH₂)₂₂CON[CH₂CH₂CH₂Si(OCH₃)₃]₂ (wherein n is an integer of 20 to 50); and
   CH₃[Si(CH₃)₂O]ₙSi(CH₃)₂(CH₂)₂₂CON[(CH₂)₃Si(OCH₃)₃]₂ (wherein n is an integer of 40 to 60).
[10] The laminate according to any one of items 1 to 9, wherein the water-repellent layer is a cured product of a mixture of a compound represented by the formula (1) and a compound represented by the following formula (2):
   [Formula 5]

   R^{A}_{α1}-X^{A}-R^{Si}_{β1} (2)

   wherein
   R^{A} is a carbon chain containing at least one ethereal oxygen atom,
   X^{A} is a single bond, or a di- to decavalent group,
   R^{Si} has the same meaning as R^{Si} in the compound represented by the formula (1),
   α1 is each independently an integer of 1 to 9, and
   β1 is each independently an integer of 1 to 9.
[11] The laminate according to any one of items 1 to 10, wherein a water contact angle of the water-repellent layer is 103° or more.
[12] An article comprising the laminate according to any one of items 1 to 11.
[13] The article according to item 12, comprising, between the substrate and the water-repellent layer, a silicon oxide-containing intermediate layer.
[14] The article according to item 13, wherein the intermediate layer comprises an alkali metal atom.
[15] The article according to item 14, wherein at least some of the alkali metal atoms are sodium atoms.
[16] The article according to any one of items 12 to 15, which is an optical member.
[17] The article according to any one of items 12 to 16, which is a display.
[18] A compound represented by any of the following formulae:
   (CH₃)₃SiO-Si(CH₃)₂O-Si(CH₃)₂-(CH₂)_{H1}-C (=O) NHCH₂CH₂CH₂Si(OCH₃)₃
   (CH₃)₃SiO-Si(CH₃)₂O-Si(CH₃)₂-(CH₂)_{H1}-C (=O) NHCH₂CH[CH₂CH₂CH₂Si(OCH₃)₃]₂
   (CH₃)₃SiO-Si(CH₃)₂O-Si(CH₃)₂-(CH₂)_{H1}-C (=O) N[CH₂CH₂CH₂Si(OCH₃)₃]₂
   (CH₃)₃SiO-Si(CH₃)₂O-Si(CH₃)₂-(CH₂)_{H1}-C (=O)NHCH₂C[CH₂CH₂CH₂Si(OCH₃)₃]₃
   wherein H1 is an integer of 11 to 50.

### Advantageous Effect of invention

The present disclosure can provide a laminate including a water-repellent layer having better water-repellency, lubricity, and abrasion durability.

### Description of Embodiments

The term "monovalent organic group" as used herein refers to a carbon-containing monovalent group. The monovalent organic group is not limited, and may be a hydrocarbon group or a derivative thereof. The derivative of a hydrocarbon group refers to a group that has one or more of N, O, S, Si, amide, sulfonyl, siloxane, carbonyl, carbonyloxy, and the like at the terminal or in the molecular chain of the hydrocarbon group. The term simply referred to as an "organic group" means a monovalent organic group. The term "divalent organic group" refers to a carbon-containing divalent group. The divalent organic group may be, for example, a divalent group obtained by further removing one hydrogen atom from the organic group. Similarly, an organic group having a valence of 3 or more refers to a group obtained by removing a predetermined number of hydrogen atoms from an organic group.

The "hydrocarbon group" as used herein refers to a group containing carbon and hydrogen that is obtained by removing a hydrogen atom from a hydrocarbon. Examples of the hydrocarbon group include, but are not limited to, C₁₋₃₀ hydrocarbon groups, such as an aliphatic hydrocarbon group and an aromatic hydrocarbon group. The "aliphatic hydrocarbon group" may be either linear, branched, or cyclic, and may be either saturated or unsaturated. The hydrocarbon group may contain one or more ring structures. The hydrocarbon group may be substituted with one or more substituents.

Examples of the substituent of the "hydrocarbon group" as used herein include, but are not limited to, a halogen atom; and one or more groups selected from a C₁₋₆ alkyl group, a C₂₋₆ alkenyl group, a C₂₋₆ alkynyl group, a C₃₋₁₀ cycloalkyl group, a C₃₋₁₀ unsaturated cycloalkyl group, a 5- to 10-membered heterocyclyl group, a 5- to 10-membered unsaturated heterocyclyl group, a C₆₋₁₀ aryl group, and a 5- to 10-membered heteroaryl group each optionally substituted with one or more halogen atoms.

The "hydrolyzable group" as used herein refers to a group that can undergo a hydrolysis reaction, i.e., refers to a group that can be removed from the main backbone of the compound by a hydrolysis reaction. Examples of the hydrolyzable group include -OR^{h}, -OCOR^{h}, -O-N=CR^{h}₂, -NR^{h}₂, -NHR^{h}, or -NCO (in these formulae, R^{h} represents a substituted or unsubstituted alkyl group having 1 to 4 carbon atoms), and -OR^{h} (i.e., an alkoxy group) is preferable. Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable.

A laminate of the present disclosure comprises a substrate, and a water-repellent layer located on the substrate,
wherein the nitrogen concentration on the surface of the water-repellent layer is 0.01 atomic% or more and 10 atomic% or less, and
the fluorine concentration on the surface of the water-repellent layer is less than 5 atomic%.

### [Substrate]

The type of the substrate included in the laminate of the present disclosure is not limited, and the substrate may be composed of any suitable material such as glass, resin (which may be natural or synthetic resin such as a commonly used plastic material), metal, ceramics, semiconductors (such as silicon and germanium), fiber (such as woven fabric and nonwoven fabric), fur, leather, wood, pottery, stone, building materials, sanitary articles.

For example, when the article to be produced is an optical member, the material constituting the surface of the substrate may be a material for an optical member, such as glass or a transparent plastic. When the article to be produced is an optical member, some layer (or film), such as a hard coat layer or an antireflection layer, may be formed on the surface (the outermost layer) of the substrate. The antireflection layer may be any of a single-layer antireflection layer and a multi-layer antireflection layer. Examples of inorganic substances usable in the antireflection layer include SiO₂, SiO, ZrO₂, TiO₂, TiO, Ti₂O₃, Ti₂O₅, Al₂O₃, Ta₂O₅, Ta₃O₅, Nb₂O₅, HfO₂, Si₃N₄, CeO₂, MgO, Y₂O₃, SnO₂, MgF₂, and WO₃. One of these inorganic substances may be used singly, or two or more kinds thereof may be used in combination (for example, as a mixture). In the case of a multi-layer antireflection layer, SiO₂ and/or SiO is preferably used in the outermost layer thereof. When the article to be produced is an optical glass component for a touch panel, a part of the surface of the substrate (glass) may have a transparent electrode such as a thin film in which indium tin oxide (ITO), indium zinc oxide, or the like is used. The substrate, according to its specific configuration or the like, may have an insulating layer, an adhesive layer, a protecting layer, a decorated frame layer (ICON), an atomizing film layer, a hard coating layer, a polarizing film, a phase difference film, a liquid crystal display module, or the like.

The form of the substrate is not limited, and may be, for example, a plate, a film, or the like. The surface region of the substrate on which the water-repellent layer is to be formed may be at least a portion of the substrate surface, and may be suitably determined according to the application, specific configuration, and the like of an article to be produced.

In one embodiment, the substrate, or at least the surface portion thereof, may be composed of a material originally having a hydroxyl group. Examples of the material include glass, as well as metal (in particular, base metal) that forms a natural oxidized film or a thermal oxidized film on its surface, ceramics, and semiconductors. Alternatively, when the substrate has an insufficient amount of hydroxyl groups or when the substrate originally has no hydroxyl group as in resin and the like, a pre-treatment may be performed on the substrate to thereby introduce or increase hydroxyl groups on the surface of the substrate. Examples of such a pre-treatment include a plasma treatment (for example, corona discharge) and ion beam irradiation. The plasma treatment can be suitably utilized to not only introduce or increase hydroxyl groups on the substrate surface, but also clean the substrate surface (remove foreign matter and the like). Another example of such a pre-treatment is a method wherein a monolayer of a surface adsorbent having a carbon-carbon unsaturated bond-containing group is formed on the surface of the substrate by a LB method (a Langmuir-Blodgett method), a chemical adsorption method, or the like beforehand, and thereafter cleaving the unsaturated bond under an atmosphere containing oxygen, nitrogen, or the like.

In another embodiment, the substrate, or at least the surface portion thereof, may be composed of a material comprising another reactive group such as a silicone compound having one or more Si-H groups or alkoxysilane.

In a preferable embodiment, the substrate is glass. Such glass is not limited, and examples include sapphire glass, soda-lime glass, alkali aluminosilicate glass, borosilicate glass, alkali-free glass, crystal glass, quartz glass, crystallized glass, chemically strengthened soda-lime glass, chemically strengthened alkali aluminosilicate glass, and chemically bonded borosilicate glass.

The thickness of the substrate is not limited, but is, for example, 5 µm or more, preferably 10 µm or more, and more preferably 20 µm or more. In addition, the thickness of the substrate is, for example, 20 mm or less, preferably 10 mm or less, and more preferably 8 mm or less.

### [Water-repellent layer]

The water-repellent layer included in the laminate of the present disclosure is located on the substrate. In the present disclosure, the phrase "on the substrate" does not necessarily refer only to an embodiment in which the water-repellent layer is in direct contact with the substrate, but can also refer to, for example, an embodiment in which an intermediate layer is present between the substrate and the water-repellent layer. In a preferred embodiment, the water-repellent layer is located on the surface of the laminate.

The water-repellent layer included in the laminate of the present disclosure may be formed by applying a surface-treating agent onto the substrate or the intermediate layer.

The water-repellent layer included in the laminate of the present disclosure has, on the surface thereof, a nitrogen concentration of 0.01 atomic% or more and 10 atomic% or less, and a fluorine concentration of less than 5 atomic%.

In one embodiment, the nitrogen concentration on the surface of the water-repellent layer is 0.01 atomic% or more and 10 atomic% or less.

In one embodiment, the fluorine concentration on the surface of the water-repellent layer is less than 5 atomic%. In a more preferable embodiment, the fluorine concentration on the surface of the water-repellent layer is less than 1 atomic%. In a more preferable embodiment, the fluorine concentration on the surface of the water-repellent layer is less than 0.1 atomic%.

In a preferable embodiment, the silicon concentration on the surface of the water-repellent layer is 0.1 atomic% or more and 50 atomic% or less.

In a more preferable embodiment, the silicon concentration on the surface of the water-repellent layer is 15 atomic% or more and 25 atomic% or less.

Note that the concentrations of the respective elements on the surface of the water-repellent layer can be determined by surface analysis. As a method for the surface analysis, an X-ray photoelectron spectroscopy (XPS) analysis method, a time-of-flight secondary ion mass spectrometry method, or the like can be used. Typically, the XPS analysis method is used.

As an apparatus for performing the XPS analysis method to measure the concentrations of the respective elements on the surface of the water-repellent layer, PHI 5000 VersaProbe II manufactured by ULVAC-PHI, Inc. may be used. As measurement conditions for the XPS analysis, it is possible to use a monochromatized Al Kα radiation at 25 W as an X-ray source, a photoelectron detection area of 1400 µm × 300 µm, a photoelectron detection angle in a range of 20 degrees to 90 degrees (for example, 20 degrees, 45 degrees, or 90 degrees), a pass energy of 23.5 eV, and Ar ions as sputter ions. By employing the apparatus and measurement conditions, based on the spectra of N1s, F1s, and Si2p orbitals, the concentrations of nitrogen, fluorine, and silicon on the surface of the water-repellent layer can be determined.

Specific measurement method and conditions may be as follows.

The XPS measurement can be performed on the surface of the water-repellent layer formed on the substrate, using an X-ray photoelectron spectroscopy apparatus (XPS, PHI 5000 VersaProbe II manufactured by ULVAC-PHI, Inc.).

The measurement conditions for XPS analysis are, for example, as follows:
X-ray source: monochromatized Al Kα radiation (25 W)
Photoelectron detection area: 1400 µm × 300 µm
Photoelectron detection angle: 45 degrees
Pass energy: 23.5 eV
Measured elements: carbon (C1s) 278 to 298 eV, nitrogen (N1s) 390 to 410 eV, oxygen (O1s) 523 to 543 eV, fluorine (F1s) 680 to 698 eV, silicon (Si2p) 94 to 114 eV

The atomic ratio corresponding to each element can be calculated from the peak shape and intensity obtained in each region.

The detection depth can be appropriately adjusted by modulating the photoelectron detection angle in the XPS analysis. For example, a shallow angle close to 20 degrees can restrict the detection depth to approximately 3 nm, whereas a deep angle close to 90 degrees can extend the detection depth to over 10 nm.

Note that in the compositional analysis by XPS, when silicon derived from the substrate is detected, the silicon concentration derived from the water-repellent layer and the silicon concentration derived from the substrate can be separated from each other by calculating the amount of substrate-derived Si from the detected amount of trace metal atoms contained in the substrate (such as Al, Na, K, B, Ca, Mg, and Sn), when the substrate is glass, and subtracting this calculated amount from the measurement result.

In one embodiment, in measuring the silicon concentration on the surface of the water-repellent layer, silicon derived from the intermediate layer such as a silicon dioxide layer may be detected. In another embodiment, in measuring the silicon concentration on the surface of the water-repellent layer, silicon derived from the intermediate layer such as a silicon dioxide layer is not detected.

The nitrogen concentration on the surface of the water-repellent layer is defined as the atomic ratio relative to the total amount of carbon, nitrogen, oxygen, fluorine, and silicon.

The fluorine concentration on the surface of the water-repellent layer is defined as the atomic ratio relative to the total amount of carbon, nitrogen, oxygen, fluorine, and silicon.

The silicon concentration on the surface of the water-repellent layer is defined as the atomic ratio relative to the total amount of carbon, nitrogen, oxygen, fluorine, and silicon.

The nitrogen concentration, fluorine concentration, and silicon concentration can be determined by measuring these concentrations at three different points on the surface of the water-repellent layer and calculating the average value thereof.

In a preferable embodiment, the water-repellent layer included in the laminate of the present disclosure is obtained by treating, on the substrate, a compound represented by the following formula (1) (namely, a silane compound):
[Formula 6]

R^{S}- X¹- (R^{Si})_{α} (1)

wherein
R^{S} is a monovalent group containing one or more Si atoms to which neither a hydroxyl group nor a hydrolyzable group is directly bonded,
X¹ is a di- to decavalent group,
R^{Si} is a monovalent group containing a Si atom to which a hydroxyl group or a hydrolyzable group is bonded, and
α is an integer of 1 to 9.
In other words, the water-repellent layer included in the laminate of the present disclosure may be a cured product of the silane compound.

R^{S} is a monovalent group containing one or more Si atoms to which neither a hydroxyl group nor a hydrolyzable group is directly bonded.

In one embodiment, R^{S} is a group having at least one branched structure of Si.

The branched structure is preferably the following structure: 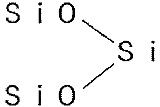 In the above formula, the Si atom is tetravalent, but the other bonds are not shown.

In one embodiment, the branched structure may be any of the following structures: 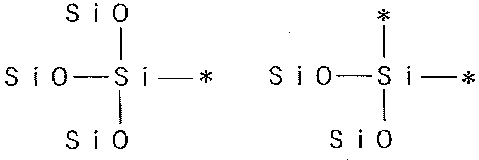 wherein * represents a bonding site. In other words, the branched structure may have two SiO branches or three SiO branches. In the above formulae, although the Si atom in the SiO is tetravalent, the other bonds are not shown.

The bonding site represented by * may be bonded to another group not bonded to X¹ that may be contained in R^{S}, may be bonded to a group bonded to X¹ that may be contained in R^{S}, or may be directly bonded to X¹. When the branched structure contains one *, it is preferable that the * is bonded to a group bonded to X¹ that may be contained in R^{S}, or is directly bonded to X¹. When two or more * are contained, these * are independently bonded to another group not bonded to X¹ that may be contained in R^{S}, or may be bonded to a group bonded to X¹ that may be contained in R^{S}, or to X¹ itself, and preferably, at least one * is bonded to X¹ or to a group bonded to X¹.

In one embodiment, R^{S} is a group represented by R¹-(R^{S1})ₛ₁-(SiR²₂)s₂-(R^{Ar})ₛ₃-,
wherein R¹ is a hydrocarbon group, or following group A or group B,
the group A and the group B are groups represented by the following formulae: 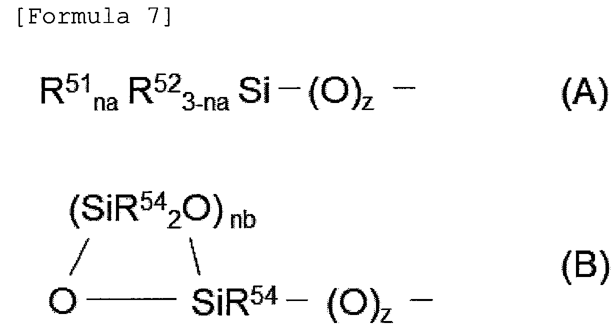 [wherein
R⁵¹ is each independently a group represented by R⁵³-(SiR⁵³₂-R⁶¹)ₘₐ-,
   R⁶¹ is each independently a single bond, an oxygen atom or a C₁₋₆ alkylene group,
   R⁵³ is each independently a hydrocarbon group or R^{51'},
      R^{51'} has the same meaning as R⁵¹,
   ma is each independently an integer of 1 to 5,
   provided that the number of R^{51'} in R⁵¹ is 20 or less,
   R⁵² is each independently a hydrocarbon group,
   na is an integer of 1 to 3,
   R⁵⁴ is each independently a hydrocarbon group,
   nb is an integer of 1 to 5, and
   z is 0 or 1],
   R^{S1} is each independently a single bond, or a group represented by the following formula: 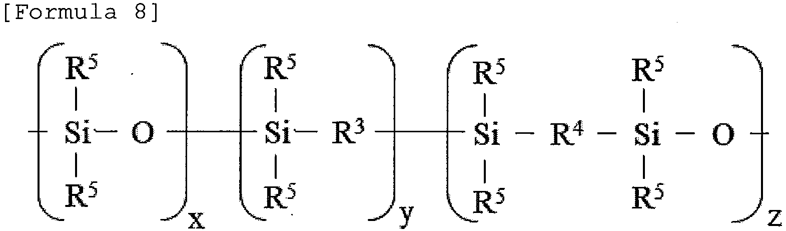 [wherein
   R³ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
   R⁴ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
   R⁶ is each independently a C₁₋₆ alkylene group,
   R⁷ is each independently an optionally substituted arylene group,
   R⁸ is each independently a single bond or a C₁₋₆ alkylene group,
   R⁹ is each independently a single bond or an oxygen atom,
   R⁵ is each independently a hydrocarbon group,
   x is an integer of 0 to 500,
   y is an integer of 0 to 500,
   z is an integer of 0 to 500,
   x + y + z is 1 or more, and
   the occurrence order of the respective repeating units enclosed in parentheses provided with x, y, or z is not limited in the formula],
   R² is each independently a hydrocarbon group, and
   s1, s2, and s3 are 0 or 1.

R¹ is a hydrocarbon group, the group A, or the group B.

In one embodiment, R¹ is a hydrocarbon group. The hydrocarbon group in R¹ may preferably be an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, a n-butyl group, or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

The hydrocarbon group in R¹ is preferably an alkyl group, and more preferably an alkyl group having 1 to 4 carbon atoms.

In one embodiment, R¹ is a C₁₋₆ alkyl group, preferably a C₁₋₃ alkyl group, and more preferably a methyl group.

In one embodiment, R¹ is a C₁₋₆ alkyl group, preferably a C₁₋₄ alkyl group, and more preferably a n-butyl group.

In a preferable embodiment, R¹ is the group A or the group B, and more preferably the group A.

(Group A)

R⁵¹ₙₐR⁵² ₛ₋ₙₐSi-(O)_{z}- (A)

R⁵¹ is each independently a group represented by R⁵³-(SiR⁵³₂-R⁶¹)ₘₐ-.

R⁶¹ is each independently a single bond, an oxygen atom or a C₁₋₆ alkylene group.

The C₁₋₆ alkylene group in R⁶¹ may be linear or may be branched. The C₁₋₆ alkylene group may be preferably a C₁₋₄ alkylene group, and more preferably a C₂₋₄ alkylene group.

In one embodiment, R⁶¹ is an oxygen atom or a C₁₋₆ alkylene group.

In one embodiment, R⁶¹ is an oxygen atom.

In one embodiment, some of R⁶¹ are oxygen atoms, and the other are C₁₋₆ alkylene groups.

R⁵³ is each independently a hydrocarbon group or R⁵¹'.

The hydrocarbon group in R⁵³ may be preferably an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

R⁵³ is preferably an alkyl group, and more preferably an alkyl group having 1 to 4 carbon atoms.

R^{51'} has the same meaning as R⁵¹. That is, R^{51'} is R⁵³-(SiR⁵³₂O)ₘₐ-. However, in R⁵¹, the number of R^{51'} is 20 or less, preferably 10 or less, more preferably 6 or less, and even more preferably 3 or less.

In one embodiment, R⁵³ is each independently a hydrocarbon group or R⁵¹'.

In a preferable embodiment, R⁵³ is each independently a hydrocarbon group.

In one embodiment, R⁵³ is R⁵³'-(SiR⁵³'₂-R⁶¹')_{ma'}-wherein
R⁵³' is each independently a hydrocarbon group or R⁵³-(SiR⁵³₂-R⁶¹)ₘₐ-,
at least one R⁵³' is R⁵³-(SiR⁵³₂-R⁶¹)ₘₐ-
   R⁵³ is each independently a hydrocarbon group,
   R⁶¹ is each independently a single bond, an oxygen atom or a C₁₋₆ alkylene group,
   ma is each independently an integer of 1 to 5,
   R⁶¹' is each independently an oxygen atom or a C₁₋₆ alkylene group, and
   ma' is each independently an integer of 1 to 5.

In another embodiment, R⁵³ is R⁵³'-(SiR⁵³'₂-R⁶¹')_{ma'}-wherein
R⁵³' is each independently a hydrocarbon group or R⁵³"-(SiR⁵³"₂-R⁶¹")_{ma"}-,
at least one R⁵³' is R⁵³"-(SiR⁵³"₂-R⁶¹")_{ma"}-,
   R⁵³" is each independently a hydrocarbon group or R⁵³-(SiR⁵³₂-R⁶¹)ₘₐ-,
   at least one R⁵³" is R⁵³-(SiR⁵²₂-R⁶¹)ₘₐ-
      R⁵³ is each independently a hydrocarbon group,
      R⁶¹ is each independently an oxygen atom or a C₁₋₆ alkylene group,
      ma is each independently an integer of 1 to 5,
   R⁶¹" is each independently an oxygen atom or a C₁₋₆ alkylene group,
   ma" is each independently an integer of 1 to 5,
R⁶¹' is each independently an oxygen atom or a C₁₋₆ alkylene group, and
ma' is each independently an integer of 1 to 5.

ma is each independently an integer of 1 to 5, and preferably 1 or 2.

R⁵² is each independently a hydrocarbon group.

The hydrocarbon group in R⁵² may preferably be an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

R⁵² is preferably an alkyl group, and more preferably an alkyl group having 1 to 4 carbon atoms.

na is an integer of 1 to 3. In one embodiment, na is 2. In another embodiment, na is 3. Note that na, when R^{51'} is present, is independently selected for (SiR⁵³₂-R⁶¹)ₘₐ.

z is 0 or 1. In one embodiment, z is 0. In another embodiment, z is 1.

In a preferable embodiment, in the group A,
R⁵¹ is each independently a group represented by R⁵³-(SiR⁵³₂-R⁶¹)ₘₐ-,
R⁶¹ is each independently a single bond, an oxygen atom or a C₁₋₆ alkylene group, and preferably an oxygen atom or a C₁₋₆ alkylene group,
R⁵³ is each independently a hydrocarbon group, and preferably an alkyl group having 1 to 4 carbon atoms,
ma is 1 or 2,
R⁵² is each independently a hydrocarbon group, and preferably an alkyl group having 1 to 4 carbon atoms, and na is 1 or 2.

Examples of the group A include, but are not limited to, the following groups:

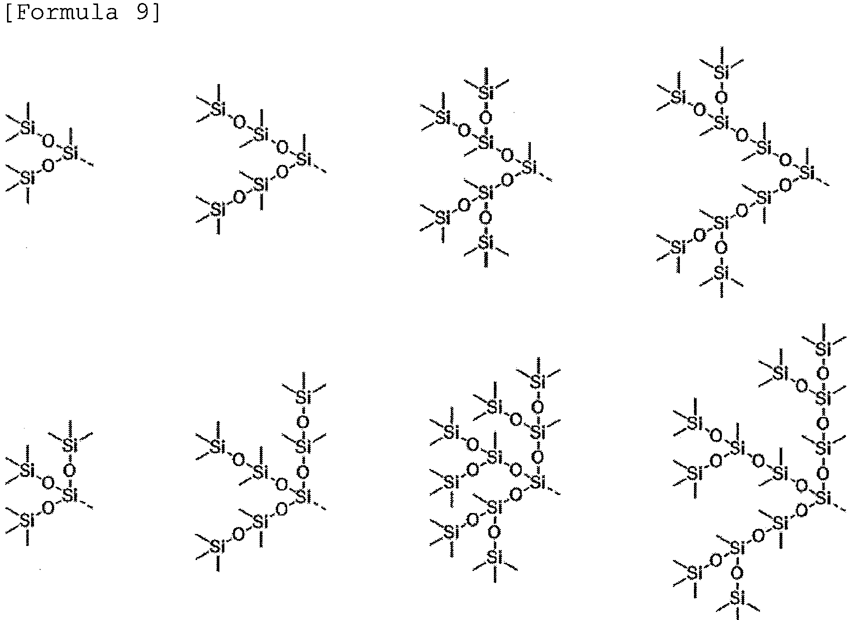

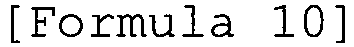

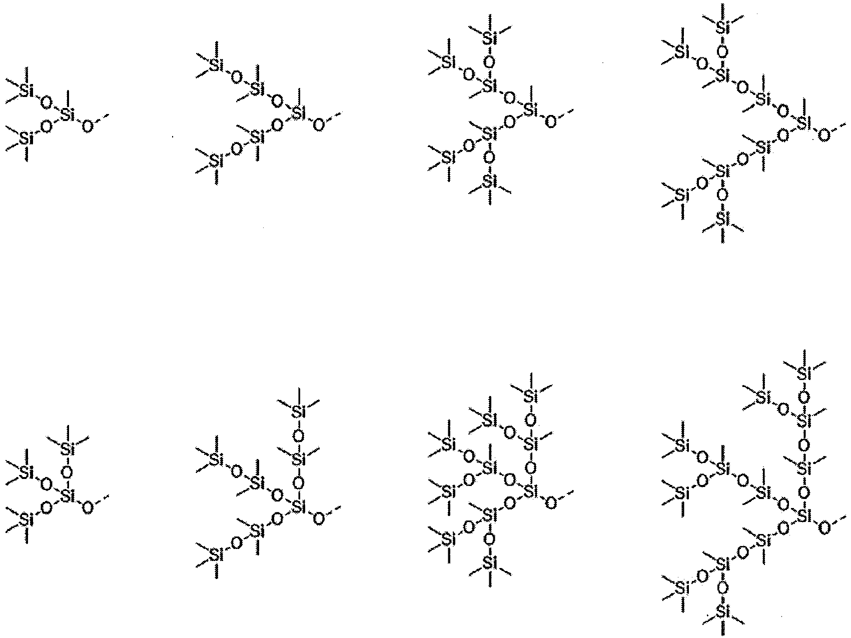

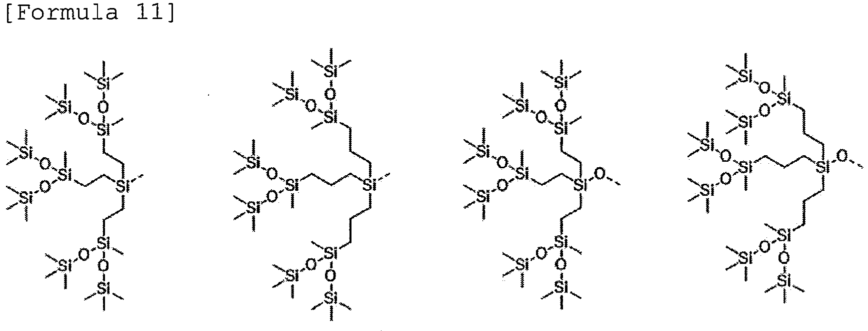

In a preferable embodiment, the group A is the following group:

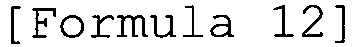

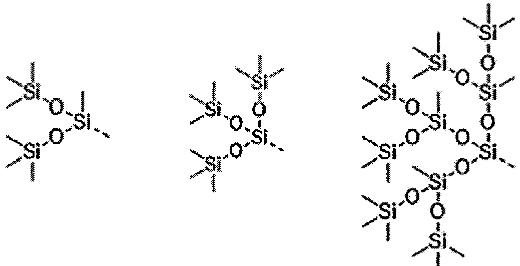

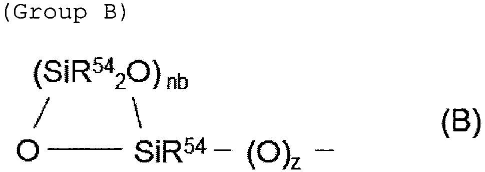

R⁵⁴ is each independently a hydrocarbon group.

The hydrocarbon group in R⁵⁴ may be preferably an alkyl group or an aryl group.

The alkyl group may be linear or may be branched. The alkyl group is preferably an alkyl group having 1 to 6 carbon atoms, and more preferably an alkyl group having 1 to 4 carbon atoms. The alkyl group is particularly preferably a methyl group, an ethyl group, a n-propyl group, an iso-propyl group, or a tert-butyl group.

The aryl group may be monocyclic or may be polycyclic. The aryl group is preferably an aryl group having 6 to 20 carbon atoms, and more preferably an aryl group having 6 to 10 carbon atoms. The aryl group is particularly preferably a phenyl group.

R⁵⁴ is preferably an alkyl group, and more preferably an alkyl group having 1 to 4 carbon atoms.

nb is an integer of 1 to 5, and preferably 2 or 3.

In a preferable embodiment, in the group B,
R⁵⁴ is each independently a hydrocarbon group, and preferably an alkyl group having 1 to 4 carbon atoms, and
nb is 2 or 3.

Examples of the group B are not limited, and include the following groups:

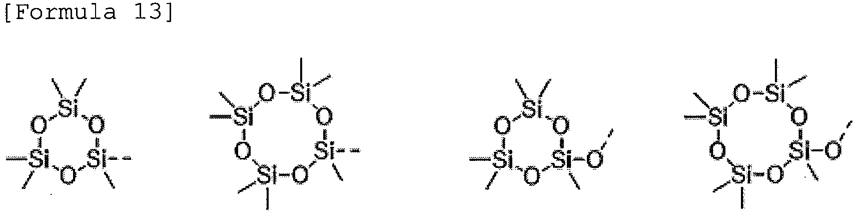

R^{S1} is each independently a single bond, or a group represented by the following formula: 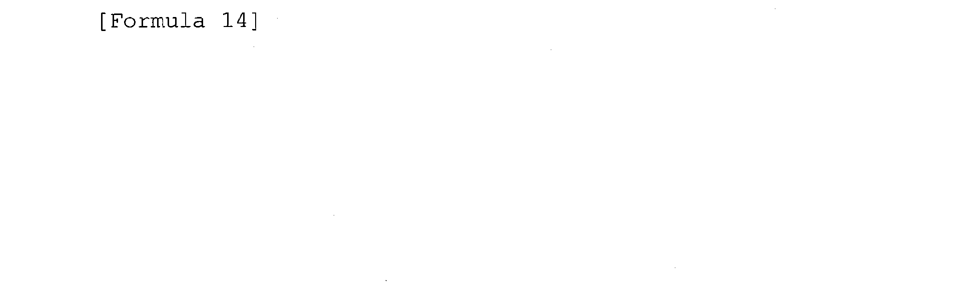 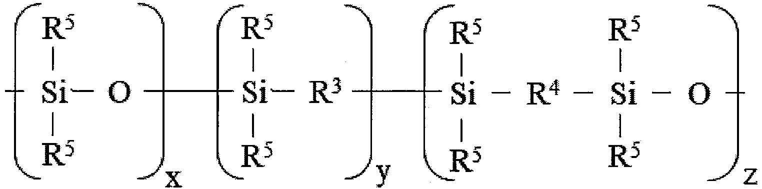 (wherein
R³ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
R⁴ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
R⁶ is each independently a C₁₋₆ alkylene group,
R⁷ is each independently an optionally substituted arylene group,
R⁸ is each independently a single bond or a C₁₋₆ alkylene group,
R⁹ is each independently a single bond or an oxygen atom,
R⁵ is each independently a hydrocarbon group,
x is an integer of 0 to 500,
y is an integer of 0 to 500,
z is an integer of 0 to 500,
x + y + z is 1 or more,
the occurrence order of the respective repeating units enclosed in parentheses provided with x, y, or z is not limited in the formula),
R² is each independently a hydrocarbon group, and s1, s2, and s3 are 0 or 1.

In one embodiment, R^{S1} is a single bond.

In another embodiment, R^{S1} is a group represented by the following formula:

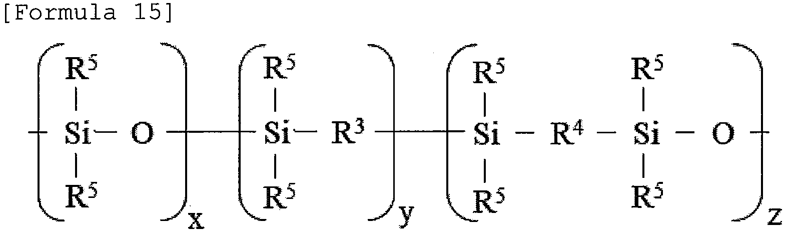

R³ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-, and preferably a C₁₋₁₂ alkylene group or -R⁶-O-R⁶-.

R⁴ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-.

In one embodiment, R⁴ is each independently a C₁₋₁₂ alkylene group, or -R⁶-O-R⁶-.

In another embodiment, R⁴ is each independently -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-.

In one embodiment, R³ is each independently a C₁₋₁₂ alkylene group, or -R⁶-O-R⁶-, and R⁴ is each independently a C₁₋₁₂ alkylene group, or -R⁶-O-R⁶-.

In another embodiment, R³ is each independently a C₁₋₁₂ alkylene group, or -R⁶-O-R⁶-, and R⁴ is each independently -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-.

The C₁₋₁₂ alkylene group may be linear or may be branched. The C₁₋₁₂ alkylene group is preferably linear.

The C₁₋₁₂ alkylene group is preferably a C₂₋₈ alkylene group, and more preferably a C₂₋₆ alkylene group.

R⁶ is each independently a C₁₋₆ alkylene group. The C₁₋₆ alkylene group may be linear or may be branched. The C₁₋₆ alkylene group is preferably linear.

The C₁₋₆ alkylene group is preferably a C₂₋₄ alkylene group, and more preferably a C₂₋₃ alkylene group.

In a preferable embodiment, in a group containing a plurality of R⁶, all R⁶ are the same group.

R⁷ is each independently an optionally substituted arylene group.

In one embodiment, R⁷ is each independently any of the following:

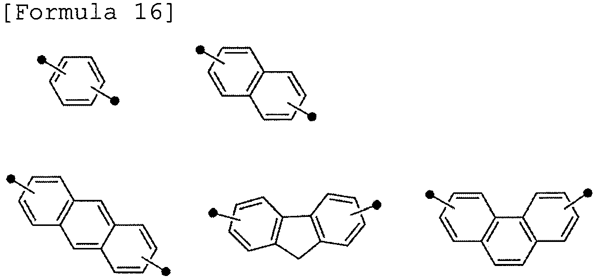

In one embodiment, R⁷ is a phenylene group.

In another embodiment, R⁷ is a naphthylene group.

The arylene group may have a substituent. The number of substituents is not limited, and is, for example, 1 to 4, and preferably 1 or 2.

In one embodiment, the phenylene group and the naphthylene group may have a substituent. The number of substituents is not limited, and is, for example, 1 to 4, and preferably 1 or 2. The substituted phenylene group is preferably 2,5-substituted phenylene.

The substituent with respect to the arylene group is each independently -R⁴¹-R⁴².

R⁴¹ is a single bond, an oxygen atom, or a sulfur atom, preferably a single bond or an oxygen atom, and more preferably an oxygen atom. In addition, it is preferable that R⁴¹ is not a nitrogen atom.

R⁴² is a C₁₋₁₂ alkyl group, -(O-R⁴³)ₚ, -R⁴⁴-R⁴⁵, or -R⁴⁴-OR⁴⁶, all of which are optionally substituted with a halogen.

The halogen is fluorine, chlorine, bromine, or iodine, and is preferably fluorine.

The C₁₋₁₂ alkyl group in R⁴² may be linear or may be branched.

R⁴³ is a C₁₋₆ alkylene group, and preferably a C₂₋₄ alkylene group. Such an alkylene group may be linear or may be branched.

R⁴⁴ is a C₁₋₁₂ alkylene group, and preferably a C₁₋₆ alkylene group. Such an alkylene group may be linear or may be branched.

R⁴⁵ is -CH=CH₂ or -OCOCH=CH₂.

R⁴⁶ is a hydrogen atom or a C₁₋₆ alkyl group. Such an alkyl group may be linear or may be branched. The C₁₋₆ alkyl group is preferably a C₁₋₃ alkyl group, more preferably a C₁₋₂ alkyl group, and even more preferably a methyl group.

R⁸ is each independently a single bond or a C₁₋₆ alkylene group. Such a C₁₋₆ alkylene group may be linear or may be branched.

In one embodiment, R⁸ is a single bond.

In another embodiment, R⁸ is a C₁₋₆ alkylene group.

R⁹ is each independently a single bond or an oxygen atom.

In one embodiment, R⁹ is a single bond.

In another embodiment, R⁹ is an oxygen atom.

R⁵ is each independently a hydrocarbon group. Such a hydrocarbon group may be substituted. It is preferable that the hydrocarbon group does not contain a nitrogen atom when substituted.

R⁵ is, each independently, preferably an unsubstituted hydrocarbon group or a hydrocarbon group substituted with a halogen atom. Such a halogen atom is preferably a fluorine atom.

R⁵ is, each independently, preferably a C₁₋₁₈ alkyl group or aryl group optionally substituted with a halogen atom, and more preferably a C₁₋₁₈ alkyl group or aryl group.

The C₁₋₁₈ alkyl group may be linear or may be branched, and is preferably linear. The C₁₋₁₈ alkyl group is preferably a C₁₋₁₀ alkyl group, more preferably a C₁₋₆ alkyl group, even more preferably a C₁₋₄ alkyl group, and yet more preferably a methyl group.

The aryl group is preferably a phenyl group.

In one embodiment, R⁵ is each independently a C₁₋₆ alkyl group, preferably a C₁₋₄ alkyl group, and more preferably a methyl group.

In another embodiment, R⁵ is a phenyl group.

In another embodiment, R⁵ is each independently a methyl group or a phenyl group, and preferably a methyl group.

x is an integer of 0 to 500, preferably an integer of 0 to 300, more preferably an integer of 0 to 100, even more preferably an integer of 1 to 100, yet more preferably an integer of 5 to 60, and further preferably an integer of 10 to 30.

In one embodiment, x is 0.

In one embodiment, x is an integer of 1 to 500, preferably an integer of 1 to 300, more preferably an integer of 1 to 100, even more preferably an integer of 5 to 60, yet more preferably an integer of 10 to 60, and particularly preferably an integer of 10 to 30, such as an integer of 2 to 100, 2 to 50, 2 to 30, 5 to 100, 5 to 50, 5 to 30, or 5 to 20. When x is within this range, the friction durability of a water-repellent layer to be obtained is improved.

In another embodiment, x is an integer of 10 to 500, more preferably an integer of 10 to 100, and even more preferably an integer of 10 to 80, such as an integer of 20 to 500, 20 to 100, 20 to 80, 30 to 80, 40 to 80, or 40 to 70. When x is within this range, the tactile sensation and the lubricity of the resulting water-repellent layer are improved.

y is an integer of 0 to 500, preferably an integer of 0 to 300, more preferably an integer of 0 to 100, even more preferably an integer of 1 to 100, yet more preferably an integer of 5 to 60, and further preferably an integer of 10 to 30.

In one embodiment, y is 0.

In one embodiment, y is an integer of 1 to 500, preferably an integer of 1 to 300, more preferably an integer of 1 to 100, even more preferably an integer of 5 to 60, yet more preferably an integer of 10 to 60, and particularly preferably an integer of 10 to 30, such as an integer of 2 to 100, 2 to 50, 2 to 30, 5 to 100, 5 to 50, 5 to 30, or 5 to 20. When y is within this range, the friction durability of the resulting water-repellent layer is improved.

In another embodiment, y is an integer of 10 to 500, preferably an integer of 10 to 100, and more preferably an integer of 10 to 80, such as an integer of 20 to 500, 20 to 100, 20 to 80, 30 to 80, 40 to 80, or 40 to 70. When y is within this range, the tactile sensation and the lubricity of the resulting water-repellent layer are improved.

z is an integer of 0 to 500, preferably an integer of 0 to 300, more preferably an integer of 0 to 100, even more preferably an integer of 1 to 100, yet more preferably an integer of 5 to 60, and further preferably an integer of 10 to 30.

In one embodiment, z is 0.

In one embodiment, z is an integer of 1 to 500, preferably an integer of 1 to 300, more preferably an integer of 1 to 100, even more preferably an integer of 5 to 60, yet more preferably an integer of 10 to 60, and particularly preferably an integer of 10 to 30, such as an integer of 2 to 100, 2 to 50, 2 to 30, 5 to 100, 5 to 50, 5 to 30, or 5 to 20. When z is within this range, the friction durability of the resulting water-repellent layer is improved.

In another embodiment, z is an integer of 10 to 500, preferably an integer of 10 to 100, and more preferably an integer of 10 to 80, such as an integer of 20 to 500, 20 to 100, 20 to 80, 30 to 80, 40 to 80, or 40 to 70. When z is within this range, the tactile sensation and the lubricity of the resulting water-repellent layer are improved.

In one embodiment, y is 0, and z is 0.

In another embodiment, x is 0, and y is 0.

R^{S1} may be a random polymer, or may be a block polymer.

s1, s2, and s3 are 0 or 1.

In a preferable embodiment,
R¹ is a methyl group,
s1 is 1,
R⁵ is a methyl group, and
x is 1, and y and z are 0.
s2 is 1, and
s3 is 0.

X¹ is a di- to decavalent group. The left side of the group X¹ binds to R^{S} and the right side binds to R^{Si}.

X¹ is a di- to decavalent group, preferably a di- to hexavalent group, more preferably a di- to tetravalent group, and even more preferably a divalent group.

In one embodiment, X¹ is a di- to decavalent group, such as di- or trivalent group, containing at least one group selected from a single bond, -CO-, -COO-, -NR^{x1}-, - CONR^{x1}-, -NR^{x1}CO-, -OCONR^{x1}-, -NR^{x1}-CO-NR^{x1}-, -O-, -S-, and -CON= (wherein R^{x1} is a hydrogen atom or a C₁₋₆ alkyl group). When the water-repellent layer of the present disclosure contains plural types of compounds represented by the formula (1), X¹ in the respective compounds may have the same group, or may have different groups.

In a preferable embodiment, X¹ is a group containing at least one group selected from -CONR^{x1}- and -NR^{×1}CO-(wherein R^{x1} is a hydrogen atom or a C₁₋₆ alkyl group).

In one embodiment, R^{x1} is a hydrogen atom.

In one embodiment, R^{x1} is a methyl group.

In a preferable embodiment, X¹ is a group represented by the following formula:

-X¹¹¹-(-X¹¹²-X¹¹¹-)ₘ-

wherein
X¹¹¹ is each independently a single bond, or a divalent group not containing a nitrogen atom,
X¹¹² is -CONR^{x1}-, or -NR^{x1}CO-,
R^{x1} is a hydrogen atom or a C₁₋₆ alkyl group, and
m is an integer of 1 to 30.

X¹¹¹ is a single bond, or a divalent group not containing a nitrogen atom.

In one embodiment, X¹¹¹ is a single bond.

In one embodiment, X¹¹¹ is a divalent group not containing a nitrogen atom.

The divalent group not containing a nitrogen atom in X¹¹¹ may be a group containing at least one group selected from alkylene, phenylene, -CO-, -COO-, -O-, -S-, and -O-(CH₂)ₓ₁-CO-. R^{x1} is a hydrogen atom or a C₁₋₆ alkyl group, and x1 is an integer of 1 to 20. The alkylene has preferably 1 to 30, and more preferably 1 to 20, such as 1 to 9, 1 to 6, 2 to 30, 5 to 25, 10 to 30, 10 to 25, 10 to 20, or 12 to 20, carbon atoms.

X¹¹¹ is preferably a C₁₋₉ alkylene group, a C₁₀₋₃₀ alkylene group, -(CH₂)_{f1}-O-(CH₂)_{f2}- (wherein f1 is an integer of 0 to 6, such as an integer of 1 to 6, and f2 is an integer of 0 to 6, such as an integer of 1 to 6), or -(CH₂)_{f3}-phenylene- (CH₂)_{f4}- (wherein f3 is an integer of 0 to 6, such as an integer of 1 to 6, and f4 is an integer of 0 to 6, such as an integer of 1 to 6). Such a C₁₋₉ alkylene group or C₁₀₋₃₀ alkylene group may be linear or may be branched. These groups may be substituted with, for example, one or more substituents selected from a fluorine atom, a C₁₋₆ alkyl group, a C₂₋₆ alkenyl group, and a C₂₋₆ alkynyl group.

In another preferable embodiment, X¹ is a group represented by the following formula:

-[(X¹²¹)ₓ₁-(X¹²²)ₓ₂]-

wherein
X¹²¹ is each independently a single bond, or a C₁₋₃₀ alkylene group,
X¹²² is each independently a single bond, -CO-, - COO-, -OCO-, -NR^{x1}-, -CONRx¹-, -NR^{x1}CO-, -OCONR^{x1}-, - NR^{x1}COO-, -NR^{x1}-CO-NR^{x1}-, -O-, -S-, -O- (CH₂)ₓ₃-CONR^{x1}-, -O-(CH₂)ₓ₃-NR^{x1}CO-, or -O-(CH₂)ₓ₃-CO-,
R^{x1} is a hydrogen atom or a C₁₋₆ alkyl group,
x3 is an integer of 1 to 30,
provided that at least one X¹²² is -CONR^{x1}-, or - NR^{x1}CO-,
x1 is an integer of 0 to 6,
x2 is an integer of 0 to 6, and
the occurrence order of the respective repeating units enclosed in parentheses provided with x1, or x2 is not limited in the formula.

X¹²¹ is each independently a single bond, or a C₁₋₆₀ alkylene group.

In one embodiment, X¹²¹ is a single bond.

In one embodiment, X¹²¹ is a C₁₋₆₀ alkylene group.

In one embodiment, at least one X¹²¹ is a C₇₋₆₀ alkylene group.

In one embodiment, the number of carbon atoms of the C₁₋₆₀ alkylene group may be 3 or more, 7 or more, 10 or more, 11 or more, 12 or more, 16 or more, 18 or more, or 22 or more, and may be 60 or less, 40 or less, 36 or less, 32 or less, 30 or less, 28 or less, or 24 or less. The number of carbon atoms of the C₁₋₆₀ alkylene group may be preferably 3 to 60, more preferably 7 to 40, and even more preferably 10 to 30. Note that when plural X¹²¹ are present, the numbers of carbon atoms of the respective alkylene groups may be different. For example, the number of carbon atoms of one alkylene group may be 1 to 6 and the number of carbon atoms in the other may be 10 to 30.

In one embodiment, the number of carbon atoms in the C₁₋₆₀ alkylene group may be 1 or more, 3 or more, or 4 or more, and may be 60 or less, 30 or less, 10 or less, 6 or less, or 4 or less. The number of carbon atoms in the C₁₋₆₀ alkylene group may be preferably 1 to 10, more preferably 1 to 6, and even more preferably 3 to 6. Note that when plural X¹²¹ are present, the numbers of carbon atoms of the respective alkylene groups may be different. For example, the number of carbon atoms of one alkylene group may be 1 to 6 and the number of carbon atoms in the other may be 10 to 30.

In one embodiment, the number of carbon atoms in the C₁₋₆₀ alkylene group may be preferably 10 to 60, more preferably 10 to 40, and even more preferably 10 to 30.

In one embodiment, the number of carbon atoms in the C₁₋₆₀ alkylene group may be preferably 11 to 60, more preferably 11 to 40, and even more preferably 11 to 30.

X¹²² is each independently a single bond, -CO-, - COO⁻, -OCO⁻, -NR^{x1}-, -CONR^{x1}-, -NR^{x1}CO-, -OCONR^{x1}-, - NR^{x1}COO-, -NR^{x1}-CO-NR^{x1}-, -O-, -S-, -O-(CH₂)ₓ₃-CONR^{x1}-, -O-(CH₂)ₓ₃-NR^{x1}CO-, or -O-(CH₂)ₓ₃-CO-, and R^{x1} is a hydrogen atom or a C₁₋₆ alkyl group, x3 is an integer of 1 to 30, and R^{x1} is a hydrogen atom or a C₁₋₆ alkyl group.

The C₁₋₆ alkyl group in R^{x1} may be linear or may be branched. In one embodiment, the C₁₋₆ alkyl group is linear. In another embodiment, the C₁₋₆ alkyl group is branched. The C₁₋₆ alkyl group is preferably a C₁₋₄ alkyl group, more preferably a methyl group or an ethyl group, and particularly preferably a methyl group.

x3 may be an integer of 1 to 30, and preferably an integer of 1 to 20, such as an integer of 1 to 10, 11 to 30, or 11 to 20.

In one embodiment, X¹²² is -CO-, -COO-, -OCO-, -NR^{x1}-, -CONR^{x1}-, -NR^{x1}CO-, -OCONR^{x1}-, -NR^{x1}COO-, -NR^{x1}-CO-NR^{x1}-, - O-, or -S-.

In a preferable embodiment, X¹²² is -CONR^{x1}-, - NR^{x1}CO-, or -O-.

x1 is an integer of 0 to 6, preferably an integer of 1 to 6, more preferably an integer of 1 to 4, and even more preferably 1 or 2.

x2 is an integer of 0 to 6, and preferably an integer of 0 to 2, such as 0 or 1. In one embodiment, x2 is 0. In another embodiment, x2 is 1.

In another embodiment, X¹ is a group represented by the following formula:

-(X²²¹)ₐ₀-X²¹⁰-[(X²¹¹)ₐ₁-(X²¹²)ₐ₂]-

wherein
X²²¹ is R²⁶¹_{b1}R²⁶²_{3-b1}C-, R²⁶³_{b2}R²⁶⁴_{3-b2}Si-, or R²⁶⁵₂N-,
   R²⁶¹ is each independently a single bond, or a divalent organic group,
   R²⁶² is each independently a hydrogen atom, or a monovalent organic group,
   R²⁶³ is each independently a single bond, or a divalent organic group,
   R²⁶⁴ is each independently a hydrogen atom, or a monovalent organic group,
   R²⁶⁵ is each independently a single bond, or a divalent organic group,
   b1 is 2 or 3,
   b2 is 2 or 3,
X²¹⁰ is a single bond, or an alkylene group having 3 or more carbon atoms,
X²¹¹ is a single bond, or a divalent organic group,
X²¹² is -CO-, -COO-, -OCO-, -NR^{x1}-, -CONR^{x1}-, -NR^{x1}CO-, -OCONR^{x1}-, -NR^{x1}COO-, -NR^{x1}-CO-NR^{x1}-, -O-, -S-, -O-(CH₂)ₓ₃-CONR^{x1}-, -O-(CH₂)ₓ₃-NR^{x1}CO-, -O-(CH₂)ₓ₃-CO-, or -CON=,
   R^{x1} is a hydrogen atom or a C₁₋₆ alkyl group,
   x3 is an integer of 1 to 30,
   provided that at least one of X²¹² is -OCONR^{x1}-, or -NR^{x1}CO-,
a0 is 0 or 1,
a1 is an integer of 1 to 5,
a2 is an integer of 0 to 5, and
the occurrence order of the respective repeating units enclosed in parentheses provided with a1, or a2 is not limited in the formula.

X²²¹ is R²⁶¹_{b1}R²⁶²_{3-b1}C-, R²⁶³_{b2}R²⁶⁴_{3-b2}Si-, or R²⁶⁵₂N-.

R²⁶¹ is each independently a single bond or a divalent organic group.

R²⁶¹ is preferably a C₁₋₆ alkylene group, -(CH₂)_{f1}-O-(CH₂)_{f2}- (wherein f1 is an integer of 0 to 6 such as an integer of 1 to 6, and f2 is an integer of 0 to 6 such as an integer of 1 to 6), or -(CH₂)_{f3}-phenylene-(CH₂)_{f4}-(wherein f3 is an integer of 0 to 6 such as an integer of 1 to 6, and f4 is an integer of 0 to 6 such as an integer of 1 to 6). Such a C₁₋₆ alkylene group may be linear or may be branched, and is preferably linear. These groups may be substituted with, for example, one or more substituents selected from, a C₁₋₆ alkyl group, a C₂₋₆ alkenyl group, and a C₂₋₆ alkynyl group, and are preferably unsubstituted.

In a preferable embodiment, R²⁶¹ is a C₁₋₆ alkylene group or -(CH₂)_{f3}-phenylene-(CH₂)_{f4}-, and preferably - phenylene- (CH₂)_{f4}-.

In another preferable embodiment, R²⁶¹ is a C₁₋₃ alkylene group. In one embodiment, R²⁶¹ may be - CH₂CH₂CH₂-. In another embodiment, R²⁶¹ may be -CH₂CH₂-.

R²⁶² is each independently a hydrogen atom or a monovalent organic group.

In one embodiment, R²⁶² is a hydrogen atom.

In another embodiment, R²⁶² is a monovalent organic group.

In R²⁶², the monovalent organic group is preferably a C₁₋₂₀ alkyl group, more preferably a C₁₋₆ alkyl group, and even more preferably a methyl group.

b1 is 2 or 3. In one embodiment, b1 is 2. In another embodiment, b1 is 3.

R²⁶³ is each independently a single bond or a divalent organic group.

R²⁶³ is preferably a C₁₋₆ alkylene group, -(CH₂)_{g1}-O-(CH₂)_{g2}- (wherein g1 is an integer of 0 to 6 such as an integer of 1 to 6, and g2 is an integer of 0 to 6 such as an integer of 1 to 6), or -(CH₂)_{g3}-phenylene-(CH₂)_{g4}-(wherein g3 is an integer of 0 to 6 such as an integer of 1 to 6, and g4 is an integer of 0 to 6 such as an integer of 1 to 6). Such a C₁₋₆ alkylene group may be linear or may be branched, and is preferably linear. These groups may be substituted with, for example, one or more substituents selected from, a C₁₋₆ alkyl group, a C₂₋₆ alkenyl group, and a C₂₋₆ alkynyl group, and are preferably unsubstituted.

In a preferable embodiment, R²⁶³ is a C₁₋₆ alkylene group or - (CH₂)_{g3}-phenylene- (CH₂)_{g4}-, and preferably - phenylene- (CH₂)_{g4}-.

In another preferable embodiment, R²⁶³ is a C₁₋₃ alkylene group. In one embodiment, R²⁶³ may be - CH₂CH₂CH₂-. In another embodiment, R²⁶³ may be -CH₂CH₂-.

R²⁶⁴ is each independently a hydrogen atom or a monovalent organic group.

In one embodiment, R²⁶⁴ is a hydrogen atom.

In another embodiment, R²⁶⁴ is a monovalent organic group.

In R²⁶⁴, the monovalent organic group is preferably a C₁₋₂₀ alkyl group, more preferably a C₁₋₆ alkyl group, and even more preferably a methyl group.

b2 is 2 or 3. In one embodiment, b2 is 2. In another embodiment, b2 is 3.

R²⁶⁵ is each independently a single bond or a divalent organic group.

R²⁶⁵ is preferably a C₁₋₆ alkylene group, -(CH₂)ₕ₁-O-(CH₂)ₕ₂- (wherein h1 is an integer of 0 to 6 such as an integer of 1 to 6, and h2 is an integer of 0 to 6 such as an integer of 1 to 6), or - (CH₂)ₕ₃-phenylene-(CH₂)ₕ₄-(wherein h3 is an integer of 0 to 6 such as an integer of 1 to 6, and h4 is an integer of 0 to 6 such as an integer of 1 to 6). Such a C₁₋₆ alkylene group may be linear or may be branched, and is preferably linear. These groups may be substituted with, for example, one or more substituents selected from, a C₁₋₆ alkyl group, a C₂₋₆ alkenyl group, and a C₂₋₆ alkynyl group, and are preferably unsubstituted.

In a preferable embodiment, R²⁶⁵ is a C₁₋₆ alkylene group or -(CH₂)ₕ₃-phenylene-(CH₂)ₕ₄-, and preferably - phenylene- (CH₂)ₕ₄-.

In another preferable embodiment, R²⁶⁵ is a C₁₋₃ alkylene group. In one embodiment, R²⁶⁵ may be - CH₂CH₂CH₂-. In another embodiment, R²⁶⁵ may be -CH₂CH₂-.

In one embodiment, X²²¹ is R²⁶¹_{b1}R²⁶²_{3-b1}C-.

In one embodiment, X²²¹ is R²⁶³_{b2}R²⁶⁴_{3-b2}S₁-.

In one embodiment, X²²¹ is R²⁶⁵₂N-.

X²¹⁰ is a single bond, or an alkylene group having 3 or more carbon atoms.

The number of carbon atoms in X²¹⁰ may be preferably 3 or more, more preferably 6 or more, even more preferably 10 or more, and yet more preferably 12 or more, such as 16 or more, 18 or more, or 22 or more. The number of carbon atoms in X²¹⁰ may be preferably 60 or less, more preferably 40 or less, even more preferably 30 or less, and yet more preferably 24 or less. The number of carbon atoms in X²¹⁰ may be preferably 3 to 60, more preferably 6 to 40, and even more preferably 10 to 30.

The alkylene group in X²¹⁰ may be linear, or may be branched. The alkylene group is preferably linear.

X²¹¹ is a single bond or a divalent organic group.

The divalent organic group is preferably a divalent hydrocarbon group.

The hydrocarbon group in X²¹¹ is preferably a hydrocarbon group having 1 to 30 carbon atoms.

The hydrocarbon group may preferably be an alkylene group or an arylene group.

The alkylene group may be linear or may be branched. The alkylene group may preferably be an alkylene group having 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

In one embodiment, the alkylene group may be, for example, a C₁₁₋₃₀ alkylene group. The number of carbon atoms of such an alkylene group may be preferably 10 or more, 11 or more, more preferably 16 or more, even more preferably 18 or more, and yet more preferably 22 or more. The number of carbon atoms of the alkylene group in X¹¹¹ may preferably be 60 or less, more preferably 40 or less, even more preferably 30 or less, and yet more preferably 24 or less. The number of carbon atoms of the alkylene group in X¹¹⁰ and X¹¹¹ may preferably be 11 to 60, more preferably 12 to 40, and even more preferably 18 to 30.

In one embodiment, the alkylene group may be, for example, a C₁₀₋₃₀ alkylene group.

In one embodiment, the alkylene group may be, for example, a C₁₁₋₃₀ alkylene group.

The arylene group may be monocyclic or may be polycyclic. The arylene group is preferably an arylene group having 6 to 20 carbon atoms, and more preferably an arylene group having 6 to 10 carbon atoms. The arylene group is particularly preferably a phenylene group.

In one embodiment, X²¹¹ is a group represented by:

-X²¹³-X²¹²-X²¹⁴-

wherein
X²¹³ is an alkylene group, an oxyalkylene group, or - (CⱼH₂ⱼ)ₖ₁-(O-CⱼH₂ⱼ)ₖ₂ wherein j is an integer of 1 to 6, k1 is 1 or 0, and k2 is an integer of 1 to 20,
X²¹² is -CONR^{x1}- or -NR^{x1}CO-,
   R^{x1} is a hydrogen atom or a C₁₋₆ alkyl group, and preferably a hydrogen atom, and
X²¹⁴ is a single bond or an alkylene group.

X²¹³ is an alkylene group, an oxyalkylene group, or - (CⱼH₂ⱼ)ₖ₁-(O-CⱼH₂ⱼ)ₖ₂ wherein j is an integer of 1 to 6, k1 is 1 or 0, and k2 is an integer of 1 to 20.

The alkylene group may be linear or may be branched. The alkylene group may preferably be an alkylene group having 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

In one embodiment, the alkylene group may be, for example, a C₁₁₋₃₀ alkylene group. The number of carbon atoms of the alkylene group may preferably be 12 or more, more preferably 16 or more, even more preferably 18 or more, and yet more preferably 22 or more. The number of carbon atoms of the alkylene group in X²¹³ and X²¹⁴ may preferably be 60 or less, more preferably 40 or less, even more preferably 30 or less, and yet more preferably 24 or less. The number of carbon atoms of the alkylene group in X²¹³ and X²¹⁴ may preferably be 11 to 60, more preferably 12 to 40, and even more preferably 18 to 30.

In one embodiment, the alkylene group may be, for example, a C₁₀₋₃₀ alkylene group. The number of carbon atoms of such an alkylene group may preferably be 10 or more, more preferably 16 or more, even more preferably 18 or more, and yet more preferably 22 or more. The number of carbon atoms of the alkylene group in X²¹³ and X²¹⁴ may preferably be 60 or less, more preferably 40 or less, even more preferably 30 or less, and yet more preferably 24 or less. The number of carbon atoms of the alkylene group in X²¹³ and X²¹⁴ may preferably be 10 to 60, more preferably 12 to 40, and even more preferably 18 to 30.

The oxyalkylene group is a group having an oxygen atom at the left terminal (the R^{S} side) of the alkylene group, i.e., an -O-alkylene group.

j is an integer of 1 to 6, and preferably an integer of 2 to 4.

k1 is 1 or 0, and preferably 0.

k2 is an integer of 1 to 20, preferably an integer of 2 to 10, and more preferably an integer of 2 to 6.

X²¹⁴ is an alkylene group.

The alkylene group may be linear or may be branched. The alkylene group may be an alkylene group preferably having 1 to 30 carbon atoms, preferably a C₁₋₁₀ alkylene group, more preferably a C₁₋₈ alkylene group, and even more preferably a C₁₋₆ alkylene group, such as a C₂₋₁₀ alkylene group, a C₂₋₈ alkylene group, or a C₂₋₆ alkylene group.

In one embodiment, X²¹¹ is a group represented by:

-O-R^{S1}-X²¹³-X²¹²-X²¹⁴-

wherein
R^{S1} has the same meaning as above,
X²¹² is -CONR^{x1}-, or -NR^{x1}CO-,
   R^{x1} is a hydrogen atom or a C₁₋₆ alkyl group, and preferably a hydrogen atom,
X²¹³ is an alkylene group, an oxyalkylene group, or - (CⱼH₂ⱼ)ₖ₁-(O-CⱼH₂ⱼ)ₖ₂ (wherein j is an integer of 1 to 6, k1 is 1 or 0, and k2 is an integer of 1 to 20), and
X¹¹⁴ is a single bond, or an alkylene group.

In one embodiment, X²¹¹ is a group represented by:

-X²¹⁵ -R^{S1}-X²¹³-X²¹²-X²¹⁴-

wherein
R^{S1} has the same meaning as above,
X²¹² is -CONR^{x1}-, or -NR^{x1}CO-,
   R^{x1} is a hydrogen atom or a C₁₋₆ alkyl group, and preferably a hydrogen atom,
X²¹³ is an alkylene group, an oxyalkylene group, or - (CⱼH₂ⱼ)ₖ₁-(O-CⱼH₂ⱼ)ₖ₂ (wherein j is an integer of 1 to 6, k1 is 1 or 0, and k2 is an integer of 1 to 20),
X²¹⁴ is a single bond, or an alkylene group, and
X²¹⁵ is an alkylene group, an oxyalkylene group, or - (Cₚ₁₀H₂ₚ₁₀)_{q1}-(O-Cₚ₁₀H₂ₚ₁₀)_{q2} (wherein p10 is an integer of 1 to 6, q1 is 1 or 0, and q2 is an integer of 1 to 20).

X²¹⁵ is an alkylene group, an oxyalkylene group, or - (CₚH₂ₚ)_{q1}-(O-CₚH₂ₚ)_{q2} wherein p is an integer of 1 to 6, q1 is 1 or 0, and q2 is an integer of 1 to 20.

The alkylene group may be linear or may be branched. The alkylene group may preferably be an alkylene group having 1 to 30 carbon atoms.

In one embodiment, the alkylene group may be, for example, a C₁₋₁₀ alkylene group, a C₁₋₈ alkylene group, a C₁₋₆ alkylene group, a C₂₋₁₀ alkylene group, a C₂₋₈ alkylene group, or a C₂₋₆ alkylene group.

The oxyalkylene group is a group having an oxygen atom at the left terminal (the R^{A} or R^{B} side) of the alkylene group, i.e., an -O-alkylene group.

p10 is an integer of 1 to 6, and preferably an integer of 2 to 4.

q1 is 1 or 0, and preferably 0.

q2 is an integer of 1 to 20, preferably an integer of 2 to 10, and more preferably an integer of 2 to 6.

In another preferable embodiment, X¹ is a group represented by the following formula: 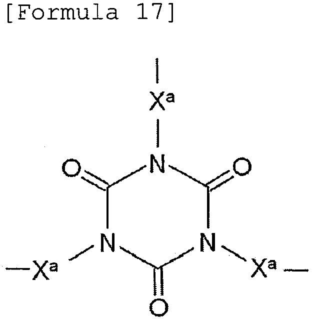 wherein X^{a} is each independently a single bond or a divalent organic group.

X^{a} is a single bond or divalent organic group directly bonded to the isocyanuric ring. X^{a} is preferably a single bond, an alkylene group, or a divalent group containing at least one bond selected from the group consisting of an ether bond, an ester bond, an amide bond, and a sulfide bond, and more preferably a single bond, an alkylene group having 1 to 10 carbon atoms, or a divalent hydrocarbon group having 1 to 10 carbon atoms and containing at least one bond selected from the group consisting of an ether bond, an ester bond, an amide bond, and a sulfide bond.

X^{a} is even more preferably a group represented by the following formula:

- (CX¹²¹X¹²²)ₓ₁-(X^{a1})_{y1}-(CX¹²³X¹²⁴)_{z1}-

wherein X¹²¹ to X¹²⁴ are each independently H, OH, or - OSi(OR¹²¹)₃, where three R¹²¹ are each independently an alkyl group having 1 to 4 carbon atoms,
X^{a1} is -C(=O)NH-, -NHC(=O)-, -O-, -C(=O)O-, -OC(=O)-, -OC(=O) O-, or -NHC(=O)NH- (left side of each bond binds to CX¹²¹X¹²²), and
x1 is an integer of 0 to 10, y1 is 0 or 1, and z1 is an integer of 1 to 10.

X^{a1} is preferably -O- or -C(=O)O-.

X^{a} is particularly preferably
a group represented by the following formula:

   -(CH₂)ₘ₁₂-O- (CH₂)ₘ₁₃-

   wherein m12 is an integer of 1 to 3, and m13 is an integer of 1 to 3,
a group represented by

   - (CH₂)ₘ₁₅-O-CH₂CH(OH) - (CH₂)ₘ₁₆-

   wherein m15 is an integer of 1 to 3, and m16 is an integer of 1 to 3,
a group represented by

   - (CH₂)ₘ₁₈-

   wherein m18 is an integer of 1 to 3, and
a group represented by

   -(CH₂)ₘ₂₀-O-CH₂CH(OSi (OCH₃)₃)- (CH₂)ₘ₂₁-

   wherein m20 is an integer of 1 to 3, and m21 is an integer of 1 to 3.

X^{a} is not limited, and specific examples include -CH₂-, -C₂H₄-, -C₃H₆-, -C₄H₈-, -C₄H₈-O-CH₂-, -CO-O-CH₂-CH(OH)-CH₂-, -S-, -(CH₂)ₘ₂₂-C(=O)-O-(CH₂)ₘ₂₃-, -(CH₂)ₘ₂₂-O-C(=O)- (CH₂)ₘ₂₃-, -(CH₂)ₘ₂₂-C(=O)-NR¹²¹-(CH₂)ₘ₂₃-, and - (CH₂)ₘ₂₂-NR¹²¹-C(=O)- (CH₂)ₘ₂₃-CH₂OCH₂CH(OSi(OCH₃)₃)CH₂-, wherein R¹²¹ is a hydrogen atom or a C₁₋₆ hydrocarbon chain, m22 is an integer of 1 to 10, and m23 is an integer of 1 to 10.

R^{Si} is a monovalent group containing a Si atom to which a hydroxyl group or a hydrolyzable group is bonded.

In a preferable embodiment, R^{Si} is a group represented by the following formula (S1), (S2), (S3), (S4), or (S5): 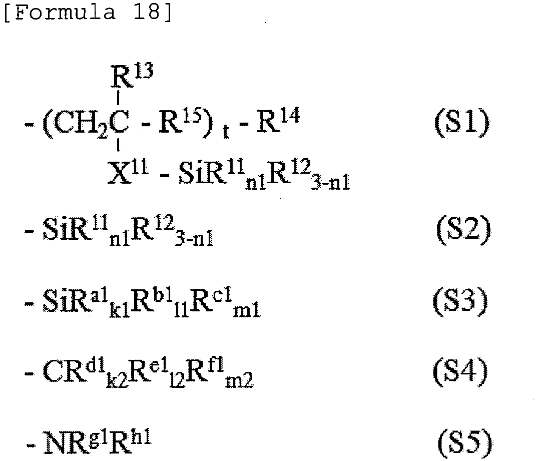 wherein
R¹¹ is each independently a hydroxyl group or a hydrolyzable group,
R¹² is each independently a monovalent organic group,
n1 is each independently an integer of 0 to 3 for each (SiR¹¹ₙ₁R¹²₃₋ₙ₁) unit,
X¹¹ is each independently a single bond or a divalent organic group,
R¹³ is each independently a hydrogen atom or a monovalent organic group,
t is each independently an integer of 2 or more,
R¹⁴ is each independently a hydrogen atom, a halogen atom, or -X¹¹-SiR¹¹ₙ₁R¹²₃₋ₙ₁,
R¹⁵ is each independently a single bond, an oxygen atom, an alkylene group having 1 to 6 carbon atoms, or an alkyleneoxy group having 1 to 6 carbon atoms,
R^{a1} is each independently -Z¹-SiR²¹ₚ₁R²²_{q1}R²³ᵣ₁,
Z¹ is each independently a divalent organic group,
R²¹ is each independently -Z^{1'}-SiR^{21'}_{p1'}R^{22'}_{q1'}R^{23'}_{r1'},
R²² is each independently a hydroxyl group or a hydrolyzable group,
R²³ is each independently a monovalent organic group,
p1 is each independently an integer of 0 to 3,
q1 is each independently an integer of 0 to 3,
r1 is each independently an integer of 0 to 3,
Z^{1'} is each independently a divalent organic group,
R^{21'} is each independently -Z^{1"}-SiR^{22"}_{q1"}R^{23"}_{r1"},
R^{22'} is each independently a hydroxyl group or a hydrolyzable group,
R^{23'} is each independently a monovalent organic group,
p1' is each independently an integer of 0 to 3,
q1' is each independently an integer of 0 to 3,
r1' is each independently an integer of 0 to 3,
Z^{1"} is each independently a divalent organic group,
R^{22"} is each independently a hydroxyl group or a hydrolyzable group,
R^{23"} is each independently a monovalent organic group,
q1" is each independently an integer of 0 to 3,
r1" is each independently an integer of 0 to 3,
R^{b1} is each independently a hydroxyl group or a hydrolyzable group,
R^{c1} is each independently a monovalent organic group,
k1 is each independently an integer of 0 to 3,
l1 is each independently an integer of 0 to 3,
m1 is each independently an integer of 0 to 3,
provided that, in the formula (S3), at least two Si atoms to which a hydroxyl group or a hydrolyzable group is bonded are present,
R^{d1} is each independently -Z²-CR³¹ₚ₂R³²_{q2}R³³ᵣ₂,
Z² is each independently a single bond, an oxygen atom, or a divalent organic group,
R³¹ is each independently -Z^{2'}-CR^{32'}_{q2'}R^{33'}_{r2'},
R³² is each independently -Z³-SiR³⁴ₙ₂R³⁵₃₋ₙ₂,
R³³ is each independently a hydrogen atom, a hydroxyl group, or a monovalent organic group,
p2 is each independently an integer of 0 to 3,
q2 is each independently an integer of 0 to 3,
r2 is each independently an integer of 0 to 3,
Z^{2'} is each independently a single bond, an oxygen atom, or a divalent organic group,
R^{32'} is each independently -Z³-SiR³⁴ₙ₂R³⁵₃₋ₙ₂,
R^{33'} is each independently a hydrogen atom, a hydroxyl group, or a monovalent organic group,
q2' is each independently an integer of 0 to 3,
r2' is each independently an integer of 0 to 3,
Z³ is each independently a single bond, an oxygen atom, or a divalent organic group,
R³⁴ is each independently a hydroxyl group or a hydrolyzable group,
R³⁵ is each independently a monovalent organic group,
n2 is each independently an integer of 0 to 3,
R^{e1} is each independently -Z³-SiR³⁴ₙ₂R³⁵₃₋ₙ₂,
R^{f1} is each independently a hydrogen atom, a hydroxyl group, or a monovalent organic group,
k2 is each independently an integer of 0 to 3,
l2 is each independently an integer of 0 to 3,
m2 is each independently an integer of 0 to 3,
provided that, in the formula (S4), at least two Si atoms to which a hydroxyl group or a hydrolyzable group is bonded are present,
R^{g1} and R^{h1} are each independently -Z⁴-SiR¹¹ₙ₁R¹²₃₋ₙ₁, - Z⁴-SiR^{a1}ₖ₁R^{d1}ₗ₁R^{c1}ₘ₁, or -Z⁴-CR^{d1}ₖ₂R^{e1}ₗ₂R^{f1}ₘ₂, and
Z⁴ is each independently a single bond, an oxygen atom, or a divalent organic group,
provided that, in the formula (S5), at least two Si atoms to which a hydroxyl group or a hydrolyzable group is bonded are present.

In the formulae, R¹¹ is each independently a hydroxyl group or a hydrolyzable group.

R¹¹ is preferably, each independently, a hydrolyzable group.

R¹¹ is preferably, each independently, -OR^{h}, -OCOR^{h}, or a halogen (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formulae, R¹² is each independently a monovalent organic group. Such a monovalent organic group is a monovalent organic group excluding the above hydrolyzable group.

In R¹², the monovalent organic group is preferably a C₁₋₂₀ alkyl group, more preferably a C₁₋₆ alkyl group, and even more preferably a methyl group.

In the formulae, n1 is each independently an integer of 0 to 3 for each (SiR¹¹ₙ₁R¹²₃₋ₙ₁) unit, provided that, in the formula (S1), at least two (SiR¹¹ₙ₁R¹²₃₋ₙ₁) units wherein n1 is 1 to 3 are present. In other words, in the formula (S1), at least two Si atoms to which a hydroxyl group or a hydrolyzable group is bonded are present.

n1 is each independently an integer of preferably 1 to 3, more preferably 2 to 3, and even more preferably 3 for each (SiR¹¹ₙ₁R¹²₃₋ₙ₁) unit.

In the formula, X¹¹ is each independently a single bond or a divalent organic group. Such a divalent organic group is preferably -R²⁸-Oₓ-R²⁹-, wherein R²⁸ and R²⁹ are each independently a single bond or a C₁₋₂₀ alkylene group, and x is 0 or 1. Such a C₁₋₂₀ alkylene group may be linear or may be branched, and is preferably linear. Such a C₁₋₂₀ alkylene group is preferably a C₁₋₁₀ alkylene group, more preferably a C₁₋₈ alkylene group, and even more preferably a C₁₋₃ alkylene group.

In one embodiment, X¹¹ is each independently a -C₁₋₆ alkylene-O-C₁₋₆ alkylene- or a -O-C₁₋₆ alkylene-.

In a preferable embodiment, X¹¹ is each independently a single bond or a linear C₁₋₈ alkylene group, preferably a single bond or a linear C₁₋₃ alkylene group, more preferably a single bond or a linear C₁₋₂ alkylene group, and even more preferably a linear C₁₋₂ alkylene group.

In the formula, R¹³ is each independently a hydrogen atom or a monovalent organic group. Such a monovalent organic group is preferably a C₁₋₂₀ alkyl group.

In a preferable embodiment, R¹³ is each independently a hydrogen atom or a linear C₁₋₈ alkyl group, preferably a hydrogen atom or a linear C₁₋₃ alkyl group, and preferably a hydrogen atom or a methyl group.

In the formula, R¹⁵ is each independently a single bond, an oxygen atom, an alkylene group having 1 to 6 carbon atoms, or an alkyleneoxy group having 1 to 6 carbon atoms.

In one embodiment, R¹⁵ is each independently an oxygen atom, an alkylene group having 1 to 6 carbon atoms, or an alkyleneoxy group having 1 to 6 carbon atoms.

In a preferable embodiment, R¹⁵ is a single bond.

In the formula, t is each independently an integer of 2 or more.

In a preferable embodiment, t is each independently an integer of 2 to 10, and preferably an integer of 2 to 6.

In the formula, R¹⁴ is each independently a hydrogen atom, a halogen atom, or -X¹¹-SiR¹¹ₙ₁R¹²₃₋ₙ₁. Such a halogen atom is preferably an iodine atom, a chlorine atom, or a fluorine atom, and more preferably a fluorine atom. In a preferable embodiment, R¹⁴ is a hydrogen atom.

In one embodiment, the formula (S1) is the following formula (S1-a): 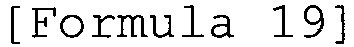 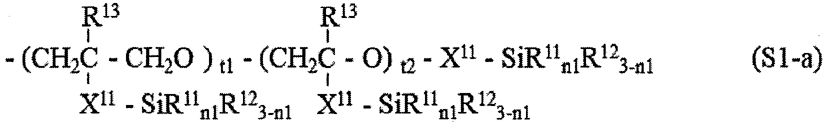 wherein
R¹¹, R¹², R¹³, X¹¹, and n1 have the same meanings as those described for the formula (S1),
t1 and t2 are each independently an integer of 1 or more, preferably an integer of 1 to 10, and more preferably an integer of 2 to 10, such as an integer of 1 to 5 or an integer of 2 to 5, and
the occurrence order of the respective repeating units enclosed in parentheses provided with t1 and t2 is not limited in the formula.

In a preferable embodiment, the formula (S1) is the following formula (S1-b): 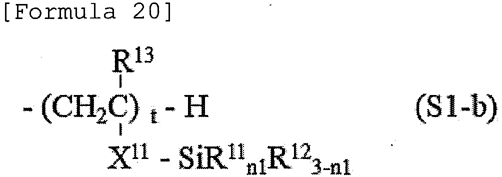 R¹¹, R¹², R¹³, X¹¹, n1, and t have the same meanings as those described for the formula (S1).

R^{a1} is each independently -Z¹-SiR²¹ₚ₁R²²_{q1}R²³ᵣ₁.

Z¹ is each independently an oxygen atom or a divalent organic group. Below, the right side of the structure denoted as Z¹ binds to (S₁R²¹ₚ₁R²²_{q1}R²³ᵣ₁).

In a preferable embodiment, Z¹ is a divalent organic group.

In a preferable embodiment, Z¹ does not include a group that forms a siloxane bond with the Si atom to which Z¹ is bonded. Preferably, in the formula (S3), (Si-Z¹-Si) does not include a siloxane bond.

Z¹ is preferably a C₁₋₆ alkylene group, -(CH₂)_{z1}-O-(CH₂)_{z2}- (wherein z1 is an integer of 0 to 6 such as an integer of 1 to 6, and z2 is an integer of 0 to 6 such as an integer of 1 to 6), or -(CH₂)_{z3}-phenylene-(CH₂)_{z4}-(wherein z3 is an integer of 0 to 6 such as an integer of 1 to 6, and z4 is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z¹ is a C₁₋₆ alkylene group or -(CH₂)_{z3}-phenylene-(CH₂)_{z4}-, and preferably - phenylene- (CH₂)_{z4}-.

In another preferable embodiment, Z¹ is a C₁₋₃ alkylene group. In one embodiment, Z¹ may be -CH₂CH₂CH₂-. In another embodiment, Z¹ may be -CH₂CH₂-.

R²¹ is each independently -Z^{1'}-SiR^{21'}_{p1'}R^{22'}_{q1'}R^{23'}_{r1'}.

Z^{1'} is each independently an oxygen atom or a divalent organic group. Below, the right side of the structure denoted as Z^{1'} binds to (SiR^{21'}_{p1'}R^{22'}_{q1'}R^{23'}_{r1'}).

In a preferable embodiment, Z^{1'} is a divalent organic group.

In a preferable embodiment, Z^{1'} does not include a group that forms a siloxane bond with the Si atom to which Z^{1'} is bonded. Preferably, in the formula (S3), (Si-Z^{1'}-Si) does not include a siloxane bond.

Z^{1'} is preferably a C₁₋₆ alkylene group, -(CH₂)_{z1'}-O-(CH₂)_{z2'}-(wherein z1' is an integer of 0 to 6 such as an integer of 1 to 6, and z2' is an integer of 0 to 6 such as an integer of 1 to 6), or -(CH₂)_{z3'}-phenylene-(CH₂)_{z4'}-(wherein z3' is an integer of 0 to 6 such as an integer of 1 to 6, and z4' is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₈ alkyl group, a C₂₋₆ alkenyl group, and a C₂₋₆ alkynyl group, and are preferably unsubstituted.

In a preferable embodiment, Z^{1'} is a C₁₋₈ alkylene group or -(CH₂)_{z3'}-phenylene-(CH₂)_{z4'}-, and preferably - phenylene- (CH₂)_{z4'}-.

In another preferable embodiment, Z^{1'} is a C₁₋₃ alkylene group. In one embodiment, Z^{1'} may be -CH₂CH₂CH₂-. In another embodiment, Z^{1'} may be -CH₂CH₂-.

R^{21'} is each independently -Z^{1"}-SiR^{22"}_{q1"}R^{23"}_{r1"}.

Z^{1"} is each independently an oxygen atom or a divalent organic group. Below, the right side of the structure denoted as Z^{1"} binds to (SiR^{22"}_{q1"}R^{23"}_{r1"}).

In a preferable embodiment, Z^{1"} is a divalent organic group.

In a preferable embodiment, Z^{1"} does not include a group that forms a siloxane bond with the Si atom to which Z^{1"} is bonded. Preferably, in the formula (S3), (Si-Z^{1"}-Si) does not include a siloxane bond.

Z^{1"} is preferably a C₁₋₆ alkylene group, -(CH₂)_{z1"}-O-(CH₂)_{z2"}- (wherein z1" is an integer of 0 to 6 such as an integer of 1 to 6, and z2" is an integer of 0 to 6 such as an integer of 1 to 6), or -(CH₂)_{z3"}-phenylene-(CH₂)_{z4"}-(wherein z3" is an integer of 0 to 6 such as an integer of 1 to 6, and z4" is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z^{1"} is a C₁₋₆ alkylene group or -(CH₂)_{z3"}-phenylene-(CH₂)_{z4"}-, and preferably - phenylene- (CH₂)_{z4"}-. When Z^{1"} is such a group, light resistance, in particular ultraviolet resistance, can be more increased.

In another preferable embodiment, Z^{1"} is a C₁₋₃ alkylene group. In one embodiment, Z^{1"} may be - CH₂CH₂CH₂-. In another embodiment, Z^{1"} may be -CH₂CH₂-.

R^{22"} is each independently a hydroxyl group or a hydrolyzable group.

R^{22"} is preferably, each independently, a hydrolyzable group.

R^{22"} is preferably, each independently, -OR^{h}, -OCOR^{h}, -O-N=CR^{h}₂, -NR^{h}₂, -NHR^{h}, or -NCO (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23"} is each independently a monovalent organic group. Such a monovalent organic group is a monovalent organic group excluding the above hydrolyzable group.

In R^{23"}, the monovalent organic group is preferably a C₁₋₂₀ alkyl group, more preferably a C₁₋₆ alkyl group, and even more preferably a methyl group.

q1" is each independently an integer of 0 to 3, and r1" is each independently an integer of 0 to 3. The sum of q1" and r1" is 3 in the (SiR^{22"}_{q1"}R^{23"}_{r1"}) unit.

q1" is preferably, each independently, an integer of 1 to 3, more preferably 2 to 3, and even more preferably 3 for each (SiR^{22"}_{q1}R^{23"}_{r1"}) unit.

R^{22'} is each independently a hydroxyl group or a hydrolyzable group.

R^{22'} is preferably, each independently, a hydrolyzable group.

R^{22'} is preferably, each independently, -OR^{h}, or - OCOR^{h} (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R^{23'} is each independently a monovalent organic group. Such a monovalent organic group is a monovalent organic group excluding the above hydrolyzable group.

In R^{23'}, the monovalent organic group is preferably a C₁₋₂₀ alkyl group, more preferably a C₁₋₆ alkyl group, and even more preferably a methyl group.

p1' is each independently an integer of 0 to 3, q1' is each independently an integer of 0 to 3, and r1' is each independently an integer of 0 to 3. The sum of p', q1', and r1' is 3 in the (SiR^{21'}_{p1'}R^{22'}_{q1'}R^{23'}_{r1'}) unit.

In one embodiment, p1' is 0.

In one embodiment, p1' may be each independently an integer of 1 to 3, an integer of 2 to 3, or 3 for each (SiR^{21'}_{p1'}R^{22'}_{q1'}R^{23'}_{r1'}) unit. In a preferable embodiment, p1' is 3.

In one embodiment, q1' is each independently an integer of 1 to 3, preferably an integer of 2 to 3, and more preferably 3 for each (SiR^{21'}_{p1'}R^{22'}_{q1'}R^{23'}_{r1'}) unit.

In one embodiment, p1' is 0, and q1' is each independently an integer of 1 to 3, preferably an integer of 2 to 3, and even more preferably 3 for each (SiR^{21'}_{p1'}R^{22'}_{q1'}R^{23'}_{r1'}) unit.

R²² is each independently a hydroxyl group or a hydrolyzable group.

R²² is preferably, each independently, a hydrolyzable group.

R²² is preferably, each independently, -OR^{h}, or - OCOR^{h} (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R²³ is each independently a monovalent organic group. Such a monovalent organic group is a monovalent organic group excluding the above hydrolyzable group.

In R²³, the monovalent organic group is preferably a C₁₋₂₀ alkyl group, more preferably a C₁₋₆ alkyl group, and even more preferably a methyl group.

p1 is each independently an integer of 0 to 3, q1 is each independently an integer of 0 to 3, and r1 is each independently an integer of 0 to 3. The sum of p1, q1, and r1 is 3 in the (SiR²¹ₚ₁R²²_{q1}R²³ᵣ₁) unit.

In one embodiment, p1 is 0.

In one embodiment, p1 may be each independently an integer of 1 to 3, an integer of 2 to 3, or 3 for each (SiR²¹ₚ₁R²²_{q1}R²³ᵣ₁) unit. In a preferable embodiment, p1 is 3.

In one embodiment, q1 is each independently an integer of 1 to 3, preferably an integer of 2 to 3, and more preferably 3 for each (SiR²¹ₚ₁R²²_{q1}R²³ᵣ₁) unit.

In one embodiment, p1 is 0, and q1 is each independently an integer of 1 to 3, preferably an integer of 2 to 3, and even more preferably 3 for each (SiR²¹ₚ₁R²²_{q1}R²³ᵣ₁) unit.

In the formula, R^{b1} is each independently a hydroxyl group or a hydrolyzable group.

R^{b1} is preferably, each independently, a hydrolyzable group.

R^{b1} is preferably, each independently, -OR^{h}, or - OCOR^{h} (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

In the formula, R^{c1} is each independently a monovalent organic group. Such a monovalent organic group is a monovalent organic group excluding the above hydrolyzable group.

In R^{c1}, the monovalent organic group is preferably a C₁₋₂₀ alkyl group, more preferably a C₁₋₆ alkyl group, and even more preferably a methyl group.

k1 is each independently an integer of 0 to 3, l1 is each independently an integer of 0 to 3, and m1 is each independently an integer of 0 to 3. The sum of k1, l1, and m1 is 3 in the (SiR^{a1}ₖ₁R^{b1}ₗ₁R^{c1}ₘ₁) unit.

In one embodiment, k1 is each independently an integer of 1 to 3, preferably 2 or 3, and more preferably 3 for each (SiR^{a1}ₖ₁R^{b1}ₗ₁R^{c1}ₘ₁) unit. In a preferable embodiment, k1 is 3.

In the formula (S3), at least two Si atoms to which a hydroxyl group or a hydrolyzable group is bonded are present.

In a preferable embodiment, in the terminal moiety of the formula (S3), at least two Si atoms to which a hydroxyl group or a hydrolyzable group is bonded are present.

In a preferable embodiment, the group represented by the formula (S3) has any one of -Z¹-SiR²²_{q1}R²³ᵣ₁ (wherein q1 is an integer of 1 to 3, preferably 2 or 3, and more preferably 3, and r1 is an integer of 0 to 2), -Z^{1'}-SiR^{22'}_{q1'}R^{23'}_{r1'} (wherein q1' is an integer of 1 to 3, preferably 2 or 3, and more preferably 3, and r1' is an integer of 0 to 2), and -Z^{1"}-SiR^{22"}_{q1"}R^{23"}_{r1"} (wherein q1" is an integer of 1 to 3, preferably 2 or 3, and more preferably 3, and r1" is an integer of 0 to 2). Z¹, Z^{1'}, Z^{1"}, R²², R²³, R^{22'}, R^{23'}, R^{22"}, and R^{23"} have the same meanings as those described above.

In a preferable embodiment, when R^{21'} is present in the formula (S3), q1" is an integer of 1 to 3, preferably 2 or 3, and more preferably 3 in at least one and preferably all R^{21'} groups.

In a preferable embodiment, when R²¹ is present in the formula (S3), p1' is 0, and q1' is an integer of 1 to 3, preferably 2 or 3, and more preferably 3 in at least one and preferably all R²¹ groups.

In a preferable embodiment, when R^{a1} is present in the formula (S3), p1 is 0, and q1 is an integer of 1 to 3, preferably 2 or 3, and more preferably 3 in at least one and preferably all R^{a1} groups.

In a preferable embodiment, in the formula (S3), k1 is 2 or 3 and is preferably 3, p1 is 0, q1 is 2 or 3 and is preferably 3.

R^{d1} is each independently -Z²-CR³¹ₚ₂R³²_{q2}R³³ᵣ₂.

Z² is each independently a single bond, an oxygen atom, or a divalent organic group. Below, the right side of the structure denoted as Z² binds to (CR³¹ₚ₂R³²_{q2}R³³ᵣ₂).

In a preferable embodiment, Z² is a divalent organic group.

In a preferable embodiment, Z² does not include a siloxane bond.

Z² is preferably a C₁₋₆ alkylene group, -(CH₂)_{z5}-O-(CH₂)_{z6}- (wherein z5 is an integer of 0 to 6 such as an integer of 1 to 6, and z6 is an integer of 0 to 6 such as an integer of 1 to 6), or -(CH₂)_{z7}-phenylene-(CH₂)_{z8}-(wherein z7 is an integer of 0 to 6 such as an integer of 1 to 6, and z8 is an integer of 0 to 6 such as an integer of 1 to 6). Such a C₁₋₆ alkylene group may be linear or may be branched, and is preferably linear. These groups may be substituted with, for example, one or more substituents selected from, a fluorine atom, a C₁₋₆ alkyl group, a C₂₋₆ alkenyl group, and a C₂₋₆ alkynyl group, and are preferably unsubstituted.

In a preferable embodiment, Z² is a C₁₋₆ alkylene group or -(CH₂)_{z7}-phenylene-(CH₂)_{z8}-, and preferably - phenylene-(CH₂)_{z8}-. When Z² is such a group, light resistance, in particular ultraviolet resistance, can be more increased.

In another preferable embodiment, Z² is a C₁₋₃ alkylene group. In one embodiment, Z² may be -CH₂CH₂CH₂-. In another embodiment, Z² may be -CH₂CH₂-.

R³¹ is each independently -Z^{2'}-CR^{32'}_{q2'}R^{33'}_{r2'}.

Z^{2'} is each independently a single bond, an oxygen atom, or a divalent organic group. Below, the right side of the structure denoted as Z^{2'} binds to (CR^{32'}_{q2'}R^{33'}_{r2'}).

In a preferable embodiment, Z^{2'} does not include a siloxane bond.

Z^{2'} is preferably a C₁₋₆ alkylene group, -(CH₂)_{z5'}-O-(CH₂)_{z6'}- (wherein z5' is an integer of 0 to 6 such as an integer of 1 to 6, and z6' is an integer of 0 to 6 such as an integer of 1 to 6), or -(CH₂)_{z7'}-phenylene-(CH₂)_{z8'}-(wherein z7' is an integer of 0 to 6 such as an integer of 1 to 6, and z8' is an integer of 0 to 6 such as an integer of 1 to 6). Such a C₁₋₆ alkylene group may be linear or may be branched, and is preferably linear. These groups may be substituted with one or more substituents selected from, for example, a fluorine atom, a C₁₋₆ alkyl group, a C₂₋₆ alkenyl group, and a C₂₋₆ alkynyl group, and are preferably unsubstituted.

In a preferable embodiment, Z^{2'} is a C₁₋₈ alkylene group or -(CH₂)_{z7'}-phenylene-(CH₂)_{z8'}-, and preferably - phenylene- (CH₂)_{z8'}-. When Z^{2'} is such a group, light resistance, in particular ultraviolet resistance, can be more increased.

In another preferable embodiment, Z^{2'} is a C₁₋₃ alkylene group. In one embodiment, Z^{2'} may be -CH₂CH₂CH₂-. In another embodiment, Z^{2'} may be -CH₂CH₂-.

R^{32'} is each independently -Z³-SiR³⁴ₙ₂R³⁵₃₋ₙ₂.

Z³ is each independently a single bond, an oxygen atom, or a divalent organic group. Below, the right side of the structure denoted as Z³ binds to (SiR³⁴ₙ₂R³⁵₃₋ₙ₂).

In one embodiment, Z³ is an oxygen atom.

In one embodiment, Z³ is a divalent organic group.

In a preferable embodiment, Z³ does not include a siloxane bond.

Z³ is preferably a C₁₋₆ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), - (CH₂)_{z7"}-phenylene-(CH₂)_{z8"}-(wherein z7" is an integer of 0 to 6 such as an integer of 1 to 6, and z8" is an integer of 0 to 6 such as an integer of 1 to 6), or - (CH₂)_{z9"}-OCONR^{z1}-(CH₂)_{z10"}- (wherein R^{z1} is a hydrogen atom or a C₁₋₆ alkyl group, and particularly a hydrogen atom, z9" is an integer of 0 to 6, such as an integer of 1 to 6, and z10" is an integer of 0 to 6, such as an integer of 1 to 6). Such a C₁₋₈ alkylene group may be linear or may be branched, and is preferably linear. These groups may be substituted with, for example, one or more substituents selected from a fluorine atom, a C₁₋₈ alkyl group, a C₂₋₆ alkenyl group, and a C₂₋₆ alkynyl group, and are preferably unsubstituted.

In a preferable embodiment, Z³ is a C₁₋₈ alkylene group, -(CH₂)_{z7"}-phenylene-(CH₂)_{z8"}-, or -(CH₂)_{z9"}-OCONR^{z1}-(CH₂)_{z10"}-, and preferably -phenylene- (CH₂)_{z8"}- or - (CH₂)_{z9"}-OCONR^{z1}-(CH₂)_{z10"}-. When Z³ is such a group, light resistance, in particular ultraviolet resistance, can be more increased.

In another preferable embodiment, Z³ is a C₁₋₃ alkylene group. In one embodiment, Z³ may be -CH₂CH₂CH₂-. In another embodiment, Z³ may be -CH₂CH₂-.

R³⁴ is each independently a hydroxyl group or a hydrolyzable group.

R³⁴ is preferably, each independently, a hydrolyzable group.

R³⁴ is preferably, each independently, -OR^{h}, -OCOR^{h}, -O-N=CR^{h}₂, -NR^{h}₂, -NHR^{h}, -NCO, or a halogen (in these formulae, R^{h} represents a substituted or unsubstituted C₁₋₄ alkyl group), and more preferably -OR^{h} (i.e., an alkoxy group). Examples of R^{h} include unsubstituted alkyl groups such as a methyl group, an ethyl group, a propyl group, an isopropyl group, a n-butyl group, and an isobutyl group; and substituted alkyl groups such as a chloromethyl group. Among such groups, an alkyl group, in particular an unsubstituted alkyl group, is preferable, and a methyl group or an ethyl group is more preferable. In one embodiment, R^{h} is a methyl group, and in another embodiment, R^{h} is an ethyl group.

R³⁵ is each independently a monovalent organic group. Such a monovalent organic group is a monovalent organic group excluding the above hydrolyzable group.

In R³⁵, the monovalent organic group is preferably a C₁₋₂₀ alkyl group, more preferably a C₁₋₆ alkyl group, and even more preferably a methyl group.

n2 is each independently an integer of 0 to 3 for each (SiR³⁴ₙ₂R³⁵₃₋ₙ₂) unit, provided that, in the terminal moiety of the formula (S4), at least two (SiR³⁴ₙ₂R³⁵₃₋ₙ₂) units wherein n2 is 1 to 3 are present. In other words, in the terminal moiety of the formula (S4), at least two Si atoms to which a hydroxyl group or a hydrolyzable group is bonded are present.

n2 is each independently an integer of preferably 1 to 3, more preferably 2 to 3, and even more preferably 3 for each (SiR³⁴ₙ₂R³⁵₃₋ₙ₂) unit.

R^{33'} is each independently a hydrogen atom, a hydroxyl group, or a monovalent organic group. Such a monovalent organic group is a monovalent organic group excluding the hydrolyzable group.

In R^{33'}, the monovalent organic group is preferably a C₁₋₂₀ alkyl group or -(CₛH₂ₛ)ₜ₁-(O-CₛH₂ₛ)ₜ₂-H (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group, even more preferably a C₁₋₆ alkyl group, and particularly preferably a methyl group.

In one embodiment, R^{33'} is a hydroxyl group.

In another embodiment, R^{33'} is a monovalent organic group, preferably a C₁₋₂₀ alkyl group, and more preferably a C₁₋₈ alkyl group.

q2' is each independently an integer of 0 to 3, and r2' is each independently an integer of 0 to 3. The sum of q2' and r2' is 3 in the (CR³²'_{q2'}R^{33'}_{r2'}) unit.

q2' is each independently an integer of preferably 1 to 3, more preferably 2 to 3, and even more preferably 3 for each (CR^{32'}_{q2'}R^{33'}_{r2'}) unit.

R³² is each independently -Z³SiR³⁴ₙ₂R³⁵₃₋ₙ₂. Such -Z³-SiR³⁴ₙ₂R³⁵₃₋ₙ₂ has the same meanings as those described for R^{32'} .

R³³ is each independently a hydrogen atom, a hydroxyl group, or a monovalent organic group. Such a monovalent organic group is a monovalent organic group excluding the above hydrolyzable group.

In R³³, the monovalent organic group is preferably a C₁₋₂₀ alkyl group or -(CₛH₂ₛ)ₜ₁-(O-CₛH₂ₛ)ₜ₂-H (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group, even more preferably a C₁₋₆ alkyl group, and particularly preferably a methyl group.

In one embodiment, R³³ is a hydroxyl group.

In another embodiment, R³³ is a monovalent organic group, preferably a C₁₋₂₀ alkyl group, and more preferably a C₁₋₆ alkyl group.

p2 is each independently an integer of 0 to 3, q2 is each independently an integer of 0 to 3, and r2 is each independently an integer of 0 to 3. The sum of p2, q2, and r2 is 3 in the (CR³¹ₚ₂R³²_{q2}R³³ᵣ₂) unit.

In one embodiment, p2 is 0.

In one embodiment, p2 may be each independently an integer of 1 to 3, an integer of 2 to 3, or 3 for each (CR³¹ₚ₂R³²_{q2}R³³ᵣ₂) unit. In a preferable embodiment, p2 is 3.

In one embodiment, q2 is each independently an integer of 1 to 3, preferably an integer of 2 to 3, and more preferably 3 for each (CR³¹ₚ₂R³²_{q2}R³³ᵣ₂) unit.

In one embodiment, p2 is 0, and q2 is each independently an integer of 1 to 3, preferably an integer of 2 to 3, and even more preferably 3 for each (CR³¹ₚ₂R³²_{q2}R³³ᵣ₂) unit.

R^{e1} is each independently -Z³-SiR³⁴ₙ₂R³⁵₃₋ₙ₂. Such -Z³-SiR³⁴ₙ₂R³⁵₃₋ₙ₂ has the same meanings as those described for R^{32'} .

R^{f1} is each independently a hydrogen atom, a hydroxyl group, or a monovalent organic group. Such a monovalent organic group is a monovalent organic group excluding the above hydrolyzable group.

In R^{f1}, the monovalent organic group is preferably a C₁₋₂₀ alkyl group, a C₂₋₂₀ alkenyl group, or -(CₛH₂ₛ)ₜ₁-(O-CₛH₂ₛ)ₜ₂-H (wherein s is an integer of 1 to 6, preferably an integer of 2 to 4, t1 is 1 or 0 and preferably 0, and t2 is an integer of 1 to 20, preferably an integer of 2 to 10, and more preferably an integer of 2 to 6), more preferably a C₁₋₂₀ alkyl group or a C₂₋₂₀ alkenyl group, even more preferably a C₁₋₆ alkyl group or a C₂₋₆ alkenyl group, and particularly preferably a methyl group, an ethyl group, or a 2-propenyl group.

In one embodiment, R^{f1} is a hydrogen atom.

In one embodiment, R^{f1} is a hydroxyl group.

In another embodiment, R^{f1} is a monovalent organic group, preferably a C₁₋₂₀ alkyl group or a C₂₋₂₀ alkenyl group, and more preferably a C₁₋₆ alkyl group or a C₂₋₆ alkenyl group.

k2 is each independently an integer of 0 to 3, l2 is each independently an integer of 0 to 3, and m2 is each independently an integer of 0 to 3. The sum of k2, l2, and m2 is 3 in the (CR^{d1}ₖ₂R^{e1}ₗ₂R^{f1}ₘ₂) unit.

In one embodiment, two or more such as 2 to 27, preferably 2 to 9, more preferably 2 to 6, even more preferably 2 to 3, and particularly preferably 3 (SiR³⁴ₙ₂R³⁵₃₋ₙ₂) units in which n2 is 1 to 3, preferably 2 or 3, and more preferably 3 are present in each terminal moiety of the formula (S4).

In a preferable embodiment, when R^{32'} is present in the formula (S4), n2 is an integer of 1 to 3, preferably 2 or 3, and more preferably 3 in at least one and preferably all R^{32'} groups.

In a preferable embodiment, when R³² is present in the formula (S4), n2 is an integer of 1 to 3, preferably 2 or 3, and more preferably 3 in at least one and preferably all R³² groups.

In a preferable embodiment, when R^{e1} is present in the formula (S4), n2 is an integer of 1 to 3, preferably 2 or 3, and more preferably 3 in at least one and preferably all R^{a1} groups.

In a preferable embodiment, in the formula (S4), k2 is 0, l2 is 2 or 3 and is preferably 3, and n2 is 2 or 3 and is preferably 3.

R^{g1} and R^{h1} are each independently -Z⁴-SiR¹¹ₙ₁R¹²₃₋ₙ₁, - Z⁴-SiR^{a1}ₖ₁R^{h1}ₗ₁R^{c1}ₘ₁, or -Z⁴-CR^{d1}ₖ₂R^{e1}ₗ₂R^{f1}ₘ₂. Here, R¹¹, R¹², R^{a1}, R^{b2}, R^{c1}, R^{d1}, R^{e1}, R^{f1}, n1, k1, l1, m1, k2, l2, and m2 have the same meanings as above.

In a preferable embodiment, R^{g1} and R^{h1} are each independently -Z⁴-SiR¹¹ₙ₁R¹²₃₋ₙ₁.

Z⁴ is each independently a single bond, an oxygen atom, or a divalent organic group. Below, the right side of the structure denoted as Z⁴ binds to (SiR¹¹ₙ₁R¹²₃₋ₙ₁).

In one embodiment, Z⁴ is an oxygen atom.

In one embodiment, Z⁴ is a divalent organic group.

In a preferable embodiment, Z⁴ does not include a siloxane bond.

Z⁴ is preferably a C₁₋₈ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}-(wherein z7" is an integer of 0 to 6 such as an integer of 1 to 6, and z8" is an integer of 0 to 6 such as an integer of 1 to 6). Such a C₁₋₆ alkylene group may be linear or may be branched, and is preferably linear. These groups may be substituted with, for example, one or more substituents selected from a fluorine atom, a C₁₋₈ alkyl group, a C₂₋₆ alkenyl group, and a C₂₋₆ alkynyl group, and are preferably unsubstituted.

In a preferable embodiment, Z⁴ is a C₁₋₆ alkylene group or -(CH₂)_{z7"}-phenylene-(CH₂)_{z8"}-, and preferably - phenylene- (CH₂)_{z8"}-. When Z³ is such a group, light resistance, in particular ultraviolet resistance, can be more increased.

In another preferable embodiment, Z⁴ is a C₁₋₃ alkylene group. In one embodiment, Z⁴ may be -CH₂CH₂CH₂-. In another embodiment, Z⁴ may be -CH₂CH₂-.

In one embodiment, none of the formulae (S1), (S2), (S3), and (S4) contains a siloxane bond.

In one embodiment, R^{Si} is a group represented by the formula (S2), (S3), (S4), or (S5).

In one embodiment, R^{Si} is a group represented by the formula (S2), (S3), or (S4).

In one embodiment, R^{Si} is a group represented by the formula (S3), (S4), or (S5).

In one embodiment, R^{Si} is a group represented by the formula (S3) or (S4).

In one embodiment, R^{Si} is a group represented by the formula (S4) or (S5).

In one embodiment, R^{Si} is a group represented by the formula (S1). In a preferable embodiment, n1 is 1 to 3, preferably 2 to 3, and even more preferably 3.

In one embodiment, R^{Si} is a group represented by the formula (S2). In a preferable embodiment, n1 is 1 to 3, preferably 2 to 3, and even more preferably 3.

In one embodiment, R^{Si} is a group represented by the formula (S3). In a preferable embodiment, the formula (S3) is -SiR^{a1}₂R^{c1} or -SiR^{a1}₃, R^{a1} is -Z¹-SiR²²_{q1}R²³ᵣ₁, Z¹ is a C₁₋₆ alkylene group, -(CH₂)_{z1}-O-(CH₂)_{z2}- (wherein z1 is an integer of 0 to 6 such as an integer of 1 to 6, and z2 is an integer of 0 to 6 such as an integer of 1 to 6), or - (CH₂)_{z3}-phenylene-(CH₂)_{z4}- (wherein z3 is an integer of 0 to 6 such as an integer of 1 to 6, and z4 is an integer of 0 to 6 such as an integer of 1 to 6), preferably a C₁₋₆ alkylene group, and q1 is 1 to 3, preferably 2 to 3, and even more preferably 3.

In one embodiment, R^{Si} is a group represented by the formula (S4). In a preferable embodiment, the formula (S4) is -CR^{e1}_{2R}^{f1} or -CR^{e1}₃, R^{e1} is -Z³-SiR³⁴ₙ₂R³⁵₃₋ₙ₂, Z³ is a C₁₋₆ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}- (wherein z7" is an integer of 0 to 6 such as an integer of 1 to 6, and z8" is an integer of 0 to 6 such as an integer of 1 to 6), preferably a C₁₋₆ alkylene group, and n2 is 1 to 3, preferably 2 to 3, and even more preferably 3.

In one embodiment, R^{Si} is a group represented by the formula (S5). In a preferable embodiment, R^{g1} and R^{h1} are -Z⁴-SiR¹¹ₙ₁R¹²₃₋ₙ₁, Z⁴ is a C₁₋₆ alkylene group, -(CH₂)_{z5"}-O-(CH₂)_{z6"}- (wherein z5" is an integer of 0 to 6 such as an integer of 1 to 6, and z6" is an integer of 0 to 6 such as an integer of 1 to 6), or -(CH₂)_{z7"}-phenylene-(CH₂)_{z8"}-(wherein z7" is an integer of 0 to 6 such as an integer of 1 to 6, and z8" is an integer of 0 to 6 such as an integer of 1 to 6), preferably a C₁₋₆ alkylene group, and n1 is 1 to 3, preferably 2 to 3, and even more preferably 3.

In a preferable embodiment, formula (S5) is the following formulae. In the following formulae, * represents the point of attachment to X¹.

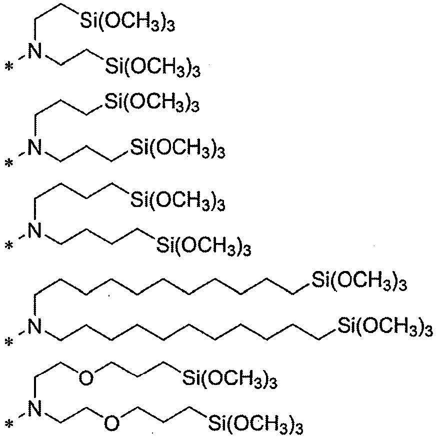

In a preferrable embodiment, at least one nitrogen atom of X¹ is bonded to at least one Si atom of R^{Si} via a group composed of other atoms and having a chain length of 1 or more and less than 7. For example, a C₁₋₆ alkylene group is preferably present between at least one nitrogen atom of X¹ and at least one Si atom of R^{Si}.

Preferably, the compound represented by the formula (1) contains at least one bond selected from the group consisting of an amide bond, a urethane bond, and a urea bond.

The compound represented by the formula (1) may contain only one bond, or a plurality of bonds, selected from the group consisting of an amide bond, a urethane bond, and a urea bond.

Preferably, the compound represented by the formula (1) does not contain an amino group. Further, it is more preferable that the compound represented by the formula (1) does not contain any nitrogen atom other than those in the amide bond, the urethane bond, and the urea bond.

When the compound represented by the formula (1) contains an amide bond, a N atom derived from the amide bond is present preferably within 15 atoms, more preferably within 10 atoms, and even more preferably within 7 atoms from any silicon atom in R^{Si}.

When the compound represented by the formula (1) contains a urethane bond, a N atom derived from the urethane bond is present preferably within 15 atoms, more preferably within 10 atoms, and even more preferably within 7 atoms from any silicon atom in R^{Si}.

When the compound represented by the formula (1) contains a urea bond, a N atom derived from the urea bond is present preferably within 15 atoms, more preferably within 10 atoms, and even more preferably within 7 atoms from any silicon atom in R^{Si}.

When the number of nitrogen atoms contained in the compound represented by the formula (1) is denoted by n_{N} and the number of silicon atoms is denoted by n_{Si}, preferably n_{Si} ≥ n_{N}, and more preferably n_{Si} ≥ n_{N} + 3.

In one embodiment, when the number of nitrogen atoms contained in the compound represented by the formula (1) is denoted by n_{N} and the number of silicon atoms is denoted by n_{Si}, preferably n_{Si} = n_{N}.

In one embodiment, when the number of nitrogen atoms contained in the compound represented by the formula (1) is denoted by n_{N} and the number of silicon atoms is denoted by n_{Si}, preferably n_{Si} = 2n_{N}.

Preferable examples of the compound represented by the formula (1) include the following compounds:
CH₃-[Si(CH₃)₂O]ₙ₁Si(CH₃)₂-(CH₂)_{H1}-C(=O)NHCH₂CH₂CH₂Si(OCH₃)₃
CH₃CH₂CH₂CH₂-[Si(CH₃)₂O]ₙ₁Si(CH₃)₂-(CH₂)_{H1}-C(=O)NHCH₂CH₂CH₂Si(OCH₃)₃
[(CH₃)₃SiO)]₂(CH₃)Si-O-[Si(CH₃)2O]ₙ₁Si(CH₃)₂-(CH₂)_{H1}-C(=O) NHCH₂CH₂CH₂Si(OCH₃)₃
[(CH3)₃SiO)]₃Si-O-[Si(CH₃)₂O]ₙ₁Si(CH₃)₂-(CH₂)_{H1}-C(=O)NHCH₂CH₂CH₂Si(OCH₃)₃
CH₃-[Si(CH₃)₂O]ₙ₁Si(CH₃)₂-(CH₂)_{H1}-O-(CH₂)_{H2}-C(=O)NHCH₂CH₂CH₂Si(OCH₃)₃
CH₃CH₂CH₂CH₂-[Si(CH₃)₂O]ₙ₁Si(CH₃)₂-(CH₂)_{H1}-O-(CH₂)_{H2}-C(=O)NHCH₂CH₂CH₂Si(OCH₃)₃
CH₃-[Si(CH₃)₂O]ₙ₁Si(CH₃)₂-(CH₂)_{H1}-C(=O)NHCH₂CH[CH₂CH₂CH₂Si(OCH₃)₃]₂
CH₃CH₂CH₂CH₂-[Si(CH₃)₂O]ₙ₁Si(CH₃)₂-(CH₂)ₙ₁-C(=O)NHCH₂CH[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}-C(=O)NHCH₂CH[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-C(=O)NHCH₂CH[CH₂CH₂CH₂Si(OCH₃)₃]₂
CH₃-[Si(CH₃)₂O]ₙ₁Si(CH₃)₂-(CH2)_{H1}-O-(CH2)_{H2}-C(=O)NHCH₂CH[CH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}-C(=O)NHCH₂CH[CH₂CH₂CH₂Si(OCH₃)₃]₂
CH₃-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
CH₃CH₂CH₂CH₂-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-C(=O)NHCH₂CH[CH₂CH₂CH₂CH₂CH₂CH₂CH₂CH₂CH₂CH₂CH₂Si(OCH₃)₃]₂
CH₃-[Si(CH₃)₂O]ₙ₁Si(CH₃)₂-(CH₂)_{H1}-O-(CH₂)_{H2}-C(=O)NHCH₂CH[CH₂CH₂CH₂CH₂CH₂CH₂CH₂CH₂CH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}-C(=O)NHCH₂CH[CH₂CH₂CH₂CH₂CH₂CH₂CH₂CH₂CH₂CH₂CH₂Si(OCH₃)₃]₂
CH₃-[Si(CH₃)₂O]ₙ₁Si(CH₃)₂-(CH₂)_{H1}-C(=O)N[CH₂CH₂CH₂Si(OCH₃)₃]₂
CH₃CH₂CH₂CH₂-[Si(CH3)₂O]ₙ₁Si(CH₃)₂-(CH₂)_{H1}-C(=O)N[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}-C(=O)N[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-C(=O)N[CH₂CH₂CH₂Si(OCH₃)₃]₂
CH₃-[Si(CH₃)₂O]ₙ₁Si(CH₃)₂-(CH₂)_{H1}-O-(CH₂)_{H2}-C(=O)N[CH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}-C(=O)N[CH₂CH₂CH₂Si(OCH₃)₃]₂
CH₃-[Si(CH₃)₂O]ₙ₁Si(CH₃)₂-(CH₂)_{H1}-N[CH₂CH₂CH₂Si(OCH₃)₃]₂
CH₃CH₂CH₂CH₂-[Si(CH₃)₂O]ₙ₁Si(CH₃)₂-(CH₂)_{H1}-N[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}-N[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-N[CH₂CH₂CH₂Si(OCH₃)₃]₂
CH₃-[Si(CH₃)₂O]ₙ₁Si(CH₃)₂-(CH₂)_{H1}-C(=O)NHCH₂C[CH₂CH₂CH₂Si(OCH₃)₃]₃
CH₃CH₂CH₂CH₂-[Si(CH₃)₂O]ₙ₁Si(CH₃)₂-(CH₂)_{H1}-C(=O)NHCH₂C[CH₂CH₂CH₂Si(OCH₃)₃]₃
[(CH₃)₃SiO)]2(CH₃)Si-O-[Si(CH₃)₂O]ₙ₁Si(CH₃)₂-(CH₂)_{H1}-C(=O)NHCH₂C[CH₂CH₂CH₂Si(OCH₃)₃]₃
[(CH₃)₃SiO)]₃Si-O-[Si(CH₃)₂O]ₙ₁Si(CH₃)₂-(CH₂)_{H1}-C(=O)NHCH₂C[CH₂CH₂CH₂Si(OCH₃)₃]₃
CH₃-[Si(CH₃)₂O]ₙ₁Si(CH₃)₂-(CH₂)_{H1}-O-(CH₂)_{H2}-C(=O)NHCH₂C[CH₂CH₂CH₂Si(OCH₃)₃]₃
CH₃CH₂CH₂CH₂-[Si(CH₃)₂O]ₙ₁Si(CH₃)₂-(CH₂)_{H1}-O-(CH₂)_{H2}-C(=O)NHCH₂C[CH₂CH₂CH₂Si(OCH₃)₃]₃
[(CH₃)₃SiO)]₂(CH₃)Si-(CH₂)_{H1}-C(=O)NHCH₂CH₂CH₂Si(OCH₃)₃
[(CH₃)₃SiO)]₃Si-(CH₂)_{H1}-C(=O)NHCH₂CH₂CH₂Si(OCH₃)₃
[(CH₃)₃SiO)]₂(CH₃)Si-(CH₂)_{H1}-C(=O)NHCH₂CH[CH₂CH₂CH₂Si(OCH₃)₃]₂
[(CH₃)₃SiO)]₃Si-(CH₂)_{H1}-C(=O)NHCH₂CH[CH₂CH₂CH₂Si(OCH₃)₃]₂
[(CH₃)₃SiO)]₂(CH₃)Si-(CH₂)_{H1}-C(=O)NHCH₂CH[CH₂CH₂CH₂CH₂CH₂CH₂CH₂CH₂CH₂CH₂CH₂Si(OCH₃)₃]₂
[(CH₃)₃SiO)]₃Si-(CH₂)_{H1}-C(=O)NHCH₂CH[CH₂CH₂CH₂CH₂CH₂CH₂CH₂CH₂CH₂CH₂CH₂Si(OCH₃)₃]₂
[(CH₃)₃SiO)]₂(CH₃)Si-(CH₂)_{H1}-C(=O)N[CH₂CH₂CH₂Si(OCH₃)₃]₂
[(CH₃)₃SiO)]₃Si-(CH₂)_{H1}-C(=O)N[CH₂CH₂CH₂Si(OCH₃)₃]₂
[(CH₃)₃SiO)]₂(CH₃)Si-(CH₂)_{H1}-N[CH₂CH₂CH₂Si(OCH₃)₃]₂
[(CH₃)₃SiO)]₃Si-(CH₂)_{H1}-N[CH₂CH₂CH₂Si(OCH₃)₃]₂
[(CH₃)₃SiO)]₂(CH₃)Si-(CH₂)_{H1}-C(=O)NHCH₂C[CH₂CH₂CH₂Si(OCH₃)₃]₃
[(CH₃)₃SiO)]₃Si-(CH₂)_{H1}-C(=O)NHCH₂C[CH₂CH₂CH₂Si(OCH₃)₃]₃ 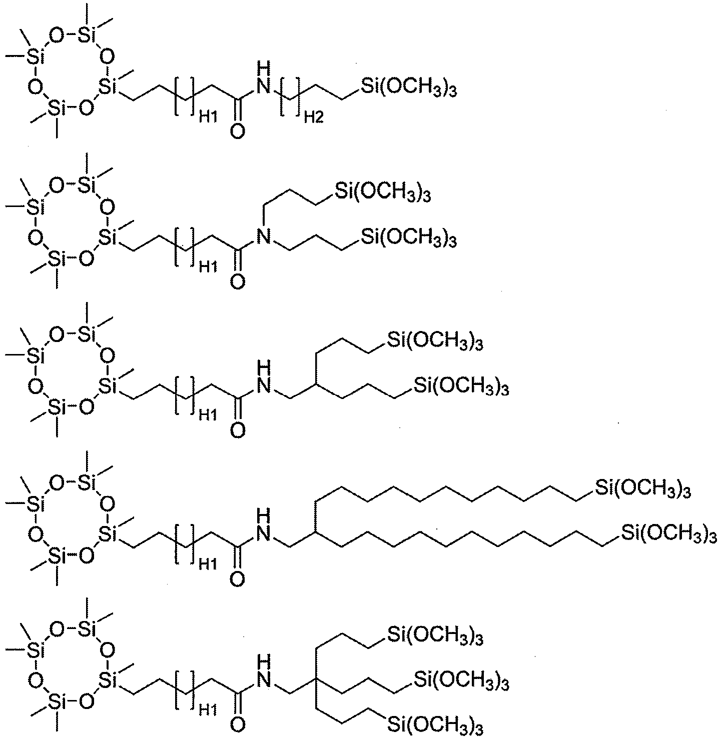
CH₃CH₂CH₂CH₂-[Si(CH₃)₂O]ₙ₁Si(CH₃)₂-(CH₂)_{H1}-O-(CH₂)_{H2}-C(CH₂CH₃)[CH₂OC(=O)NHCH₂CH₂CH₂Si(OCH₃)₃]₂
CH₃-[Si(CH₃)₂O]ₙ₁Si(CH₃)₂-(CH₂)_{H1}-O-(CH₂)_{H2}-C(CH₂CH₃)[CH₂OC(=O)NHCH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}-C(CH₂CH₃)[CH₂OC(=O)NHCH₂CH₂OC(=O)CH(CH₃)CH₂Si(OCH₃)₃]₂
CH₃-[Si(CH₃)₂O]ₙ₁Si(CH₃)₂-(CH₂)_{H1}-O-(CH₂)_{H2}-C(CH₂CH₃)[CH₂OC(=O)NHCH₂CH₂OC(=O)CH(CH₃)CH₂Si(OCH₃)₃]₂
CH₃CH₂CH₂CH₂-[Si(CH₃)₂O]ₙ₁Si(CH₃)₂--(CH₂)_{H1}-O-(CH₂)_{H2}-C[CH₂OC(=O)NHCH₂CH₂CH₂Si(OCH₃)₃]₃
CH₃-[(Si(CH₃)₂O)]ₙ₁Si(CH₃)₂-(CH₂)_{H1}-O-(CH₂)_{H2}-C[CH₂OC(=O)NHCH₂CH₂CH₂Si(OCH₃)₃]₃
[CH₃CH₂CH₂CH₂-[(Si(CH₃)₂O)]ₙ₁Si(CH₃)₂-(CH₂)_{H1}-O-(CH₂)_{H2}-]₂-C[CH₂OC(=O)NHCH₂CH₂CH₂Si(OCH₃)₃]₂
[CH₃-[(Si(CH₃)₂O)]ₙ₁Si(CH₃)₂-(CH₂)_{H1}-O-(CH₂)_{H2}-]₂-C[CH₂OC(=O)NHCH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}-OC(=O)NHCH₂CH₂CH₂Si(OCH₃)₃
CH₃-[Si(CH₃)₂O]ₙ₁Si(CH₃)₂-(CH₂)_{H1}-O-(CH₂)_{H2}-OC(=O)NHCH₂CH₂CH₂Si(OCH₃)₃
CH₃CH₂CH₂CH₂-[Si(CH₃)₂O]ₙ₁Si(CH₃)₂-(CH₂)_{H1}-O-(CH₂)_{H2}-OC(=O)NHCH₂CH₂OC(=O)CH(CH₃)CH₂Si(OCH₃)₃
CH₃-[Si(CH₃)₂O]ₙ₁Si(CH₃)₂-(CH₂)_{H1}-O-(CH₂)H₂-OC(=O)NHCH₂CH₂OC(=O)CH(CH₃)CH₂Si(OCH₃)₃
[CH₃CH₂CH₂CH₂-[Si(CH₃)₂O]ₙ₁Si(CH₃)₂-(CH₂)_{H1}-O-(CH₂)_{H2}-]₃C-CH₂OC(=O)NHCH₂CH₂CH₂Si(OCH₃)₃
[CH₃-[Si(CH₃)₂O]ₙ₁Si(CH₃)₂-(CH₂)_{H1}-O-(CH₂)_{H2}-]₃C-CH₂OC(=O)NHCH₂CH₂CH₂Si(OCH₃)₃
[CH₃CH₂CH₂CH₂-[(Si(CH₃)₂O)]ₙ₁Si(CH₃)₂-(CH₂)_{H1}-O-(CH₂)_{H2}-]₂C(CH₂CH₃)[CH₂OC(=O)NHCH₂CH₂CH₂Si(OCH₃)₃]
[CH₃-[(Si(CH₃)₂O)]ₙ₁Si(CH₃)₂-(CH₂)_{H1}-O-(CH₂)_{H2}-]₂C(CH₂CH₃)[CH₂OC(=O)NHCH₂CH₂CH₂Si(OCH₃)₃] wherein
n1 is each independently an integer of 0 to 100, and
H1 and H2 are each independently an integer of 1 to 50.

n1 is each independently an integer of 0 to 100.

In one embodiment, n1 is each independently 0 or 1.

In another embodiment, n1 is each independently an integer of 5 to 100, and preferably 10 to 80.

H1 is each independently an integer of 1 to 50, preferably 8 to 40, and more preferably 11 to 30.

H2 is each independently an integer of 1 to 50, preferably 1 to 10, and more preferably 1 to 5.

Preferable specific examples of the compound represented by the formula (1) include the following compounds:
CH₃CH₂CH₂CH₂Si(CH₃)₂O(Si(CH₃)₂O)ₙSi(CH₃)₂CH₂CH₂CH₂OCH₂CON HCH₂CH₂CH₂Si(OCH₃)₃ (wherein n is an integer of 40 to 70, such as 59);
CH₃CH₂CH₂CH₂Si(CH₃)₂-(OSi(CH₃)₂)-(CH₂)₃-OCH₂-CONH-CH₂C{CH₂CH₂CH₂Si(OCH₃)₃}₃ (wherein n is an integer of 40 to 70, such as 55); 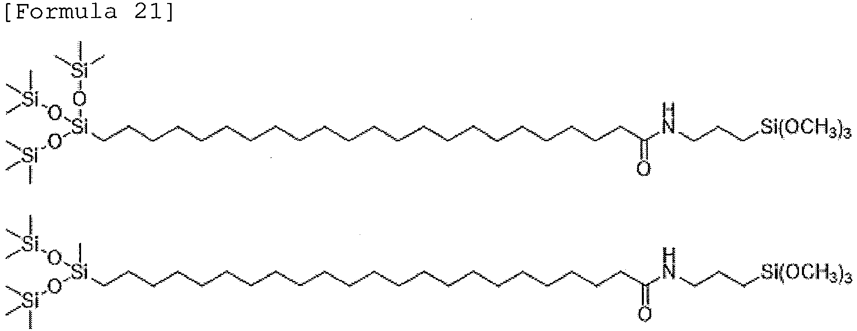
CH₃Si(CH₃)₂O(Si(CH₃)₂O)ₙSi(CH₃)₂(CH₂)₁₀CONHCH₂CH₂CH₂Si(OC H₃)₃ (wherein n is an integer of 10 to 30, such as 16).

Other preferable examples of the compound represented by the formula (1) include the following compounds:
(CH₃)₃Si-(OSi(CH₃)₂)ₙ-(CH₂)₁₀-CON[CH₂CH₂CH₂Si(OCH₃)₃]₂ (wherein n is an integer of 10 to 30, such as 19);
[(CH₃)₃SiO]₂CH₃SiO(Si(CH₃)₂O)ₙSi(CH₃)₂CH₂CH₂CH₂CH₂CH₂CH₂C H₂CH₂CH₂CH₂CH₂CH₂CH₂CH₂CH₂CH₂CH₂CH₂CH₂CH₂CH₂CH₂CONHCH₂CH[CH₂CH₂ CH₂Si(OCH₃)₃]₂ (wherein n is an integer of 20 to 40, such as 26);
CH₃[Si(CH₃)₂O]ₙSi(CH₃)₂(CH₂)₂₂CONH-CH₂CH[CH₂CH₂CH₂Si(OCH₃)₃]₂ (wherein n is an integer of 40 to 70, such as 57);
CH₃CH₂CH₂CH₂-[Si(CH₃)₂O]ₙSi(CH₃)₂-CH₂CH₂CH₂-O-CH₂-C(CH₂CH₃)[CH₂OC(=O)NHCH₂CH₂CH₂Si(OCH₃)₃]₂ (wherein n is an integer of 40 to 80, such as 63);
CH₃CH₂CH₂CH₂-[Si(CH₃)₂O]ₙSi(CH₃)₂-CH₂CH₂CH₂-O-CH₂CH₂O-C(=O)NHCH₂CH₂CH₂Si(OCH₃)₃ (wherein n is an integer of 40 to 80, such as 60); 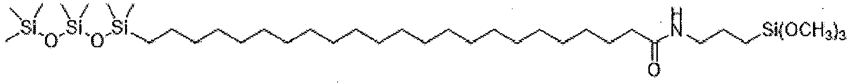 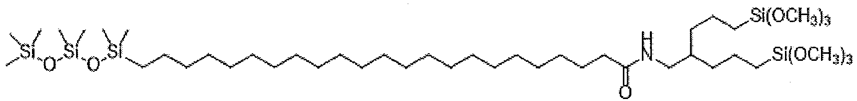
CH₃[Si(CH₃)₂O]ₙSi(CH₃)₂(CH₂)₂₂CON[CH₂CH₂CH₂Si(OCH₃)₃]₂ (wherein n is an integer of 20 to 40, such as 26);
CH₃(Si(CH₃)₂O)ₙSi(CH₃)₂(CH₂)₂₂CON[CH₂CH₂CH₂)₃Si(OCH₃)₃]₂ (wherein n is an integer of 20 to 50, such as 34); and
CH₃[Si(CH₃)₂O]ₙSi(CH₃)₂(CH₂)₂₂CON[(CH₂)₃Si(OCH₃)₃]₂ (wherein n is an integer of 40 to 60, such as 48).

Although not limited, the compound represented by the formula (1) may have a number average molecular weight of 5 × 10² to 1 × 10⁵. The compound represented by the formula (1) has a number average molecular weight of preferably 1,000 to 30,000, and more preferably 1,500 to 10,000 from the viewpoint of abrasion durability. Note that such a "number average molecular weight" is a value measured by ¹H-NMR.

The compound represented by the formula (1) can be obtained, for example, as follows. A compound represented by the following formula:

R¹⁶¹-COOH

wherein R¹⁶¹ is a R^{1ab}-R^{S}-containing group,
R^{1ab} is a hydrocarbon group, the group A, or the group B, and
R^{S} has the same meaning as above,

is reacted with a compound represented by the following formula:

   NH₂-R¹⁶²

   wherein R¹⁶² is an aryl group-containing group,
to give a compound represented by the following formula:

   R¹⁶¹-CONH-R¹⁶³-R¹⁶⁴

   wherein
   R¹⁶¹ is a R^{1ab}-R^{S}-containing group,
   R¹⁶³ is an (n + 1)-valent linker group, and
   R¹⁶⁴ is an allyl group.
Next, the thus obtained allyl compound is reacted with a compound represented by the following formula:

   HSiR¹⁶⁵ₘR¹⁶⁶₃₋ₘ

   wherein
   R¹⁶⁵ is each independently at each occurrence a hydroxyl group or a hydrolyzable group,
   R¹⁶⁶ is each independently at each occurrence a monovalent organic group, and
   m is 1 to 3.

As another method, the compound represented by the formula (1) can be obtained as follows.

First, an unsaturated carboxylic acid or an unsaturated carboxylic acid ester such as a compound represented by the formula:

· CH₂=CH-R¹⁷¹-COOR¹⁷²

wherein
R¹⁷¹ is an alkylene group, and
R¹⁷² is a hydrogen atom or a C₁₋₆ alkyl group,
is reacted with a silane compound such as a compound represented by the formula:

R^{1ab}-R^{S}-SiR^{2a}₂-H

wherein
R^{1ab} is a hydrocarbon group, the group A or the group B,
R^{2a} is each independently a hydrocarbon group,
to give a compound represented by the formula:

R^{1ab}-R^{S}-SiR^{2a}₂-CH₂CH₂-R¹⁷¹-COOR¹⁷².

Subsequently, the thus obtained compound is reacted with an amine derivative having a terminal carbon-carbon double bond, such as a compound represented by the formula:

NH₂-R¹⁷³

wherein
R¹⁷³ is -R¹⁷⁴-CH=CH₂, or -R¹⁷⁵(-R¹⁷⁴-CH=CH₂)₃,
R¹⁷⁴ is a single bond or a C₁₋₆ alkylene group,
R¹⁷⁵ is -R¹⁷⁶-C, and
R¹⁷⁴ is a single bond or a C₁₋₆ alkylene group,
to give a compound represented by:

R^{1ab}-R^{S}-SiR^{2a}₂-CH₂CH₂-R¹⁷¹-CONH₂-R¹⁷⁴-CH=CH₂,

or

R^{1ab}-R^{S}-SiR^{2a}₂-CH₂CH₂-R¹⁷¹-CONH₂-R¹⁷⁵(-R¹⁷⁴-CH=CH₂)₃.

Ultimately, the compound obtained as above is reacted with, for example, a compound represented by the formula:

HSi(R¹⁷⁶)₃

wherein R¹⁷⁶ is a hydrolyzable group, and thus, the compound represented by the formula (1) can be obtained.

In one embodiment, the water-repellent layer included in the laminate of the present disclosure is a cured product of a mixture with a compound represented by the following formula (2):
[Formula 22]

**R^{A}_{α1}-X^{A}-R^{Si}_{β1}** **(2)**

wherein
R^{A} is a carbon chain containing at least one ethereal oxygen atom,
X^{A} is a di- to decavalent group,
R^{Si} has the same meaning as R^{Si} in the compound represented by the formula (1),
α1 is each independently an integer of 1 to 9, and β1 is each independently an integer of 1 to 9.

R^{A} is a carbon chain containing at least one ethereal oxygen atom.

R^{A} is preferably a group represented by:

R^{A1}-O-(R^{A3}O)ₙ-R^{A2}-

wherein
R^{A1} is a C₁₋₃₆ alkyl group,
R^{A2} is a C₁₋₃₆ alkylene group,
R^{A3} is each independently a C₁₋₆ alkylene group, and
n is an integer of 0 to 200.

R^{A1} is a C₁₋₃₆ alkyl group, and may be preferably a C₁₋₃₀ alkyl group, more preferably C₁₋₂₆ alkyl group, even more preferably C₁₋₁₆ alkyl group, and yet more preferably C₁₋₆ alkyl group. Such an alkyl group may be linear or may be branched. In one embodiment, the alkyl group is linear. In another embodiment, the alkyl group is branched.

R^{A2} is a C₁₋₃₆ alkylene group, and may be preferably a C₁₋₃₀ alkylene group, more preferably C₁₋₂₆ alkylene group, even more preferably C₁₋₁₆ alkylene group, and yet more preferably C₁₋₆ alkylene group. Such an alkylene group may be linear or may be branched. In one embodiment, the alkylene group is linear. In another embodiment, the alkylene group is branched.

R^{A3} is each independently a C₁₋₆ alkylene group, and may be preferably a C₁₋₄ alkylene group, more preferably C₂₋₃ alkylene group, and even more preferably -CH₂CH₂-. Such an alkylene group may be linear or may be branched. In one embodiment, the alkylene group is linear. In another embodiment, the alkylene group is branched.

n is an integer of 0 to 200, and may be an integer of preferably 1 to 100, more preferably 1 to 50, more preferably 1 to 10, and even more preferably 1 to 6. The lower limit of n may be, for example, 0, 1, 3, 5, 7, 10, 15, 20, 30, or 50. The upper limit of n may be 200, 150, 100, 50, 30, 20, 15, 10, or 6. From the viewpoint of fingerprint removability by wiping, n may be preferably 1 to 30, and more preferably 1 to 10. From the viewpoint of friction durability, n is preferably 50 to 100.

X^{A} is interpreted as a linker connecting the ether moiety (R^{A}) that mainly provides functions and the silane moiety (R^{Si}) that provides an ability to bind to a substrate. Accordingly, X^{A} is not limited as-long as the compound represented by the formula (1A) can stably exist.

X^{A} is each independently a single bond or a di- to decavalent organic group.

The di- to decavalent organic group in X^{A} is preferably a di- to octavalent organic group. In one embodiment, such a di- to decavalent organic group is preferably a di- to tetravalent organic group, and more preferably a divalent organic group. In another embodiment, such a di- to decavalent organic group is preferably a tri- to octavalent organic group, and more preferably a tri- to hexavalent organic group. α1 is each independently an integer of 1 to 9, is preferably 1 in one embodiment, and is an integer of preferably 1 to 6, and more preferably 1 to 4 in another embodiment. β1 is each independently an integer of 1 to 9, is preferably 1 in one embodiment, and is an integer of preferably 2 to 7, and more preferably 2 to 5 in another embodiment.

In one embodiment, X^{A} is a single bond or a divalent organic group, and α1 and β1 are 1.

In one embodiment, X^{A} is a tri- to hexavalent organic group, α1 is 1, and β1 is an integer of 2 to 5.

In one embodiment, X^{A} is a trivalent organic group, α1 is 1, and β1 is 2.

When X^{A} is a single bond or a divalent organic group, the formula (2) is represented by the following formula (2'):
[Formula 23]

**R^{A} - X^{A}- R^{Si}** **(2')**

In one embodiment, X^{A} is a divalent organic group. When X^{A} is a divalent organic group, α1 and β1 are 1 in the formula.

In one embodiment, X^{A} is, for example, a divalent organic group represented by the following formula:

-(R⁸¹)ₚ₅-(X⁸¹)_{q5}-

wherein
R⁸¹ is a single bond, -(CH₂)ₛ₅-, or an o-, m-, or p-phenylene group, and preferably -(CH₂)ₛ₅-,
s5 is an integer of 1 to 30, preferably an integer of 1 to 15, more preferably an integer of 1 to 10, even more preferably an integer of 1 to 6, such as an integer of 1 to 3, or an integer of 1 to 20, preferably an integer of 4 to 15, and more preferably an integer of 7 to 13,
X⁸¹ is -(X⁸²)₁₅-,
X⁸² is each independently a group selected from the group consisting of -O-, -S-, an o-, m-, or p-phenylene group, -CO-, -C(O)O-, -CONR⁸⁴-, -O-CONR⁸⁴-, -NR⁸⁴-, - (CH₂)ₙ₅-, -Si(R⁸⁹)₂-, and -SiO(R⁸⁹)₂-,
R⁸⁴ is each independently a hydrogen atom, or a monovalent organic group, and preferably a hydrogen atom, a phenyl group, a C₁₋₆ alkyl group (preferably a methyl group), or an oxyalkylene-containing group having 1 to 10 carbon atoms,
R⁸⁹ is an alkyl group (preferably an alkyl group having 1 to 10 carbon atoms), or a phenyl group,
n5 is each independently an integer of 1 to 20, preferably an integer of 1 to 15, more preferably an integer of 1 to 10, and even more preferably an integer of 1 to 6, such as an integer of 1 to 3,
l5 is an integer of 1 to 10, preferably an integer of 1 to 5, and more preferably an integer of 1 to 3,
p5 is 0 or 1,
q5 is 0 or 1, and
here, at least one of p5 and q5 is 1, and the occurrence order of the respective repeating units enclosed in parentheses with p5 or q5 is not limited in the formula. Here, X^{A} (typically a hydrogen atom in X^{A}) may be substituted with one or more substituents selected from a fluorine atom, a C₁₋₃ alkyl group, and a C₁₋₃ fluoroalkyl group. In a preferable embodiment, X^{A} is not substituted with these groups.

The oxyalkylene-containing group having 1 to 10 carbon atoms is a group containing -O-C₁₋₁₀ alkylene-, and is, for example, -R⁸⁵-(-O-C₁₋₁₀ alkylene)ₙ-R⁸⁶ (wherein R⁸⁵ is a single bond or a divalent organic group, and preferably a C₁₋₆ alkylene group, n is any integer, and preferably an integer of 2 to 10, and R⁸⁶ is a hydrogen atom or a monovalent organic group, and preferably a C₁₋₆ alkyl group). The alkylene group may be linear or may be branched.

In a preferable embodiment, X^{A} is each independently -(R⁸¹)ₚ₅-(X⁸¹)_{q5}-R⁸²-. R⁸² is a single bond, -(CH₂)t₅-, or an o-, m-, or p-phenylene group, and preferably -(CH₂)ₜ₅-. t5 is an integer of 1 to 30, preferably an integer of 4 to 15, and more preferably an integer of 7 to 13. Here, R⁸² (typically a hydrogen atom in R⁸²) may be substituted with one or more substituents selected from a fluorine atom, a C₁₋₃ alkyl group, and a C₁₋₃ fluoroalkyl group. In a preferable embodiment, R⁸² is not substituted with these groups.

Preferably, X^{A} may be each independently:
a C₁₋₃₀ alkylene group (preferably a linear C₁₋₂₀ alkylene group), or

   -R⁸¹-X⁸³-R⁸²,
wherein R⁸¹ and R⁸² have the same meaning as above, and
X⁸³ is
-O-,
-S-,
-CO-,
-C(O)O-,
-CONR⁸⁴-,
-O-CONR⁸⁴-,
-O-(CH₂)ᵤ₅-CONR⁸⁴-,
-O-(CH₂)ᵤ₅-CO-, or
-CONR⁸⁴-(CH₂)ᵤ₅-N(R⁸⁴) -,
wherein R⁸⁴ has the same meaning as above, and
u5 is an integer of 1 to 20, preferably an integer of 2 to 6, and more preferably an integer of 2 to 3.

More preferably, X^{A} is each independently:
a C₁₋₃₀ alkylene group (preferably a linear C₁₋₂₀ alkylene group),

   -(CH₂)ₛ₅-X⁸³-,

   -X⁸³-(CH₂)t₅-,

   or

   -(CH₂)ₛ₅-X⁸³-(CH₂)ₜ₅-
wherein X⁸³, s5 and t5 have the same meaning as above.

In a preferable embodiment, X^{A} is each independently:
a C₁₋₃₀ alkylene group (preferably a linear C₁₋₃₀ alkylene group),

   -(CH₂)ₛ₅-X⁸³-,

   -X⁸³-(CH₂)t₅-,

   or

   -(CH₂)ₛ₅-X⁸³-(CH₂)ₜ₅-

   -wherein
X⁸³ is -O-, -CO-, -CONR⁸⁴-, -O-CONR⁸⁴-, -O-(CH₂)ᵤ₅-CONR⁸⁴-, or -O-(CH₂)ᵤ₅-CO-,
R⁸⁴ is each independently a hydrogen atom, a phenyl group, a C₁₋₆ alkyl group (preferably a methyl group), or an oxyalkylene-containing group having 1 to 10 carbon atoms, and
s5, t5, and u5 have the same meaning as above.

In a preferable embodiment, X^{A} is each independently:
a C₁₋₃₀ alkylene group (preferably a linear C₁₋₃₀ alkylene group),

   -(CH₂)ₛ₅-O-(CH₂)t₅-,

   -(CH₂)ₛ₅-CONR⁸⁴-(CH₂)t₅-,

   -(CH₂)ₛ₅-O-(CH₂)ᵤ₅-CO-,

   or

   -(CH₂)ₛ₅-O-(CH₂)ᵤ₅-CONR⁸⁴-(CH₂)ₜ₅-

   -wherein
R⁸⁴ is each independently a hydrogen atom, a phenyl group, a C₁₋₆ alkyl group (preferably a methyl group), or an oxyalkylene-containing group having 1 to 10 carbon atoms, and
s5, t5, and u5 have the same meaning as above.

In a preferable embodiment, X^{A} is a C₁₋₃₀ alkylene group, or -(CH₂)ₛ₅-CONH-(CH₂)ₜ₅-.

In one embodiment, X^{A} is a C₁₋₃₀ alkylene group. In such an embodiment, the number of carbon atoms of the alkylene group is, from the viewpoint of friction durability, preferably 7 or more, 10 or more, 11 or more, 18 or more, or 22 or more. From the viewpoint of synthetic accessibility, the number of carbon atoms of the alkylene group is preferably 25 or less, or 20 or less. X^{A} may be, for example, a C₇₋₃₀ alkylene group, a C₁₁₋₃₀ alkylene group, or a C₂₁₋₃₀ alkylene group.

In another embodiment, X^{A} is -(CH₂)ₛ₅-CONH-(CH₂)ₜ₅-.

X^{A} may be each independently substituted with one or more substituents selected from a fluorine atom, a C₁₋₃ alkyl group, and a C₁₋₃ fluoroalkyl group (preferably a C₁₋₃ perfluoroalkyl group). In one embodiment, X^{A} is unsubstituted.

In each formula of X^{A}, the left side binds to R^{A} and the right side binds to R^{Si}.

In one preferable embodiment, X^{A} is a trivalent organic group. When X^{A} is a trivalent organic group, α1 is 2 and β1 is 1, or α1 is 2 and β1 is 2.

The trivalent organic group is preferably a group represented by the following formula: 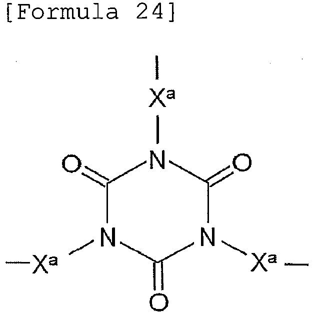 wherein X^{a} has the same meaning as X^{a} in the compound represented by the formula (1).

In a preferrable embodiment, at least one nitrogen atom of X^{A} is bonded to at least one Si atom of R^{Si} via a group composed of other atoms and having a chain length of 1 or more and less than 7. For example, a C₁₋₆ alkylene group is preferably present between at least one nitrogen atom of X^{A} and at least one Si atom of R^{Si}.

Preferably, the compound represented by the formula (2) contains at least one amide bond.

Preferably, it is preferable that the compound represented by the formula (2) does not contain an amino group, and it is more preferable that it does not contain any nitrogen atom other than those in the amide bond.

When the compound represented by the formula (2) contains an amide bond, a N atom derived from the amide bond is present preferably within 15 atoms, more preferably within 10 atoms, and even more preferably within 7 atoms from any silicon atom in R^{Si}.

When the number of nitrogen atoms contained in the compound represented by the formula (2) is denoted by n_{N} and the number of silicon atoms is denoted by n_{Si}, preferably n_{Si} ≥ n_{N}, and more preferably n_{Si} ≥ n_{N} + 3.

The water-repellent layer included in the laminate of the present disclosure may be a cured product of the compound represented by the formula (1), or a mixture of the compound represented by the formula (1) and the compound represented by the formula (2).

The cured product of the compound represented by the formula (1), or the mixture of the compound represented by the formula (1) and the compound represented by the formula (2) may be formed by applying, onto the substrate of the laminate of the present disclosure, the compound represented by the formula (1), the mixture of the compound represented by the formula (1) and the compound represented by the formula (2), or a composition containing the compound or mixture, and subjecting the resultant surface to a heat treatment or the like to cause a dehydrative condensation reaction between the compounds.

The compound represented by the formula (1), the mixture of the compound represented by the formula (1) and the compound represented by the formula (2), or the composition containing the compound or mixture may be a surface-treating agent.

In one embodiment, the surface-treating agent contains at least one compound represented by the formula (1).

In one embodiment, the content of the compound represented by the formula (1) is preferably 0.1 to 50.0% by mass, more preferably 1.0 to 30.0% by mass, even more preferably 5.0 to 25.0% by mass, and particularly preferably 10.0 to 20.0% by mass based on the entirety of the surface-treating agent.

In another embodiment, the content of the compound represented by the formula (1) is preferably 0.001 to 30% by mass, more preferably 0.01 to 10% by mass, even more preferably 0.05 to 5% by mass, and particularly preferably 0.05 to 2% by mass based on the entirety of the surface-treating agent.

In one embodiment, the surface-treating agent contains a mixture of at least one compound represented by the formula (1) and at least one compound represented by the formula (2).

In one embodiment, the content of the mixture may be preferably 0.1 to 50.0% by mass, more preferably 1.0 to 30.0% by mass, even more preferably 5.0 to 25.0% by mass, and particularly preferably 10.0 to 20.0% by mass based on the entirety of the surface-treating agent.

In another embodiment, the content of the mixture is preferably 0.001 to 30% by mass, more preferably 0.01 to 10% by mass, even more preferably 0.05 to 5% by mass, and particularly preferably 0.05 to 2% by mass based on the entirety of the surface-treating agent.

In one embodiment, the surface-treating agent contains a compound represented by the formula (1) or (2), and at least one of condensates in which at least a part of the compounds is condensed.

In the above embodiment, the content of the condensate may be preferably 40% by mass or less and more preferably 30% by mass or less based on the sum of the compound represented by the formula (1) or (2) and the condensate. Here, the content of the condensate can be determined from, for example, the abundance ratio of the peak position to the area in GPC (gel permeation chromatography).

The surface-treating agent may contain a solvent, a (non-reactive) silicone compound that may be understood as a silicone oil (hereinafter, referred to as "silicone oil"), an alcohol, a catalyst, a surfactant, a polymerization inhibitor, a sensitizer, and the like.

In one embodiment, the surface-treating agent may contain a solvent selected from the compounds represented by R⁷¹OR⁷², R⁷³ₙ₈C₆H₆₋ₙ₈, R⁷⁴R⁷⁵R⁷⁶Si-(O-SiR⁷⁷R⁷⁸)ₘ₈-R⁷⁹, and (OSiR⁷⁷R⁷⁸)ₘ₉,
wherein
R⁷¹ to R⁷⁹ are each independently a monovalent organic group having 1 to 10 carbon atoms,
m8 is an integer of 1 to 6,
m9 is an integer of 3 to 8, and
n8 is an integer of 0 to 6.

The monovalent organic group having 1 to 10 carbon atoms may be linear or branched, and may further contain a cyclic structure.

In one embodiment, the monovalent organic group having 1 to 10 carbon atoms may contain an oxygen atom, a nitrogen atom, or a halogen atom.

In another embodiment, the monovalent organic group having 1 to 10 carbon atoms does not contain a halogen atom.

In a preferable embodiment, the monovalent organic group having 1 to 10 carbon atoms is a hydrocarbon group optionally substituted with a halogen, and preferably a hydrocarbon group not substituted with a halogen.

In one embodiment, the hydrocarbon group is linear.

In another embodiment, the hydrocarbon group is branched.

In another embodiment, the hydrocarbon group contains a cyclic structure.

In one embodiment, the solvent is R⁷¹OR⁷².

R⁷¹ and R⁷² may be, each independently, preferably a hydrocarbon group having 1 to 8 carbon atoms, and more preferably a C₁₋₆ alkyl group or a C₅₋₈ cycloalkyl group.

In one embodiment, the solvent is R⁷³ₙ₈O₆H₆₋ₙ₈.

C₆H₆₋ₙ₈ is an n8-valent benzene ring. That is to say, R⁷³ₙ₈C₆H₆₋ₙ₈ is benzene substituted with n8 R⁷³.

R⁷³ may be each independently a halogen, or a C₁₋₆ alkyl group optionally substituted with a halogen.

n8 is preferably an integer of 1 to 3.

In one embodiment, the solvent is R⁷⁴R⁷⁵R⁷⁶Si-(O-SiR⁷⁷R⁷⁸)ₘ₈-R⁷⁹.

In one embodiment, the solvent is (OSiR⁷⁷R⁷⁸)ₘ₉. (OSiR⁷⁷R⁷⁸)ₘ₉ is a cyclic siloxane formed of multiple OSiR⁷⁷R⁷⁸ units bonded in a cyclic form.

R⁷⁴ to R⁷⁹ are each independently a hydrogen atom or a C₁₋₆ alkyl group, preferably a C₁₋₆ alkyl group, more preferably a C₁₋₃ alkyl group, and even more preferably a methyl group.

m8 is preferably an integer of 1 to 6, more preferably an integer of 1 to 5, and even more preferably 1 to 2.

m9 is preferably an integer of 3 to 6, and more preferably an integer of 3 to 5.

In one embodiment, examples of the solvent include aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, iso-propanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide, N,N-dimethylacetamide, and N-methylpyrrolidone; ether alcohols such as methyl cellosolve, cellosolve, isopropyl cellosolve, butyl cellosolve, and diethylene glycol monomethyl ether; diethylene glycol monoethyl ether acetate; polyfluoroaromatic hydrocarbons (for example, 1,3-bis(trifluoromethyl)benzene); polyfluoroaliphatic hydrocarbons (for example, C₆F₁₃CH₂CH₃ (for example, ASAHIKLIN(R) AC-6000 manufactured by AGC Inc.), C₆F₁₃H (for example, ASAHIKLIN(R) AC-2000 manufactured by AGC Inc.), and 1,1,2,2,3,3,4-heptafluorocyclopentane (for example, Zeorolla(R) H manufactured by ZEON Corporation); fluorine-containing hydrocarbons such as 1,1,2-trichloro-1,2,2-trifluoroethane, 1,2-dichloro-1,1,2,2-tetrafluoroethane, 1,1-dichloro-1,2,2,3,3-pentafluoropropane (HCFC 225), and 1,3-bis(trifluoromethyl)benzene; fluorine-containing alcohols such as CF₃CH₂OH, CF₃CF₂CH₂OH, and (CF₃)₂CHOH; alkyl perfluoroalkyl ethers (the perfluoroalkyl group and the alkyl group may be linear or branched) such as hydrofluoroethers (HFE) (for example, perfluoropropyl methyl ether (C₃F₇OCH₃) (for example, Novec(TM) 7000 manufactured by SUMITOMO 3M), perfluorobutyl methyl ether (C₄F₉OCH₃) (for example, Novec(TM) 7100 manufactured by SUMITOMO 3M), perfluorobutyl ethyl ether (C₄F₉OC₂H₅) (for example, Novec(TM) 7200 manufactured by SUMITOMO 3M), and perfluorohexyl methyl ether (C₂F₅CF(OCH₃)C₃F₇) (for example, Novec(TM) 7300 manufactured by SUMITOMO 3M), or CF₃CH₂OCF₂CHF₂ (for example, ASAHIKLIN(R) AE-3000 manufactured by AGC Inc.)), hydrofluoroolefins; ethers such as CF₃CH=CHCl (for example, CELEFIN(R) 1233Z manufactured by Central Glass Co., Ltd.), CHF₂CF=CHCl (for example, AMOLEA(R) AS-300 manufactured by AGC Inc.), and cyclopentyl methyl ether; siloxanes such as hexamethyldisiloxane, hexaethyldisiloxane, octamethyltrisiloxane, octamethylcyclotetrasiloxane, octamethylcyclopentasiloxane, decamethylcyclopentasiloxane, decamethyltetrasiloxane, dodecamethylpentasiloxane, and tetradecamethylhexasiloxane; and dimethylsulfoxide. Alternatively, the solvent may be a mixed solvent of two or more of such solvents. In particular, preferred are aliphatic hydrocarbons, aromatic hydrocarbons, esters, glycol ethers, alcohols, ether alcohols, and siloxanes. For example, preferred are hexane, cyclohexane, heptane, octane, nonane, decane, undecane, dodecane, mineral spirits, benzene, toluene, xylene, naphthalene, methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, ethyl 2-hydroxyisobutyrate, propylene glycol monomethyl ether, propylene glycol monoethyl ether, propylene glycol monobutyl ether, methanol, ethanol, iso-propanol, n-butanol, isobutanol, tert-butanol, sec-butanol, diethylene glycol monomethyl ether, hexamethyldisiloxane, hexaethyldisiloxane, octamethyltrisiloxane, decamethyltetrasiloxane, dodecamethylpentasiloxane, tetradecamethylhexasiloxane, octamethylcyclotetrasiloxane, and octamethylcyclopentasiloxane.

Examples of the silicone oil include, but are not limited to, compounds represented by the following general formula (3a):

R^{1a}-(SiR^{3a}₂-O)ₐ₁-SiR^{3a}₂-R^{1a} (3a)

wherein
R^{1a} is each independently a hydrogen atom or a hydrocarbon group,
R^{3a} is each independently a hydrogen atom or a hydrocarbon group, and
a1 is 2 to 3,000.

R^{3a} is each independently a hydrogen atom or a hydrocarbon group. Such a hydrocarbon group may be substituted.

R^{3a} is, each independently, preferably an unsubstituted hydrocarbon group or a hydrocarbon group substituted with a halogen atom. Such a halogen atom is preferably a fluorine atom.

R^{3a} is, each independently, preferably a C₁₋₆ alkyl group or an aryl group optionally substituted with a halogen atom, and more preferably a C₁₋₆ alkyl group or an aryl group.

The C₁₋₆ alkyl group may be linear or may be branched, and is preferably linear.
The C₁₋₆ alkyl group is preferably a C₁₋₃ alkyl group, and more preferably a methyl group.

The aryl group is preferably a phenyl group.

In one embodiment, R^{3a} is each independently a C₁₋₆ alkyl group, preferably a C₁₋₃ alkyl group, and more preferably a methyl group.

In another embodiment, R^{3a} is a phenyl group.

In another embodiment, R^{3a} is a methyl group or a phenyl group, and preferably a methyl group.

R^{1a} is each independently a hydrogen atom or a hydrocarbon group, and has the same meanings as those described for R^{3a}.

R^{1a} is, each independently, preferably a C₁₋₆ alkyl group or an aryl group optionally substituted with a halogen atom, and more preferably a C₁₋₆ alkyl group or an aryl group.

In one embodiment, R^{1a} is each independently a C₁₋₆ alkyl group, preferably a C₁₋₃ alkyl group, and more preferably a methyl group.

In another embodiment, R^{1a} is a phenyl group.

In another embodiment, R^{1a} is a methyl group or a phenyl group, and preferably a methyl group.

a1 is 2 to 1,500. a1 may be preferably 5 or more, more preferably 10 or more, and even more preferably 15 or more, such as 30 or more or 50 or more. a1 may be preferably 1,000 or less, more preferably 500 or less, even more preferably 200 or less, and yet more preferably 150 or less, such as 100 or less or 80 or less.

a1 may be preferably 5 to 1,000, more preferably 10 to 500, even more preferably 15 to 200, and yet more preferably 15 to 150.

Other examples of the silicone oil include compounds represented by (3b) below:

R^{1a}-R^{S2}-R^{3a} (3b)

wherein
R^{1a} is each independently a hydrocarbon group,
R^{3a} is each independently a hydrocarbon group, and
R^{S2} has the same meanings as those described for the formula (2).

The silicone oil may have an average molecular weight of 500 to 1,000,000, and preferably 1,000 to 100,000. The molecular weight of the silicone oil may be measured using GPC.

The silicone oil may be, for example, a linear or cyclic silicone oil in which a1 in -(SiR^{3a}₂-O)ₐ₁- is 30 or less. The linear silicone oil may be a so-called straight silicone oil or modified silicone oil. Examples of the straight silicone oil include dimethyl silicone oil, methyl phenyl silicone oil, and methyl hydrogen silicone oil. Examples of the modified silicone oil include those obtained by modifying a straight silicone oil with alkyl, aralkyl, polyether, higher fatty acid ester, fluoroalkyl, epoxy, carboxyl, alcohol, or the like. The cyclic silicone oil may be, for example, cyclic dimethylsiloxane oil.

The silicone oil may be contained in an amount of, for example, 0 to 50% by mass, preferably 0.001 to 30% by mass, and more preferably 0.1 to 5% by mass, based on the surface-treating agent.

In the surface-treating agent, such a silicone oil may be contained in an amount of, for example, 0 to 300 parts by mass, preferably 0 to 100 parts by mass, more preferably 0 to 50 parts by mass, and even more preferably 0 to 10 parts by mass, based on total 100 parts by mass of the compound represented by the formula (1) (in the case of using two or more compounds, the total thereof, which also applies below), or total 100 parts by mass of the mixture of the compound represented by the formula (1) and the compound represented by the formula (2).

The silicone oil contributes to increasing the surface lubricity of the water-repellent layer.

Examples of the alcohol include methanol, ethanol, iso-propanol, n-butanol, isobutanol, tert-butanol, sec-butanol, 3-pentanol, octyl alcohol, 3-methyl-3-methoxybutanol, and tert-amyl alcohol. Such an alcohol added to the surface-treating agent improves the stability of the surface-treating agent.

Examples of the catalyst include acids (for example, acetic acid, hydrochloric acid, nitric acid, sulfuric acid, phosphoric acid, sulfonic acid, p-toluenesulfonic acid, trifluoroacetic acid, and the like), bases (for example, sodium hydroxide, potassium hydroxide, ammonia, triethylamine, diethylamine, and the like), transition metals (for example, Ti, Ni, Sn, Zr, Al, B, Si, Ta, Nb, Mo, W, Cr, Hf, V, and the like), and sulfur-containing compounds or nitrogen-containing compounds having an unshared electron pair in the molecular structure (for example, sulfoxide compounds, aliphatic amine compounds, aromatic amine compounds, phosphoric acid amide compounds, amide compounds, and urea compounds).

Examples of the aliphatic amine compound include diethylamine and triethylamine. Examples of the aromatic amine compound include aniline and pyridine.

In a preferable embodiment, the transition metal is contained as a transition metal compound represented by M-R, wherein M is a transition metal atom and R is a hydrolyzable group. By using a compound obtained by bonding a transition metal and a hydrolyzable group as the transition metal compound, the transition metal atom can be contained in the water-repellent layer more efficiently, and the abrasion durability and the chemical resistance of the water-repellent layer can be more increased.

The hydrolyzable group means a group that can undergo a hydrolysis reaction in the same manner as the hydrolyzable group concerning the compound represented by the formula (1) or (2), i.e., means a group that can be removed from the transition metal atom by a hydrolysis reaction. Examples of the hydrolyzable group include - OR^{m}, -OCOR^{m}, -O-N=CR^{m}₂, -NR^{m}₂, -NHR^{m}, -NCO, or a halogen (in these formulae, R^{m} represents a substituted or unsubstituted C₁₋₄ alkyl group).

In a preferable embodiment, the hydrolyzable group is -OR^{m}, and preferably methoxy or ethoxy. By using an alkoxy group as the hydrolyzable group, the transition metal atom can be contained in the water-repellent layer more efficiently, and the abrasion durability and the chemical resistance of the water-repellent layer can be more increased.

In one embodiment, the hydrolyzable group may be the same as the hydrolyzable group contained in the compound represented by the formula (1) or (2). By causing the hydrolyzable groups in the silane compound and in the transition metal compound to be the same group, the influence of such hydrolyzable groups being mutually exchanged, if ever, can be minimized.

In another embodiment, the hydrolyzable group may be different from the hydrolyzable group contained in the compound represented by the formula (1) or (2). By causing the hydrolyzable groups in the silane compound and in the transition metal compound to be different, the reactivity of hydrolysis can be controlled.

In one embodiment, the above hydrolyzable group and the hydrolyzable group contained in the compound represented by the formula (1) or (2) may be mutually exchanged in the surface-treating agent.

In a preferable embodiment, the transition metal compound may be Ta(OR^{m})₅ (wherein R^{m} is a substituted or unsubstituted C₁₋₄ alkyl group), preferably Ta (OCH₂CH₃)₅ or Si(OR^{m})₁₋ₘ₁R^{m'}ₘ₁ (wherein R^{m} is a substituted or unsubstituted C₁₋₄ alkyl group, R^{m'} is a C₁₋₄ alkyl group, and m1 is 0 or 1), and preferably tetraethoxysilane, methyltrimethoxysilane, methyltriethoxysilane, tetraisopropoxysilane, dimethyldiethoxysilane, or dimethyldimethoxysilane.

The catalyst may be contained in an amount of, for example, 0.0002% by mass or more based on the entirety of the surface-treating agent. The catalyst may be contained in an amount of preferably 0.02% by mass or more, and more preferably 0.04% by mass or more, based on the entirety of the surface-treating agent. The catalyst may be contained in an amount of, for example, 10% by mass or less based on the entirety of the surface-treating agent and, in particular, is contained in an amount of 1% by mass or less. The surface-treating agent can contribute to the formation of a water-repellent layer having better durability when the catalyst is contained in the concentration as described above.

The content of the catalyst is preferably 0 to 10% by mass, more preferably 0 to 5% by mass, and particularly preferably 0 to 1% by mass, based on the compound represented by the formula (1) or the mixture of the compound represented by the formula (1) and the compound represented by the formula (2).

The catalyst promotes hydrolysis and dehydrative condensation of the compound represented by the formula (1) or (2), and promotes formation of a layer formed of the surface-treating agent.

Examples of other components include, in addition to those described above, tetraethoxysilane, methyltrimethoxysilane, 3-aminopropyltrimethoxysilane, 3-glycidoxypropyltrimethoxysilane, and methyltriacetoxysilane.

The surface-treating agent may contain, in addition to the components described above, trace amounts of Pt, Rh, Ru, 1,3-divinyltetramethyldisiloxane, triphenylphosphine, NaCl, KCl, silane condensates, and the like as impurities.

In one embodiment, the surface-treating agent is for a dry coating method, and preferably for vacuum deposition.

In one embodiment, the surface-treating agent is for a wet coating method, and preferably for dip coating.

The surface-treating agent can be formed into pellets by impregnating a porous material such as a porous ceramic material or a metal fiber such as a fiber obtained by, for example, solidifying steel wool in a cotton-like form with composition. Such pellets can be used in, for example, vacuum deposition.

The water-repellent layer may further have, depending on the compositional features of the compounds contained, water-repellency, oil-repellency, antifouling properties, waterproof properties (preventing water from entering electronic components and the like), surface lubricity (or lubricity, for example, excellent tactile sensations to the fingers), chemical resistance, and the like. Besides, the water-repellent layer included in the laminate of the present disclosure may have both high friction durability and fingerprint removability by wiping. For example, properties such as water repellency, oil repellency, and surface lubricity of the water-repellent layer can be maintained at a high rate even after the layer is abraded a predetermined number of times compared to the properties before abrasion.

The water contact angle of the water-repellent layer may be, for example, 95° or more, or furthermore 100° or more, preferably 103° or more, more preferably 106° or more, and even more preferably 110° or more, and may be, for example, 140° or less, or furthermore 125° or less.

The water contact angle and contact angles using other liquids can be measured by the method described herein in Examples.

The thickness of the water-repellent layer is not limited, and may be preferably 15 nm or less, such as 1 to 15 nm, 1 to 13 nm, or 1 to 10 nm.

The laminate of the present disclosure can be produced by applying, on the surface of a substrate (for example, glass), a surface-treating agent containing a compound represented by the formula (1), or a mixture of the compound represented by the formula (1) and a compound represented by the formula (2), and post-treating the resultant as necessary to form a layer of a cured product of the compound or the mixture (namely, a water-repellent layer).

The water-repellent layer can be formed by applying the surface-treating agent to the surface of the substrate so as to coat the surface. The coating method is not limited. For example, a wet coating method and a dry coating method can be used.

Examples of the wet coating method include dip coating, spin coating, flow coating, spray coating, roll coating, gravure coating, wipe coating, squeegee coat method, die coat, inkjet, cast method, Langmuir-Blodgett method, and similar methods.

Examples of the dry coating method include deposition (usually, vacuum deposition), sputtering, CVD, and similar methods. Specific examples of the deposition method (usually, a vacuum deposition method) include resistive heating, high-frequency heating using electron beam, microwave, or the like, ion beam, and similar methods. Specific examples of the CVD method include plasma-CVD, optical CVD, thermal CVD, and similar methods.

Furthermore, coating by an atmospheric pressure plasma method can be performed.

When using the wet coating method, the surface-treating agent of the present disclosure can be applied to the substrate surface after being diluted with a solvent. From the viewpoint of the stability of the composition of the present disclosure and the volatility of the solvent, the following solvents are preferably used: aliphatic hydrocarbons such as hexane, cyclohexane, heptane, octane, nonane, decane, undecane, dodecane, and mineral spirits; aromatic hydrocarbons such as benzene, toluene, xylene, naphthalene, and solvent naphtha; esters such as methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, and ethyl 2-hydroxyisobutyrate; ketones such as acetone, methyl ethyl ketone, methyl isobutyl ketone, 2-hexanone, cyclohexanone, methyl amino ketone, and 2-heptanone; glycol ethers such as ethyl cellosolve, methyl cellosolve, methyl cellosolve acetate, ethyl cellosolve acetate, propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether, and ethylene glycol monoalkyl ether; alcohols such as methanol, ethanol, iso-propanol, n-butanol, isobutanol, tert-butanol, sec-butanol, 3-pentanol, octyl alcohol, 3-methyl-3-methoxybutanol, and tert-amyl alcohol; glycols such as ethylene glycol and propylene glycol; cyclic ethers such as tetrahydrofuran, tetrahydropyran, and dioxane; amides such as N,N-dimethylformamide, N,N-dimethylacetamide, and N-methylpyrrolidone; ether alcohols such as methyl cellosolve, cellosolve, isopropyl cellosolve, butyl cellosolve, and diethylene glycol monomethyl ether; diethylene glycol monoethyl ether acetate; polyfluoroaromatic hydrocarbons (for example, 1,3-bis(trifluoromethyl)benzene); polyfluoroaliphatic hydrocarbons (for example, C₆F₁₃CH₂CH₃ (for example, ASAHIKLIN(R) AC-6000 manufactured by AGC Inc.), C₆F₁₃H (for example, ASAHIKLIN(R) AC-2000 manufactured by AGC Inc.), and 1,1,2,2,3,3,4-heptafluorocyclopentane (for example, Zeorolla(R) H manufactured by ZEON Corporation); fluorine-containing hydrocarbons such as 1,1,2-trichloro-1,2,2-trifluoroethane, 1,2-dichloro-1,1,2,2-tetrafluoroethane, 1,1-dichloro-1,2,2,3,3-pentafluoropropane (HCFC 225), and 1,3-bis(trifluoromethyl)benzene; fluorine-containing alcohols such as CF₃CH₂OH, CF₃CF₂CH₂OH, and (CF₃)₂CHOH; alkyl perfluoroalkyl ethers (the perfluoroalkyl group and the alkyl group may be linear or branched) such as hydrofluoroethers (HFE) (for example, perfluoropropyl methyl ether (C₃F₇OCH₃) (for example, Novec(TM) 7000 manufactured by SUMITOMO 3M), perfluorobutyl methyl ether (C₄F₉OCH₃) (for example, Novec (TM) 7100 manufactured by SUMITOMO 3M), perfluorobutyl ethyl ether (C₄F₉OC₂H₅) (for example, Novec(TM) 7200 manufactured by SUMITOMO 3M), and perfluorohexyl methyl ether (C₂F₅CF(OCH₃)C₃F₇) (for example, Novec(TM) 7300 manufactured by SUMITOMO 3M), or CF₃CH₂OCF₂CHF₂ (for example, ASAHIKLIN(R) AE-3000 manufactured by AGC Inc.)), hydrofluoroolefins; ethers such as CF₃CH=CHCl (for example, CELEFIN(R) 1233Z manufactured by Central Glass Co., Ltd.), CHF₂CF=CHCl (for example, AMOLEA(R) AS-300 manufactured by AGC Inc.), and cyclopentyl methyl ether; siloxanes such as hexamethyldisiloxane, hexaethyldisiloxane, octamethyltrisiloxane, octamethylcyclotetrasiloxane, octamethylcyclopentasiloxane, decamethylcyclopentasiloxane, decamethyltetrasiloxane, dodecamethylpentasiloxane, and tetradecamethylhexasiloxane; and dimethylsulfoxide. Alternatively, the solvent may be a mixed solvent of two or more of such solvents. In particular, preferred are aliphatic hydrocarbons, aromatic hydrocarbons, esters, glycol ethers, alcohols, ether alcohols, and siloxanes. For example, preferred are hexane, cyclohexane, heptane, octane, nonane, decane, undecane, dodecane, mineral spirits, benzene, toluene, xylene, naphthalene, methyl acetate, ethyl acetate, propyl acetate, n-butyl acetate, isopropyl acetate, isobutyl acetate, cellosolve acetate, propylene glycol methyl ether acetate, carbitol acetate, diethyl oxalate, ethyl pyruvate, ethyl 2-hydroxybutyrate, ethyl acetoacetate, amyl acetate, methyl lactate, ethyl lactate, methyl 3-methoxypropionate, ethyl 3-methoxypropionate, methyl 2-hydroxyisobutyrate, ethyl 2-hydroxyisobutyrate, propylene glycol monomethyl ether, propylene glycol monoethyl ether, propylene glycol monobutyl ether, methanol, ethanol, iso-propanol, n-butanol, isobutanol, tert-butanol, sec-butanol, diethylene glycol monomethyl ether, hexamethyldisiloxane, hexaethyldisiloxane, octamethyltrisiloxane, decamethyltetrasiloxane, dodecamethylpentasiloxane, tetradecamethylhexasiloxane, octamethylcyclotetrasiloxane, and octamethylcyclopentasiloxane.

When using the dry coating method, the surface-treating agent may be directly subjected to the dry coating method, or may be diluted with the solvent before being subjected to the dry coating method.

A water-repellent layer is preferably formed such that the surface-treating agent coexists in the layer with a catalyst for hydrolysis and dehydrative condensation. Conveniently, in the case of a wet coating method, the surface-treating agent is diluted with a solvent, and then, immediately before application to the substrate surface, a catalyst may be added to the diluted solution of the surface-treating agent. In the case of a dry coating method, the surface-treating agent to which a catalyst has been added is directly used in a deposition (usually vacuum deposition) treatment, or a pellet-like material may be used in a deposition (usually vacuum deposition) treatment, wherein pellets are obtained by impregnating a porous body of metal such as iron or copper with the surface-treating agent to which the catalyst has been added.

The catalyst may be any suitableacid or base, transition metal (such as Ti, Ni, Sn, Zr, Al, or B), sulfur-containing compound or nitrogen-containing compound having an unshared electron pair in the molecular structure (such as a sulfoxide compound, an aliphatic amine compound, an aromatic amine compound, a phosphoric acid amide compound, an amide compound, or an urea compound), or the like. The acid catalyst may be, for example, acetic acid, formic acid, trifluoroacetic acid, hydrochloric acid, nitric acid, sulfuric acid, phosphoric acid, sulfonic acid, methanesulfonic acid, or p-toluenesulfonic acid. Also, the base catalyst may be, for example, ammonia, sodium hydroxide, potassium hydroxide, or an organic amine such as triethylamine or diethylamine. Examples of the transition metal, the aliphatic amine compound, and the aromatic amine compound include those described above.

Below, the article of the present disclosure will now be described.

An article of the present disclosure includes the above-described laminate.

In one embodiment, the article of the present disclosure may include a silicon oxide-containing intermediate layer between glass and the water-repellent layer. By providing such an intermediate layer, adhesion between glass and the water-repellent layer is increased, and durability is increased.

In a preferable embodiment, the intermediate layer may contain an alkali metal atom in addition to silicon oxide.

Examples of the alkali metal atom include lithium, sodium, and potassium. The alkali metal atom is preferably sodium.

The thickness of the intermediate layer is not limited, and is preferably 1 to 200 nm and particularly preferably 1 to 20 nm. By causing the thickness of the intermediate layer to be at the lower limit of the above range or greater, the effect of increasing adhesion provided by the intermediate layer is more increased.

The concentration of alkali metal atoms in the intermediate layer can be measured by various surface analysis apparatuses such as TOF-SIMS, XPS, and XRF.

The proportion of alkali metal atoms to all atoms in the entirety of the intermediate layer can be obtained by XPS depth profile analysis using ion sputtering, wherein measurement by XPS and surface etching by ion sputtering using an ion gun provided in an XPS apparatus are alternately performed.

In the intermediate layer, the average alkali metal concentration in a region having a depth of 1 nm or less from the surface that is in contact with the water-repellent layer is determined by obtaining a depth profile of the alkali metal atom concentration by TOF-SIMS (time-of-flight secondary ion mass spectrometry) depth analysis using ion sputtering, and then calculating the average alkali metal atom concentration in the profile. TOF-SIMS depth profile analysis by ion sputtering is performed by alternately repeating measurement by TOF-SIMS and surface etching by ion sputtering using an ion gun provided in a TOF-SIMS apparatus.

The article of the present disclosure may be, but is not limited to, an optical member. Examples of the optical member include lenses of glasses or the like; front surface protective plates, antireflection plates, polarizing plates, and anti-glare plates for displays such as PDPs and LCDs; touch panel sheets for equipment such as cell phones and portable information terminals; disc surfaces of optical discs such as Blu-ray(R) discs, DVD discs, CD-Rs, and MOs; optical fibers; and display surfaces of watches and clocks.

The article of the present disclosure may be medical equipment or a medical material. The article having a water-repellent layer that is obtained according to the present disclosure may be an automobile interior or exterior member. Examples of the exterior material are as follows: windows, light covers, and external camera covers. Examples of the interior material are as follows: instrument panel covers, navigation system touch panels, and decorative interior materials.

The silicon oxide-containing intermediate layer described above can be formed by applying a silicon oxide precursor to the substrate surface. When the intermediate layer contains an alkali metal atom, the intermediate layer can be formed by applying a composition containing a silicon oxide precursor and an alkali metal source to the substrate surface.

Examples of the silicon oxide precursor include silicic acid, a partial condensate of silicic acid, an alkali metal silicate, a silane compound having a hydrolyzable group that is bonded to a silicon atom, and a partially hydrolyzed condensate of such a silane compound. Silicic acid and a partial condensate thereof can be converted to silicon oxide by dehydrative condensation, and an alkali metal silicate can be converted to silicon oxide by being converted first to silicic acid or a partial condensate thereof with an acid or a cation exchange resin and then dehydratively condensing the resulting silicic acid or partial condensate thereof. Examples of the hydrolyzable group in the silane compound having a hydrolyzable group that is bonded to a silicon atom include an alkoxy group and a chlorine atom. The hydrolyzable group of the silane compound can be hydrolyzed to give a hydroxyl group, and the resulting silanol compound can be dehydratively condensed to give silicon oxide. Examples of the silane compound having a hydrolyzable group that is bonded to a silicon atom include alkoxysilanes such as tetraalkoxysilane and alkyltrialkoxysilane, and tetrachlorosilane.

The alkali metal source includes alkali metal hydroxides, water-soluble alkali metal salts, and the like. Examples of the water-soluble alkali metal salts include alkali metal carbonates, alkali metal hydrogen carbonates, alkali metal hydrochlorides, and alkali metal nitrates. The alkali metal source is preferably an alkali metal hydroxide and an alkali metal carbonate.

Note that the alkali metal silicate can be used as a silicon oxide precursor and an alkali metal source. The alkali metal silicate can be converted to silicon oxide via silicic acid, and in this process, a small amount of alkali metal may remain in the produced silicon oxide. Accordingly, regulating the amount of the remaining alkali metal enables silicon oxide containing a predetermined amount of alkali metal atoms to be obtained.

The water-repellent layer contained in the article of the present disclosure may have high abrasion durability as described above. Moreover, the water-repellent layer may have not only high abrasion durability but also have, depending on the composition of the surface-treating agent used, water-repellency, oil-repellency, antifouling properties (e.g., preventing grime such as fingerprints from adhering), waterproof properties (preventing water from entering electronic components and the like), surface lubricity (or lubricity, for example, such as removability by wiping of grime such as fingerprints, and excellent tactile sensations to the fingers), chemical resistance, and the like, and may be suitably used as a functional thin film.

Accordingly, the present disclosure further relates to an optical material having the water-repellent layer as the outermost layer.

The optical material preferably includes a wide variety of optical materials, in addition to optical materials relating to displays and the like as exemplified below: for example, displays such as cathode ray tubes (CRTs; for example, PC monitors), liquid crystal displays, plasma displays, organic EL displays, inorganic thin-film EL dot matrix displays, rear projection displays, vacuum fluorescent displays (VFDs), field emission displays (FEDs); protective plates for such displays; and those obtained by performing an antireflection film treatment on their surfaces.

The article of the present disclosure may be, but is not limited to, an optical member. Examples of the optical member include lenses of glasses or the like; front surface protective plates, antireflection plates, polarizing plates, and anti-glare plates for displays such as PDPs and LCDs; touch panel sheets for equipment such as cell phones and portable information terminals; disc surfaces of optical discs such as Blu-ray(R) discs, DVD discs, CD-Rs, and MOs; optical fibers; and display surfaces of watches and clocks.

The article of the present disclosure may be medical equipment or a medical material. The article having a layer that is obtained according to the present disclosure may be an automobile interior or exterior member. Examples of the exterior material are as follows: windows, light covers, and external camera covers. Examples of the interior material are as follows: instrument panel covers, navigation system touch panels, and decorative interior materials.

The thickness of the layer is not limited. The thickness of the layer in the case of an optical member may be in the range of, for example, 1 to 50 nm, preferably 1 to 30 nm, and more preferably 1 to 15 nm, from the viewpoint of optical performance, abrasion durability, and antifouling properties.

The apparatus for performing X-ray photoelectron spectroscopy for measuring the atomic composition and the ratio of constitutional atoms of the water-repellent layer may be XPS or PHI 5000 VersaProbe II manufactured by ULVAC-PHI, Inc. Usable measurement conditions for XPS analysis may be an X-ray source of 25 W monochromatic AlKα radiation, a photoelectron detection surface of 1,400 µm × 300 µm, a photoelectron detection angle in a range of 20° to 90° (for example, 20°, 45°, 90°), a pass energy of 23.5 eV, and sputtering with a gas cluster ion beam or Ar ions. The compositions of the water-repellent layer and the intermediate layer can be determined by observing the peak areas of F1s, C1s, O1s, and Si2p under the above apparatus and measurement conditions, and calculating the atomic ratio of fluorine, carbon, oxygen, and silicon.

Also, depth profile analysis may be performed as well. Usable measurement conditions for XPS analysis may be an X-ray source of 25 W monochromatic AlKα radiation, a photoelectron detection surface of 1,400 µm × 300 µm, a photoelectron detection angle in a range of 20° to 90° (for example, 20°, 45°, 90°), a pass energy of 23.5 eV, and Ar ions, gas cluster ions, C60 ions, or the like as sputtering ions. Etching may be performed to 1 to 100 nm by sputtering, and the composition in the coating film at each etching depth may be obtained as well.

By adjusting the photoelectron detection angle of the XPS analysis, the detection depth can be suitably adjusted. For example, a shallow angle close to 20 degrees allows a detection depth of about 3 nm, while a deep angle close to 90 degrees allows a detection depth of about 10 nm.

The silicon oxide-containing intermediate layer described above can be formed by applying a silicon oxide precursor to the substrate surface. When the intermediate layer contains an alkali metal, the intermediate layer can be formed by applying a composition containing a silicon oxide precursor and an alkali metal source to the substrate surface.

Examples of the silicon oxide precursor include silicic acid, a partial condensate of silicic acid, an alkali metal silicate, a silane compound having a hydrolyzable group that is bonded to a silicon atom, and a partially hydrolyzed condensate of such a silane compound. Silicic acid and a partial condensate thereof can be converted to silicon oxide by dehydrative condensation, and an alkali metal silicate can be converted to silicon oxide by being converted first to silicic acid or a partial condensate thereof with an acid or a cation exchange resin and then dehydratively condensing the resulting silicic acid or partial condensate thereof. Examples of the hydrolyzable group in the silane compound having a hydrolyzable group that is bonded to a silicon atom include an alkoxy group and a chlorine atom. The hydrolyzable group of the silane compound can be hydrolyzed to give a hydroxyl group, and the resulting silanol compound can be dehydratively condensed to give silicon oxide. Examples of the silane compound having a hydrolyzable group that is bonded to a silicon atom include alkoxysilanes such as tetraalkoxysilane and alkyltrialkoxysilane, and tetrachlorosilane.

The alkali metal source includes alkali metal hydroxides, water-soluble alkali metal salts, and the like. Examples of the water-soluble alkali metal salts include alkali metal carbonates, alkali metal hydrogen carbonates, alkali metal hydrochlorides, and alkali metal nitrates. The alkali metal source is preferably an alkali metal hydroxide and an alkali metal carbonate.

Note that the alkali metal silicate can be used as a silicon oxide precursor and an alkali metal source. The alkali metal silicate can be converted to silicon oxide via silicic acid, and in this process, a small amount of alkali metal may remain in the produced silicon oxide. Accordingly, regulating the amount of the remaining alkali metal enables silicon oxide containing a predetermined amount of alkali metal atoms to be obtained.

The thickness of the intermediate layer is not limited, and is in the range of, for example, 1 to 50 nm, preferably 1 to 30 nm, more preferably 2 to 15 nm, and even more preferably 3 to 10 nm.

So far, the compound, the composition, and the article of the present disclosure have been described in detail. The compound, the composition, the article, and the like of the present disclosure are not limited to those exemplified above.

The present invention will now be more specifically described by way of the following Examples, but the present invention is not limited to these Examples.

In the following Examples, the number n of siloxane repeating units was calculated by ¹H-NMR.

### (Synthetic Example 1)

After mixing 5.0 g of CH₃CH₂CH₂CH₂Si(CH₃)₂O(Si(CH₃)₂O)ₙSi(CH₃)₂CH₂CH₂CH₂OCH₂COOH, 92 mg of 2-propen-1-amine, 31 mg of 1-(3-dimethylaminopropyl)-3-ethylcarbodiimide hydrochloride, 13 mg of 4-dimethylaminopyridine, and 20 mL of dichloromethane, the resulting mixture was stirred at room temperature for 16 hours. The resulting reaction solution was washed with hydrochloric acid and water, and concentrated under reduced pressure to give 5.28 g of a compound (1): CH₃CH₂CH₂CH₂Si(CH₃)₂O(Si(CH₃)₂O)ₙSi(CH₃)₂CH₂CH₂CH₂OCH₂CONHCH₂C H=CH₂ (wherein n ≈ 59).

¹H-NMR (400 MHz, CHLOROFORM-D) δ [ppm] 6.59-6.71 (br), 5.80-5.91 (m), 5.12-5.24 (m), 3.91-3.97 (m), 3.45-3.50 (t), 1.58-1.69 (m), 1.24-1.36 (m), 0.86-0.91 (t), 0.51-0.58 (m), -0.10-0.30 (m)

### (Synthetic Example 2)

After addition of 2.0 g of the compound (1), 10 mL of toluene, 47 µL of a xylene solution containing a 2% Pt complex of 1,3-divinyl-1,1,3,3-tetramethyldisiloxane, and 113 µL of aniline, 210 µL of trimethoxysilane was added, and the resulting mixture was stirred at 40°C for 3 hours. Thereafter, the mixture was purified to give 1.74 g of a compound (2):
CH₃CH₂CH₂CH₂Si(CH₃)₂O(Si(CH₃)₂O)ₙSi(CH₃)₂CH₂CH₂CH₂OCH₂CONHCH₂C H₂CH₂Si (OCH₃)₃ (wherein n ≈ 59).

¹H-NMR (400 MHz, CHLOROFORM-D) δ [ppm] 6.62-6.70 (br), 3.92 (s), 3.53-3.62 (m), 3.43-3.49 (t), 3.27-3.33 (q), 1.58-1.72 (m), 1.24-1.35 (m), 0.85-0.92 (t), 0.63-0.69 (t), 0.50-0.57 (m), -0.13-0.32 (m)

### (Synthetic Example 3)

After mixing CH₃CH₂CH₂CH₂Si(CH₃)₂-(OSi(CH₃)₂)ₙ-(CH₂)₃-OCH₂-COOH (10 g), 2,2-diallyl-4-penten-1-amine (1.71 g), 1-(3-dimethylaminopropyl)-3-ethylcarbodiimide hydrochloride (1.98 g), 4-dimethylaminopyridine (84 mg), and dichloromethane (30 mL), the resulting mixture was stirred at room temperature for 16 hours. The mixture was diluted with dichloromethane, washed with hydrochloric acid and water, and concentrated under reduced pressure to give a compound (3): CH₃CH₂CH₂CH₂Si(CH₃)₂-(OSi(CH₃)₂)ₙ-(CH₂)₃-OCH₂-CONH-CH₂C(CH₂CH=CH₂)₃ (8.88 g). The average of the number n of repeating units was 55.

¹H-NMR (CDCl₃, 400 MHz) δ [ppm]: -0.10-0.30 (m), 0.52-0.59 (m, 4H), 0.88 (t, J=6.9Hz, 3H), 1.26-1.33 (m, 4H), 1.61-1.69 (m, 2H), 2.05 (d, J=7.3Hz, 6H), 3.22 (d, J=6.4Hz, 2H), 3.47 (t, J=6.6Hz, 2H), 3.93 (s, 2H), 5.08-5.13 (m, 6H), 5.82-5.92 (m, 3H), 6.75 (brs, 1H)

### (Synthetic Example 4)

The compound (3) (5 g), toluene (5 mL), a xylene solution of Karstedt's catalyst (2%, 0.24 mL), aniline (38 mg), and trimethoxysilane (1.19 mL) were mixed. The resulting mixture was stirred at room temperature for 16 hours, and concentrated under reduced pressure to give a compound (4): CH₃CH₂CH₂CH₂Si(CH₃)₂-(OSi(CH₃)₂)ₙ-(CH₂)₃-OCH₂-CONH-CH₂C{CH₂CH₂CH₂Si(OCH₃)₃)₃ (4.8 g). The average of the number n of repeating units was 55.

¹H-NMR (CDCl₃, 400 MHz) δ [ppm]: -0.13-0.32 (m), 0.54-0.63 (m, 10H), 0.90 (t, J=7.1Hz, 3H), 1.23-1.37 (m, 16H), 1.62-1.69 (m, 2H), 3.17 (d, J=5.9Hz, 2H), 3.47-3.50 (m, 2H), 3.56-3.63 (m, 27H), 3.94 (s, 2H), 6.54 (brs, 1H)

### (Synthetic Example 5)

After addition of 3.02 g of 22-tricosenoic acid, 26 mL of toluene, and 17 mL of methanol, 20 mL of trimethylsilyldiazomethane was added dropwise, followed by stirring at room temperature for 3 hours. Thereafter, the resulting mixture was concentrated under reduced pressure to give 3.11 g of a compound (5).

¹H-NMR (CDCl₃, 400 MHz) δ [ppm]: 1.249-1.649 (m), 2.005-2.061 (m), 2.279-2.316 (t), 1.567-1.622 (m), 3.662 (s), 4.904-5.015 (m), 5.760-5.862 (m)

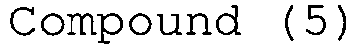

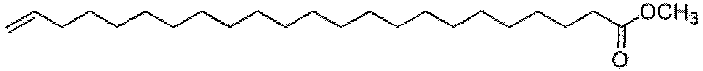

### (Synthetic Example 6)

After addition of 1.25 g of the compound (5), 20.0 mL of toluene, 0.1 mL of pyridine, and 0.65 mL of a xylene solution containing a 2% Pt complex of 1,3-divinyl-1,1,3,3-tetramethyldisiloxane, 1.01 g of tris(trimethylsilyloxy)silane was added dropwise. The resulting mixture was stirred at room temperature for 16 hours, and purified to give 1.36 g of a compound (6).

¹H-NMR (CDCl₃, 400 MHz) δ [ppm]: 0.013-0.142 (m), 0.408 (t), 1.137-1.378 (m), 1.591 (quin), 2.275 (t), 3.639 (s)

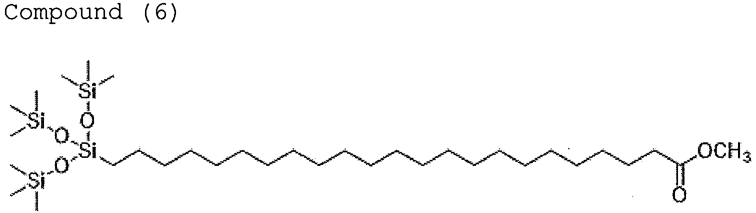

### (Synthetic Example 7)

After addition of 0.64 g of the compound (6), 2.8 mL of allylamine, 0.12 g of 1,5,7-triazabicyclo[4.4.0]dec-5-ene, the resulting mixture was stirred at 75°C for 3 hours. Thereafter, the mixture was washed with an aqueous hydrochloric acid solution, dehydrated over magnesium sulfate, and concentrated under reduced pressure to give 0.68 g of compound (7).

¹H-NMR (CDCl₃, 400 MHz) δ [ppm]: 0.011-0.217 (m), 0.407 (t), 1.153-1.378 (m), 1.612 (quin), 2.163 (t), 3.865 (tt), 5.090-5.182 (m), 5.409 (br), 5.770-5.866 (m)

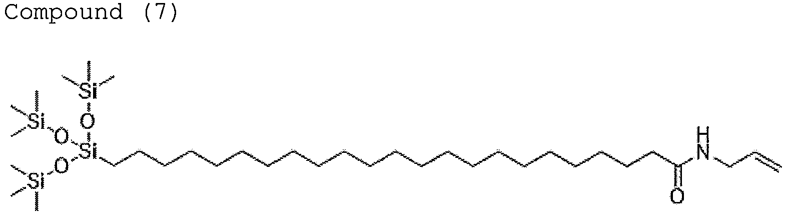

### (Synthetic Example 8)

After addition of 0.56 g of the compound (7), 10.0 mL of toluene, 0.022 mL of aniline, and 0.46 mL of a xylene solution containing a 2% Pt complex of 1,3-divinyl-1,1,3,3-tetramethyldisiloxane, 0.2 mL of trimethoxysilane was added, and the resulting mixture was stirred at 45°C for 2 hours. Thereafter, the mixture was purified to give 0.57 g of a compound (8).

¹H-NMR (CDCl₃, 400 MHz) δ [ppm]: 0.010-0.141 (m), 0.408 (t), 0.629 (t), 1.150-1.376 (m), 1.519-1.652 (m), 2.121 (t), 3.172 (q), 3.516-3.589 (m), 5.607 (br)

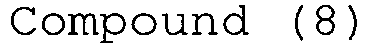

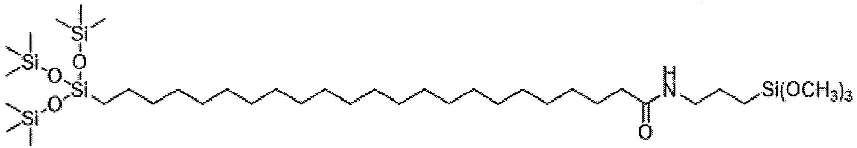

### (Synthetic Example 9)

First, 0.50 g of compound (5), 10.0 mL of toluene, 0.05 mL of pyridine, and 0.3 mL of a xylene solution containing a 2% Pt complex of 1,3-divinyl-1,1,3,3-tetramethyldisiloxane were each added, and then 1.2 mL of 1,1,1,3,5,5,5-heptamethyltrisiloxane was added dropwise. After being stirred at room temperature for 17 hours, the mixture was purified to give 0.87 g of the compound (9).

¹H-NMR (CDCl₃, 400 MHz) δ [ppm]: 0.033-0.241 (m), 0.438-0.550 (m), 1.191-1.413 (m), 1.607-1.642 (m), 2.242-2.325 (m), 3.669 (s)

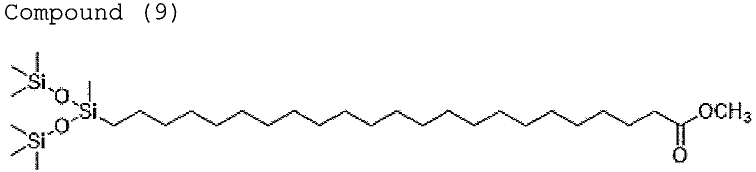

### (Synthetic Example 10)

First, 0.86 g of compound (9), 5.0 mL of allylamine, and 0.20 g of 1,5,7-triazabicyclo[4.4.0]dec-5-ene were each added, and the mixture was then stirred at 75°C for 3 hours. Thereafter, the mixture was washed with an aqueous hydrochloric acid solution, dehydrated over magnesium sulfate, and concentrated under reduced pressure to give 0.72 g of compound (10).

¹H-NMR (CDCl₃, 400 MHz) δ [ppm]: 0.076-0.128 (m), 0.413-0.465 (t), 1.183-1.1.404 (m), 1.604-1.677 (m), 2.173-2.248 (t), 3.841-3.942 (m), 5.122-5.210 (m), 5.809-5.877 (m)

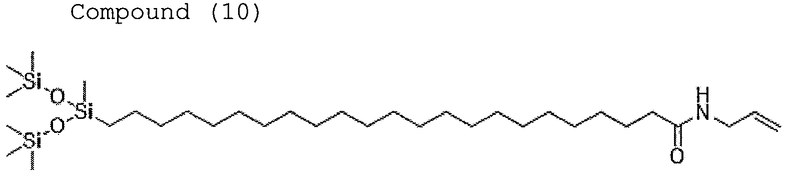

### (Synthetic Example 11)

First, 0.72 g of compound (10), 6.0 mL of toluene, 0.04 mL of pyridine, and 0.26 mL of a xylene solution containing a 2% Pt complex of 1,3-divinyl-1,1,3,3-tetramethyldisiloxane were each added, then 1.4 mL of trimethoxysilane was added, and the mixture was stirred at room temperature for 16 hours. Thereafter, the mixture was purified to give 0.48 g of the compound (11).

¹H-NMR (CDCl₃, 400 MHz) δ [ppm]: 0.054-0.149 (m), 0.425-0.464 (t), 0.628-0.681 (m), 1.181-1.402 (m), 1.544-1.768 (m), 2.125-2.164 (t), 3.558-3.646 (m)

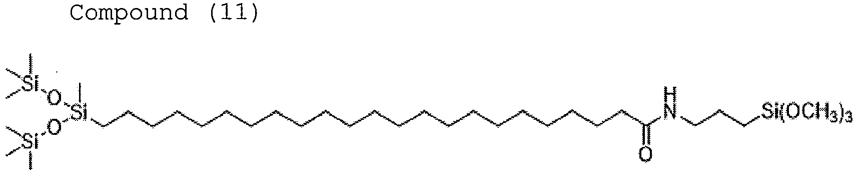

### (Synthetic Example 12)

Tris(trimethylsilyloxy)silane (0.7 g), 18-octadecen-1-ol (1.0 g), tris(pentafluorophenyl)borane (0.24 g), and toluene (10 mL) were each added, and the mixture was then heated at 70°C for 2 hours while being stirred. Thereafter, the reaction solution was subjected to filtration through a silica gel column, and the filtrate was concentrated to give 1.2 g of a compound (12).

¹H-NMR (400 MHz, CHLOROFORM-D) δ5.87-5.76 (m, 1H), 5.02-4.91 (m, 2H), 3.64 (t, J=6.6Hz, 2H), 2.07-2.01 (m, 2H), 1.55-1.50 (m, 2H), 1.41-1.26 (m, 26H), 0.15-0.07 (m, 18H), 0.03 (s, 3H)

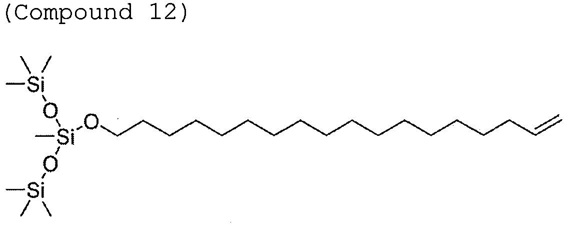

### (Synthetic Example 13)

The compound (12) (1.0 g), Karstedt's catalyst (0.13 g, a xylene solution containing platinum in an amount of 2%), trimethoxysilane (0.75 g), pyridine (22 mg), and toluene (10 mL) were each added, the mixture was stirred at room temperature for 4 hours and then concentrated under reduced pressure to give 1.09 g of compound (13).

¹H-NMR (400 MHz, CHLOROFORM-D) δ3.74-3.53 (m, 11H), 1.56-1.50 (m, 2H), 1.43-1.25 (m, 30H), 0.67-0.62 (m, 2H), 0.26-0.07 (m, 18H), 0.04 (q, J=4.4Hz, 3H)

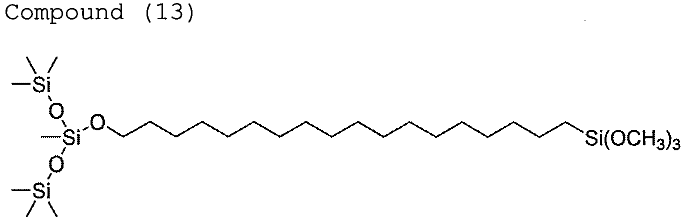

### (Synthetic Example 14)

After addition of 5.01 g of CH₃Si(CH₃)₂O(Si(CH₃)₂O)ₙSi(CH₃)₂(CH₂)₁₀COOH, 15.0 g of tetrahydrofuran, 0.99 g of 1-(3-dimethylaminopropyl)-3-ethylcarbodiimide hydrochloride, 0.047 g of 4-dimethylaminopyridine, and 0.38 mL of allylamine, the resulting mixture was stirred at room temperature for 16 hours. Thereafter, the mixture was purified to give 4.80 g of a compound (14):
CH₃Si(CH₃)₂O(Si(CH₃)₂O)ₙSi(CH₃)₂(CH₂)₁₀CONHCH₂CH=CH₂ (wherein n ≈ 16).

¹H-NMR (CDCl₃, 400 MHz) δ [ppm]: -0.124-0.279 (m), 0.486-0.523 (t), 1.243-1.269 (m), 1.617 (bs), 2.161-2.196 (t), 3.859 (bs), 5.083-5.175 (m), 5.781-5.848 (m)

### (Synthetic Example 15)

After addition of 4.34 g of the compound (14): CH₃Si(CH₃)₂O(Si(CH₃)₂O)ₙSi(CH₃)₂(CH₂)₁₀CONHCH₂CH=CH₂, 13.09 g of toluene, 0.035 g of triacetoxymethylsilane, and 0.15 ml of a xylene solution containing a 2% Pt complex of 1,3-divinyl-1,1,3,3-tetramethyldisiloxane, 0.61 mL of trichlorosilane was added, and the resulting mixture was heated to 60°C and stirred for 4 hours. Thereafter, volatile substances were distilled off under reduced pressure, a mixed solution of 0.280 g of methanol and 6.340 g of trimethyl orthoformate was added to the resultant, and the resulting mixture was heated to 50°C and stirred for 3 hours. Then, the resultant was purified to give 4.24 g of a compound (15):
CH₃Si(CH₃)₂O(Si(CH₃)₂O)ₙSi(CH₃)₂(CH₂)₁₀CONHCH₂CH₂CH₂Si(OCH₃)₃ (wherein n ≈ 16).

¹H-NMR (CDCl₃, 400 MHz) δ [ppm]: -0.010-0.157 (m), 0.495-0.666 (m), 1.251-1.274 (m), 1.578-1.654 (m), 2.123-2.312 (m), 3.218-3.267 (m), 3.420-3.605 (m)

For preparing a surface-treating agent 7, the following compound (16) was used.

Compound (16): MCR-XT11, manufactured by Gelest, Inc. (triethoxysilylethyl-terminated polydimethylsiloxane, Mw = 600 to 900)

### (Synthetic Example 17)

After mixing (CH₃)₃Si-(OSi(CH₃)₂)ₙ-(CH₂)₁₀-CON(CH₂CH=CH₂)₂ (2 g), toluene (10 mL), a xylene solution of Karstedt's catalyst (2%, 0.20 mL), aniline (32 mg), and trimethoxysilane (1.00 mL), the resulting mixture was stirred at room temperature for 16 hours, and concentrated under reduced pressure to give a compound (17): (CH₃)₃Si-(OSi(CH₃)₂)ₙ-(CH₂)₁₀-CON[CH₂CH₂CH₂Si(OCH₃)₃]₂ (2.23 g). The average of the number n of repeating units was 19.

¹H NMR (CDCl₃, 400 MHz) δ [ppm]: -0.20-0.31 (m), 0.42-0.65 (m, 6H), 1.10-1.40 (m, 14H), 1.63-1.71 (m, 6H), 2.26 (t, 2H, 7.2 Hz), 3.19 (t, 2H, 7.6 Hz), 3.27 (t, 2H, 7.6 Hz), 3.45-3.65 (m, 18H).

### (Synthetic Example 18)

First, 2.00 g of [(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH₂CH₂CH₂CH₂CONHCH₂CH(CH₂CH=CH₂)₂ (n≈26), 10 ml of toluene, 0.05 ml of a xylene solution containing a 2% Pt complex of 1,3-divinyl-1,1,3,3-tetramethyldisiloxane, and 0.01 ml of aniline were added, the mixture was stirred, 0.24 ml of trimethoxysilane was added dropwise at room temperature, and then the mixture was heated to 45°C and stirred for 2 hours. Thereafter, volatile substances were distilled off under reduced pressure, and the resultant was purified to give 2.0 g of a compound (18):
[(CH₃)₃SiO]₂CH₃SiO(Si(CH₃)₂O)ₙSi(CH₃)₂CH₂CH₂CH₂CH₂CH₂CH₂CH₂CH₂ CH₂CH₂CH₂CH₂CH₂CH₂CH₂CH₂CH₂CH₂CH_{2C}H_{2C}H_{2C}H₂CONHCH₂CH[CH₂CH₂CH₂Si (OCH₃)₃]₂ (wherein n ≈ 26).

¹H-NMR (CDCl₃, 400 MHz) δ [ppm]: -0.089-0.207 (m), 0.492-0.531 (m), 0.595-0.635 (t), 1.200-1.308 (m), 1.378-1.681 (m), 2.123-2.160 (t), 3.157-3.187 (t), 3.517-3.592 (m), 3.494-3.602 (m), 5.465-5.492 (m)

### (Synthetic Example 19)

After adding and stirring 4.03 g of perfluorophenyl 22-tricosenoate and 5.0 ml of THF, 1.30 ml of dimethylchlorosilane, and 0.080 ml of a xylene solution containing a 2% Pt complex of 1,3-divinyl-1,1,3,3-tetramethyldisiloxane were added at room temperature, and the resulting mixture was stirred at room temperature for 16 hours. Thereafter, volatile components were distilled off under reduced pressure, and the resultant was purified to give 4.6 g of a compound (19-1): chlorodimethylsilyl tricosenoate.

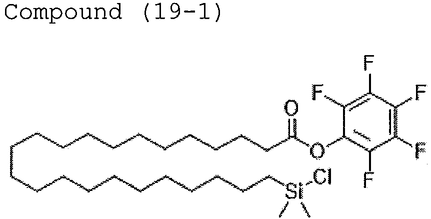

To a separate reactor, 1.33 g of hexamethyldisiloxane and 10 ml of THF were added and stirred, and to the resulting mixture, 2.57 ml of a solution of 15% n-butyllithium in hexane was added under a water bath at 30°C. After cooling the mixture in an ice bath, 17.79 g of hexamethylcyclotrisiloxane and 20 ml of THF were added to the solution, followed by stirring further for 8 hours. While cooling the mixture in an ice bath, a solution of 2.3 g of the previously synthesized compound (19-1), chlorodimethylsilyltricosenoic acid ester, in 10 ml of THF was added, and the resulting mixture was stirred for 1 hour. To the resultant, 1.50 g of 2-allylpent-4-en-1-amine was added, and the resultant was kept immersed in the ice bath and stirred for 16 hours. A part of the reaction solution was then purified to give 2.8 g of a compound (19-2): CH₃[Si(CH₃)₂O]ₙSi(CH₃)₂(CH₂)₂₂CONH-CH₂CH[CH₂CH=CH₂]₂. The average of n was 57.

¹H NMR (CDCl₃, 400 MHz) δ [ppm]: -0.089 - 0.211 (m), 0.494 - 0.533 (t), 1.242 - 1.335 (m), 1.586 - 1.623 (m), 1.692 - 1.758 (m), 2.000 - 2.160 (m), 3.193 - 3.224 (t), 5.023 - 5.077 (m), 5.455 (br), 5.728 - 5.832 (m)

### (Synthetic Example 20)

After addition of 2.74 g of the compound (19-2), 5.5 mL of toluene, 14 µL of pyridine, and 70 µL of a xylene solution containing a 2% Pt complex of 1,3-divinyl-1,1,3,3-tetramethyldisiloxane, 0.29 mL of trimethoxysilane was further added, and the resulting mixture was stirred at room temperature for 16 hours. Thereafter, the resultant was purified to give 2.63 g of a compound (20): CH₃[Si(CH₃)₂O]ₙSi(CH₃)₂(CH₂)₂₂CONH-CH₂CH[CH₂CH₂CH₂Si(OCH₃)₃]₂. The average number of repeating units of dimethylsiloxane was 57.

¹H NMR (CDCl₃, 400 MHz) δ [ppm]: -0.104-0.196 (m), 0.498 (t), 0.604 (t), 1.226-1.339 (m), 1.404 (quin), 1.568-1.664 (m), 2.130 (t), 3.160 (t), 3.496-3.584 (m), 5.471 (br)

### (Synthetic Example 21)

After addition of 2.0 g of CH₃CH₂CH₂CH₂-[Si(CH₃)₂O]ₙSi(CH₃)₂-CH₂CH₂CH₂-O-CH₂-C(CH₂CH₃)(CH₂OH)₂ (average molecular weight: 4,700), and 0.49 mL of (3-isocyanatopropyl)trimethoxysilane, the resulting mixture was stirred at 40°C for 2.5 hours, at 55°C for 3.5 hours, and then at 60°C for 6 hours. Thereafter, the mixture was washed with methanol, and concentrated to give 1.5 g of a compound (21): CH₃CH₂CH₂CH₂-[Si(CH₃)₂O]ₙSi(CH₃)₂-CH₂CH₂CH₂-O-CH₂-C(CH₂CH₃)[CH₂OC(=O)NHCH₂CH₂CH₂Si(OCH₃)₃]₂. The average number of repeating units of dimethylsiloxane was 63.

¹H-NMR (400 MHz, CHLOROFORM-D) δ 4.83 (s, 2H), 4.01-3.94 (m, 6H), 3.57-3.49 (m, 18H), 3.32-3.24 (m, 2H), 3.16-3.12 (m, 4H), 1.60-1.54 (m, 6H), 1.40-1.24 (m, 6H), 0.90-0.82 (t, 6H), 0.66-0.58 (m, 4H), 0.54-0.47 (m, 4H), 0.21 - - 0.09 (m)

### (Synthetic Example 22)

After addition of 2.0 g of CH₃CH₂CH₂CH₂-[Si(CH₃)₂O]ₙSi(CH₃)₂-CH₂CH₂CH₂-O-CH₂CH₂OH (average molecular weight: 4,800), and 0.48 mL of (3-isocyanatopropyl)trimethoxysilane, the resulting mixture was stirred at 55°C for 1 hour, at 65°C for 3 hours, and then at 70°C for 5 hours. Thereafter, the mixture was washed with methanol, and concentrated to give 1.5 g of a compound (22): CH₃CH₂CH₂CH₂-[Si(CH₃)₂O]ₙSi(CH₃)₂-CH₂CH₂CH₂-O-CH₂CH₂O-C(=O)NHCH₂CH₂CH₂Si(OCH₃)₃. The average number of repeating units of dimethylsiloxane was 60.

¹H-NMR (400 MHz, CHLOROFORM-D) δ 4.87 (s, 1H), 4.20-4.18 (t, 2H), 3.60-3.53 (m, 9H), 3.43-3.40 (t, 2H), 3.30-3.26 (t, 2H), 3.18-3.13 (m, 2H), 1.75-1.69 (m, 2H), 1.64-1.58 (m, 2H), 1.34-1.24 (m, 4H), 0.89-0.85 (t, 3H), 0.69-0.60 (m, 2H), 0.54-0.49 (m, 4H), 0.21 - -0.09 (m)

### (Synthetic Example 23)

After addition of 20.10 g of 22-tricosenoic acid, 200 mL of dichloromethane, 10.20 g of 1,1'-carbonyldiimidazole, the resulting mixture was stirred at room temperature for 2 hours, and purified to give 20.25 g of a compound (23).

¹H NMR (CDCl₃, 400 MHz) δ [ppm]: 1.219-1.445 (m), 1.803 (quin), 2.040 (q), 2.856 (t), 4.880-5.054 (m), 5.745-5.888 (m), 7.105 (s), 7.483 (s), 8.165 (s)

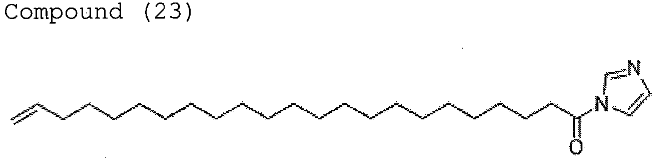

### (Synthetic Example 24)

First, 5.0 g of compound (23), 29 mL of toluene, 4 µL of pyridine, and 0.55 mL of a xylene solution containing a 2% Pt complex of 1,3-divinyl-1,1,3,3-tetramethyldisiloxane were each added, then 5.05 mL of 1,1,1,3,3,5,5-heptamethyltrisiloxane was added dropwise. After being stirred at room temperature for 16 hours, the mixture was purified to give 7.58 g of compound (24).

¹H NMR (CDCl₃, 400 MHz) δ [ppm]: -0.129-0.251 (m), 0.526 (t), 1.115-1.430 (m), 1.802 (quin), 2.855 (t), 7.104 (s), 7.480 (s), 8.173 (s)

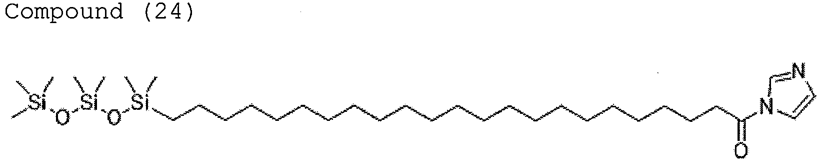

### (Synthetic Example 25)

First, 4.03 g of compound (24), 14 mL of toluene, and 0.58 mL of allylamine were each added, and the mixture was then stirred at room temperature for 1 hour. Thereafter, the mixture was purified to give 1.17 g of compound (25).

¹H NMR (CDCl₃, 400 MHz) δ [ppm]: -0.129-0.237 (m), 0.525 (t), 1.180-1.1.404 (m), 1.635 (quin), 2.192 (t), 3.891 (tt), 5.117-5.209 (m), 5.469 (br), 5.781-5.892 (m)

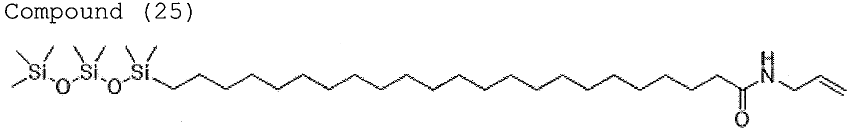

### (Synthetic Example 26)

First, 1.17 g of compound (25), 3.0 mL of toluene, 0.046 mL of pyridine, and 0.22 mL of a xylene solution containing a 2% Pt complex of 1,3-divinyl-1,1,3,3-tetramethyldisiloxane were each added, then 0.72 mL of trimethoxysilane was added, and the mixture was stirred at room temperature for 4 hours. Thereafter, the mixture was purified to give 1.06 g of the compound (26).

¹H NMR (CDCl₃, 400 MHz) δ [ppm]: -0.133-0.234 (m), 0.523 (t), 0.649 (t), 1.166-1.402 (m), 1.582-1.675 (m), 2.149 (t), 3.239 (q), 3.486-3.664 (m), 5.677 (br)

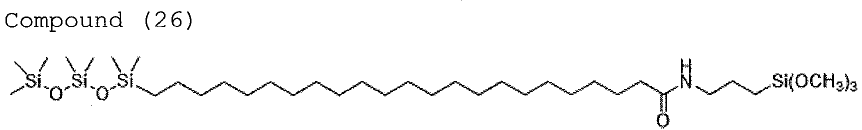

### (Synthetic Example 27)

First, 3.55 g of compound (24), 12 mL of toluene, and 0.85 g of 2-allylpent-4-en-1-amine were each added, and the mixture was then stirred at room temperature for 1 hour. Thereafter, the mixture was purified to give 1.64 g of compound (27).

¹H NMR (CDCl₃, 400 MHz) δ [ppm]: -0.130-0.236 (m), 0.525 (t), 1.180-1.1.404 (m), 1.612 (quin), 1.736 (quin), 2.071 (q), 2.157 (t), 3.217 (t), 5.033-5.087 (m), 5.510 (br), 5.738-5.841 (m)

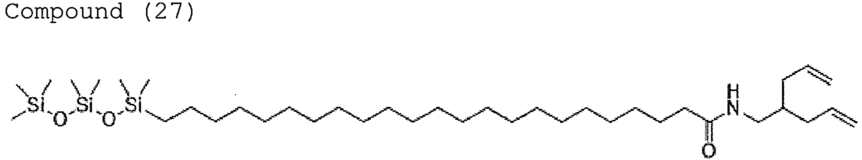

### (Synthetic Example 28)

First, 1.64 g of compound (27), 5.0 mL of toluene, 0.058 mL of pyridine, and 0.27 mL of a xylene solution containing a 2% Pt complex of 1,3-divinyl-1,1,3,3-tetramethyldisiloxane were each added, then 1.83 mL of trimethoxysilane was added, and the mixture was stirred at room temperature for 4 hours. Thereafter, the mixture was purified to give 1.77 g of the compound (28).

¹H NMR (CDCl₃, 400 MHz) δ [ppm]: -0.134-0.232 (m), 0.522 (t), 0.626 (t), 1.103-1.388 (m), 1.388-1.449 (m), 1.538-1.690 (m), 2.156 (t), 3.182 (t), 3.383-3.741 (m), 5.534 (br)

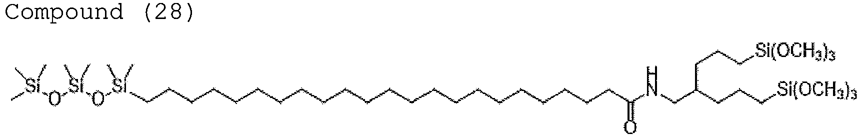

### (Synthetic Example 29)

After addition of 2.11 g of 22-tricosenoic acid, 95 ml of toluene, 1.26 g of 1,1'-carbonyldiimidazole, the resulting mixture was stirred at room temperature for 1 hour. Thereafter, the resultant was purified to give 2.22 g of a compound (29): CH₂=CH(CH₂)₂₀CO(C₃H₄N₂).

¹H NMR (CDCl₃, 400 MHz) δ [ppm]: 1.250 (s), 1.333-1.426 (m), 1.761-1.836 (m), 2.007-2.061 (dd), 2.837-2.875 (t), 4.909-5.016 (m), 5.761-5.863 (m), 7.104 (s), 7.481 (s), 8.174 (s)

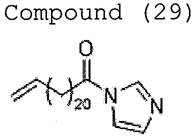

### (Synthetic Example 30)

After addition of 1.38 g of the compound (29): CH₂=CH(CH₂)₂₀CO(C₃H₄N₂), 24.9 g of toluene, and 6.12 g of CH₃[Si(CH₃)₂O]ₙSi(CH₃)₂H, 0.56 ml of a xylene solution containing a 2% Pt complex of 1,3-divinyl-1,1,3,3-tetramethyldisiloxane was added, and the resulting mixture was heated to 60°C and stirred for 12 hours. Thereafter, the mixture was purified to give 6.86 g of a compound (30): CH₃[Si(CH₃)₂O]ₙSi(CH₃)₂(CH₂)₂₂CO(C₃H₄N₂). The average of n was 26.

¹H NMR (CDCl₃, 400 MHz) δ [ppm]: -0.076-0.223 (m), 0.505-0.543 (t), 1.253 (br s), 1.767-1.841 (m), 2.857-2.894 (t), 7.124 (s), 7.497 (s), 8.273 (s)

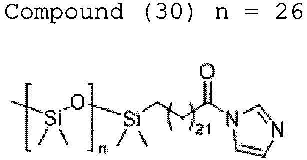

### (Synthetic Example 31)

After addition of 6.86 g of the compound (30): CH₃[Si(CH₃)₂O]ₙSi(CH₃)₂(CH₂)₂₂CO(C₃H₄N₂), 6.86 g of heptane, and 1.48 g of bis[3-(trimethoxysilyl)propyl]amine, the resulting mixture was stirred at 60°C for 3 hours. Thereafter, the mixture was purified to give 6.71 g of a compound (31):
CH₃[Si(CH₃)₂(CH₃)₂(CH₂)₂₂CON[CH₂CH₂CH₂Si(OCH₃)₃]₂. The average of n was 26.

¹H NMR (CDCl₃, 400 MHz) δ [ppm]: -0.109-0.216 (m), 0.499-0.537 (t), 0.559-0.612 (m), 1.245 (br s), 1.570-1.630 (m), 2.256-2.295 (t), 3.182-3.221 (t), 3.264-3.301 (t), 3.556 (br s), 3.575 (br s)

### (Synthetic Example 32)

A compound (32):
CH₃(Si(CH₃)₂O)ₙSi(CH₃)₂(CH₂)₂₂CON[CH₂CH₂CH₂Si(OCH₃)₃]₂ was obtained in the same manner as in Synthetic Examples 30 to 31 except that the raw material was changed to use CH₃(Si(CH₃)₂O)ₙSi(CH₃)₂H. The average of n was 34.

¹H NMR (CDCl₃, 400 MHz) δ [ppm]: -0.109-0.216 (m), 0.499-0.537 (t), 0.559-0.612 (m), 1.245 (br s), 1.570-1.630 (m), 2.256-2.295 (t), 3.182-3.221 (t), 3.264-3.301 (t), 3.556 (br s), 3.575 (br s)

### (Synthetic Example 33)

A compound (33):
CH₃[Si(CH₃)₂O]₄₈Si(CH₃)₂(CH₂)₂₂CON[(CH₂)₃Si(OCH₃)₃]₂ was obtained in the same manner as in Synthetic Examples 7 to 8 except that the raw material was changed to use CH₃(Si(CH₃)₂O)ₙSi(CH₃)₂H. The average of n was 48.

### <Preparation of surface-treating agent>

Surface-treating agents were prepared as shown in Table 1.

**[Table 1]**

| Surface-treating agent No. | Compound No. | Solvent | Solid content |
|---|---|---|---|
| Surface-treating agent 1 | Compound (2) | Hexamethyldisiloxane | 20% by mass |
| Surface-treating agent 2 | Compound (4) | Hexamethyldisiloxane | 20% by mass |
| Surface-treating agent 3 | Compound (8) | Heptane | 20% by mass |
| Surface-treating agent 4 | Compound (11) | Heptane | 20% by mass |
| Surface-treating agent 5 | Compound (13) | Heptane | 20% by mass |
| Surface-treating agent 6 | Compound (15) | Hexamethyldisiloxane | 20% by mass |
| Surface-treating agent 7 | Compound (16) | Hexamethyldisiloxane | 20% by mass |
| Surface-treating agent 8 | Compound (17) | Hexamethyldisiloxane | 20% by mass |
| Surface-treating agent 9 | Compound (18) | Hexamethyldisiloxane | 20% by mass |
| Surface-treating agent 10 | Compound (20) | Hexamethyldisiloxane | 20% by mass |
| Surface-treating agent 11 | Compound (21) | Hexamethyldisiloxane | 20% by mass |
| Surface-treating agent 12 | Compound (22) | Hexamethyldisiloxane | 20% by mass |
| Surface-treating agent 13 | Compound (26) | Heptane | 20% by mass |
| Surface-treating agent 14 | Compound (28) | Heptane | 20% by mass |
| Surface-treating agent 15 | Compound (30) | Heptane | 20% by mass |
| Surface-treating agent 16 | Compound (32) | Heptane | 20% by mass |
| Surface-treating agent 17 | Compound (33) | Heptane | 20% by mass |

### <Na-containing intermediate layer forming material>

First, 2.2 g of sodium hydroxide (manufactured by Fujifilm Wako Pure Chemical Corporation) was dissolved in 24 g of distilled water to give a 8.4% by mass aqueous sodium hydroxide solution. Then, 24 g of this 8.4% by mass aqueous sodium hydroxide solution and 20 g of MS gel (M.S. GEL D-100-60A (manufactured by AGC Si-Tech Co., Ltd.)) were mixed so that the aqueous sodium hydroxide solution was absorbed into the MS gel. The MS gel that had absorbed the aqueous sodium hydroxide solution was dried at 25°C for 8 hours, then molded with a tableting machine (4 MPa for 1 minute), and fired at 1,000°C for 1 hour to give a formed article 1 (pellets).

### (SiO₂ intermediate layer)

The surface-treating agents prepared above were vacuum-deposited onto chemically tempered glass (Gorilla Glass, manufactured by Corning Incorporated, thickness 0.7 mm). Specifically, a molybdenum boat in a vacuum deposition system was filled with 0.1 g of a surface-treating agent, and the vacuum deposition system was evacuated to a pressure of 3.0 × 10⁻³ Pa or lower. Thereafter, a silicon dioxide film having a thickness of 5 nm was formed, followed by heating the boat by the resistance heating scheme to form a surface-treating layer (i.e., a water-repellent layer). Thereafter, heat treatment was performed in an oven at 150°C for 2 hours to give a surface-treating layer.

### (Na-containing SiO₂ intermediate layer)

The surface-treating agents prepared above were vacuum-deposited onto chemically tempered glass (Gorilla Glass, manufactured by Corning Incorporated, thickness 0.7 mm). Specifically, a molybdenum boat in a vacuum deposition system was filled with 0.1 g of a surface-treating agent, and the vacuum deposition system was evacuated to a pressure of 3.0 × 10⁻³ Pa or lower. Thereafter, vapor deposition by the electron beam deposition scheme was performed using the formed article 1 to form a Na-containing silicon dioxide film having a thickness of 5 nm, followed by heating the boat by the resistance heating scheme to form a surface-treating layer (i.e., a water-repellent layer). Thereafter, heat treatment was performed in an oven at 150°C for 2 hours to give a surface-treating layer.

### <Evaluation>

### [Measurement of water contact angle after film deposition]

The surface of the substrate with the surface-treating layer prepared by the method described above was thoroughly wiped with Kimwipes S-200 (product name, manufactured by NIPPON PAPER CRECIA CO., LTD.) soaked in ethanol, and then the static water contact angle was measured.

### (Measurement of contact angle)

For contact angle measurement, a fully automatic contact angle meter DropMaster 700 (manufactured by Kyowa Interface Science Co., Ltd.) was used under an environment of 25°C. Specifically, the substrate having the measurement target, i.e., the surface-treating layer, was placed horizontally, 2 µL of water was dripped from a microsyringe onto the surface, and a static image was taken with a video microscope one second after the dropwise addition to thereby measure the static contact angle. The static contact angle was measured at five different points on the surface-treating layer of the substrate, and the average value calculated therefrom was used.

Evaluation criteria for the water contact angle measurement were as follows:
103° or more: good (circle)
less than 103°: poor (cross mark)

### [Evaluation of abrasion resistance]

### (Abrasion method)

A friction block as described below was brought into contact with the formed surface-treating layer, a 5 N load was applied thereto, and the friction block was moved back and forth at a speed of 40 mm/sec, with the load being applied. The static water contact angle (°) after 50 times of friction was measured. The method for measuring the contact angle was as described above.

### - Friction block

The surfaces of an article obtained by processing silicone rubber as described below were covered with cotton soaked with artificial sweat having the following composition, and the article was used as a friction block.
- Composition of artificial sweat:
   Anhydrous disodium hydrogen phosphate: 2 g
   Sodium chloride: 20 g
   85% Lactic acid: 2 g
   Histidine hydrochloride: 5 g
   Distilled water: 1 kg

Article obtained by processing silicone rubber:
Obtained by processing Silicone Rubber Stopper SR-51 manufactured by Tigers Polymer Corporation into a cylinder having a diameter of 1 cm and a thickness of 1 cm.

### (Evaluation criteria for water contact angle after abrasion test)

90° or more: excellent (double circle)
75° or more and less than 90°: good (circle)
60° or more and less than 75°: fair (triangle)
less than 60°: poor (cross mark)

### [Measurement of surface composition]

### (XPS measurement method)

The surface composition of the surface-treating layer formed on the substrate was analyzed using an X-ray photoelectron spectroscopy apparatus (XPS, PHI 5000 VersaProbe II manufactured by ULVAC-PHI, Inc.). Measurement conditions for the XPS analysis were as follows:
X-ray source: Monochromatized Al Kα radiation (25 W)
Photoelectron detection area: 1400 µm × 300 µm
Photoelectron detection angle: 45 degrees
Pass energy: 23.5 eV
Measured elements: carbon (C1s) 278 to 298 eV, nitrogen (N1s) 390 to 410 eV, oxygen (O1s) 523 to 543 eV, fluorine (F1s) 680 to 698 eV, silicon (Si2p) 94 to 114 eV

The nitrogen concentration (atomic%) in the surface-treating layer was calculated from the peak shape and intensity obtained in each region.

Evaluation criteria for the nitrogen concentration in the surface-treating layer were as follows:
(Criteria for nitrogen concentration)
1.0 atomic% or more: good (circle)
0.5 atomic% or more and less than 1.0 atomic%: fair (triangle)
less than 0.5 atomic%: poor (cross mark)

### [Evaluation of lubricity]

To evaluate the tactile sensation, the dynamic friction coefficient was measured using FPT-F1 manufactured by Labthink Instruments Co., Ltd. After the surface-treating layer was formed, excess components on the surface were wiped off with ethanol, and then the dynamic friction coefficient was measured. The measurement conditions were as follows:
Friction material: urethane sheet (thickness: 2 mm)
Contact area: 2 cm²
Load: 200 gf
Friction speed: 5 mm/sec

### (Evaluation criteria)

less than 0.6: good (circle)
0.6 or more: poor (cross mark)

Table 2 below shows the measurement results of the N concentration, the water contact angle after film deposition, and the water contact angle after the abrasion test. In addition, it was confirmed that the fluorine concentration was less than 0.01 atomic% in all Examples.

**[Table 2]**

| Example/Compar ative Example No. | Surface-treating agent No. | Inermediate layer | N Concentration | Water contact angle after film deposition | Water contact angle after abrasion test |
|---|---|---|---|---|---|
| Example 1 | Surface-treating agent 3 | Na-containing silicon dioxide film | ○ | ○ | ⊚ |
| Example 2 | Surface-treating agent 4 | Na-containing silicon dioxide film | ○ | ○ | ⊚ |
| Comparative Example 1 | Surface-treating agent 5 | Na-containing silicon dioxide film | × | × | × |
| Example 3 | Surface-treating agent 3 | Silicon dioxide film | ○ | ○ | ○ |
| Example 4 | Surface-treating agent 4 | Silicon dioxide film | ○ | ○ | ○ |
| Comparative Example 2 | Surface-treating agents | Silicon dioxide film | × | × | × |
| Example 11 | agent 9 | Na-containing silicon dioxide film | ○ | ○ | ⊚ |
| Example 12 | Surface-treating I agent 10 | Na-containing silicon dioxide film | Δ | ○ | ○ |
| Example 13 | Surface-treating-agent 9 | Silicon dioxide film | ○ | ○ | ⊚ |
| Example 14 | Surface-treating agent 10 | Silicon dioxide film | Δ | ○ | ○ |
| Example 21 | Surface-treating agent 13 | Na-containing silicon dioxide film | ○ | ○ | ○ |
| Example 22 | Surface-treating agent 14 | Na-containing silicon dioxide film | ○ | ○ | ○ |
| Example 23 | Surface-treating agent 13 | Silicon dioxide film | ○ | ○ | ○ |
| Example 24 | Surface-treating agent 14 | Silicon dioxide film | ○ | ○ | ○ |

Table 3 below shows the measurement results of the N concentration, the water contact angle after film deposition, and the evaluation results of the lubricity. In addition, it was confirmed that the fluorine concentration was less than 0.01 atomic% in all Examples.

**[Table 3]**

| Example /Comparative Example No. | Surface-treating agent No. | Intermediate layer | N Concentration | Water contact angle | Lubricity |
|---|---|---|---|---|---|
| Example 5 | Surface-treating agent 1 | Na-containing silicon dioxide film | Δ | ○ | ○ |
| Example 6 | Surface-treating agent 2 | Na-containing silicon dioxide film | Δ | ○ | ○ |
| Example 7 | Surface-treating agent 6 | Na-containing silicon dioxide film | Δ | ○ | ○ |
| Comparative Example 3 | Surface-treating agent 7 | Na-containing silicon dioxide film | × | × | ○ |
| Example 8 | Surface-treating agent 1 | Silicon dioxide film | Δ | ○ | ○ |
| Example 9 | Surface-treating agent 2 | Silicon dioxide film | Δ | ○ | ○ |
| Example 10 | Surface-treating agent 6 | Silicon dioxide film | Δ | ○ | ○ |
| Comparative Example 4 | Surface-treating agent 7 | Silicon dioxide film | × | × | ○ |
| Example 16 | Surface-treating agent 8 | Na-containing silicon dioxide film | ○ | ○ | ○ |
| Example 16 | Surface-treating agent 11 | Na-containing silicon dioxide film | Δ | ○ | ○ |
| Example 17 | Surface-treating agent 12 | Na-containing silicon dioxide film | Δ | ○ | ○ |
| Example 18 | Surface-treating agent 8 | Silicon dioxide film | ○ | ○ | ○ |
| Example 19 | Surface-treating agent 11 | Silicon dioxide film | Δ | ○ | ○ |
| Example 20 | Surface-treating agent 12 | Silicon dioxide film | Δ | ○ | ○ |
| Example 25 | Surface-treating agent 15 | Na-containing silicon dioxide film | ○ | ○ | ○ |
| Example 26 | Surface-treating agent 16 | Na-containing silicon dioxide film | ○ | ○ | ○ |
| Example 27 | Surface-treating agent 17 | Na-containing silicon dioxide film | Δ | ○ | ○ |
| Example 28 | Surface-treating agent 15 | Silicon dioxide film | ○ | ○ | ○ |
| Example 29 | Surface-treating agent 16 | Silicon dioxide film | ○ | ○ | ○ |
| Example 30 | Surface-treating agent 17 | Silicon dioxide film | Δ | ○ | ○ |

### Industrial Applicability

The surface-treating agent of the present disclosure can be suitably utilized in a variety of applications.

## Claims

1. A laminate comprising a substrate and a water-repellent layer located on the substrate,
wherein a nitrogen concentration on a surface of the water-repellent layer is 0.01 atomic% or more and 10 atomic% or less, and
a fluorine concentration on the surface of the water-repellent layer is less than 5 atomic%.

2. The laminate according to claim 1,
wherein a silicon concentration on the surface of the water-repellent layer is 0.1 atomic% or more and 50 atomic% or less.

3. The laminate according to claim 2,
wherein the silicon concentration on the surface of the water-repellent layer is 15 atomic% or more and 25 atomic% or less.

4. The laminate according to claim 1, wherein the water-repellent layer is a cured product of a compound represented by the following formula (1):
[Formula 1]
R^{S}-X¹-(R^{Si})_{α} (1)
wherein
R^{S} is a monovalent group containing one or more Si atoms to which neither a hydroxyl group nor a hydrolyzable group is directly bonded,
X¹ is a di- to decavalent group,
R^{Si} is a monovalent group containing a Si atom to which a hydroxyl group or a hydrolyzable group is bonded, and
α is an integer of 1 to 9.

5. The laminate according to claim 4,
wherein R^{S} is a group represented by R¹-(R^{S1})ₛ₁-(SiR²₂)ₛ₂-(R^{Ar})ₛ₃-,
wherein R¹ is a hydrocarbon group, or the following group A or group B,
the group A and the group B are groups represented by the following formulae: 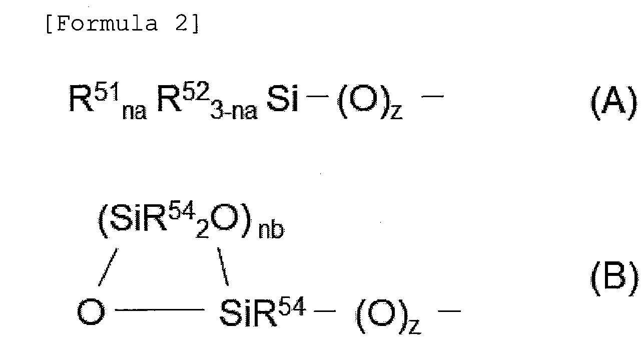 [wherein
R⁵¹ is each independently a group represented by R⁵³-(SiR⁵³₂-R⁶¹)ₘₐ-,
R⁶¹ is each independently a single bond, an oxygen atom or a C₁₋₆ alkylene group,
R⁵³ is each independently a hydrocarbon group or R⁵¹',
R⁵¹' has the same meaning as R⁵¹,
ma is each independently an integer of 1 to 5,
provided that the number of R⁵¹' in R⁵¹ is 20 or less,
R⁵² is each independently a hydrocarbon group,
na is an integer of 1 to 3,
R⁵⁴ is each independently a hydrocarbon group,
nb is an integer of 1 to 5, and
z is 0 or 1],
R^{S1} is each independently a single bond, or a group represented by the following formula: 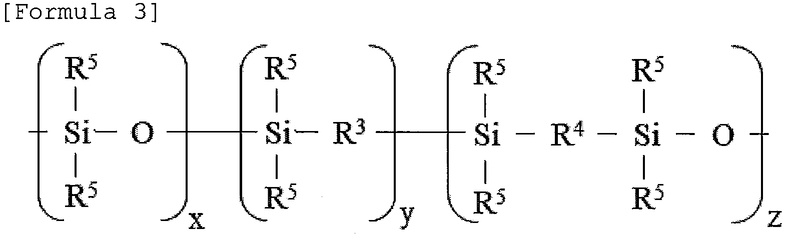 [wherein
R³ is each independently a C₁₋₁₂ alkylene group, -R⁶-O-R⁶-, -R⁸-R⁷-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
R⁴ is each independently a C₁₋₁₂ alkylene group, -R⁶-O-R⁶-, -R⁸-R7-R⁸-, -R⁸-R⁷-R⁹-R⁷-R⁸-, -R⁸-R⁷-R⁹-R⁶-R⁹-R⁷-R⁸-, or -R⁹-R⁶-R⁹-R⁷-R⁹-R⁶-R⁹-,
R⁶ is each independently a C₁₋₆ alkylene group,
R⁷ is each independently an optionally substituted arylene group,
R⁸ is each independently a single bond or a C₁₋₆ alkylene group,
R⁹ is each independently a single bond or an oxygen atom,
R⁵ is each independently a hydrocarbon group,
x is an integer of 0 to 500,
y is an integer of 0 to 500,
z is an integer of 0 to 500,
x + y + z is 1 or more, and
the occurrence order of the respective repeating units enclosed in parentheses provided with x, y, or z is not limited in the formula],
R² is each independently a hydrocarbon group, and
s1, s2, and s3 are 0 or 1.

6. The laminate according to claim 4,
wherein the compound represented by the formula (1) is any one of the following compounds:
CH₃-[Si(CH₃)₂O]ₙ₁Si(CH₃)2-(CH₂)_{H1}-C(=O)NHCH₂CH₂CH₂Si(OCH₃)₃
CH₃CH₂CH₂CH₂-[Si(CH₃)₂O]ₙ₁Si(CH₃)₂-(CH₂)_{H1}-C(=O)NHCH₂CH₂CH₂Si(OCH₃)₃
[(CH₃)₃SiO)]₂(CH₃)Si-O-[Si(CH₃)₂O]ₙ₁Si(CH₃)₂-(CH₂)_{H1}-C(=O)NHCH₂CH₂CH₂Si(OCH₃)₃.
[(CH₃)₃SiO)]₃Si-O-[Si(CH₃)₂O]ₙ₁Si(CH₃)₂-(CH₂)_{H1}-C(=O)NHCH₂CH₂CH₂Si(OCH₃)₃
CH₃-[Si(CH₃)₂O]ₙ₁Si(CH₃)2-(CH₂)_{H1}-O-(CH₂)_{H2}-C(=O)NHCH₂CH₂CH₂Si(OCH₃)₃
CH₃CH₂CH₂CH₂-[Si(CH₃)₂O]ₙ₁Si(CH₃)₂-(CH₂)_{H1}-O-(CH₂)_{H2}-C (=O)NHCH₂CH₂CH₂Si(OCH₃)₃
CH₃-[Si(CH₃)₂O]ₙ₁Si(CH₃)2-(CH₂)_{H1}⁻ C(=O)NHCH₂CH[CH₂CH₂CH₂Si(OCH₃)₃]₂
CH₃CH₂CH₂CH₂-[Si(CH₃)₂O]ₙ₁Si(CH₃)2-(CH₂)H1⁻ C (=O)NHCH₂CH[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}-C(=O)NHCH₂CH[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-C(=O)NHCH₂CH[CH₂CH₂CH₂Si(OCH₃)₃]₂
CH₃-[Si(CH₃)₂O]ₙ₁Si(CH₃)₂-(CH₂)_{H1}-O-(CH₂)_{H2}-C(=O)NHCH₂CH[CH₂CH₂CH₂Si(OCH₃)₃]₂
CH₃CH₂CH2CH₂-[Si(CH₃)₂O]ₙ₁Si(CH₃)₂-(CH₂)_{H1}-O-(CH₂)_{H2}-C(=O)NHCH₂CH[CH₂CH₂CH₂Si(OCH₃)₃]₂
CH₃-[Si(CH₃)₂O]ₙ₁Si(CH₃)2-(CH₂)H1-C(=O)NHCH₂CH[CH₂CH₂CH₂CH₂CH₂CH₂CH₂CH₂CH₂CH₂CH₂Si(OCH₃)₃]₂
CH₃CH₂CH₂CH₂-[Si(CH₃)₂0]ₙ₁Si(CH₃)2⁻(CH₂)_{H1}⁻ C(=O)NHCH₂CH[CH₂CH₂CH₂CH₂CH₂CH₂CH₂CH₂CH₂CH₂CH₂Si(OCH₃)₃]₂
[(CH₃)₃SiO)]₂(CH₃)Si-O-[Si(CH₃)₂O]ₙ₁Si(CH₃)2⁻(CH₂)_{H1}-C (=O)NHCH₂CH[CH₂CH₂CH₂CH₂CH₂CH₂CH₂CH₂CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-C(=O)NHCH₂CH [CH₂CH₂CH₂CH₂CH₂CH₂CH₂CH₂CH₂CH₂CH₂Si(OCH₃)₃]₂
CH₃-[Si(CH₃)₂O]ₙ₁Si(CH₃)₂-(CH₂)_{H1}-O-(CH₂)_{H2}-C(=O)NHCH_{2C}H[CH₂CH₂CH₂CH₂CH₂CH₂CH₂CH₂CH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)_{H2}-C(=O)NHCH_{2C}H[CH₂CH₂CH₂CH₂CH₂CH₂CH₂CH₂CH₂CH₂CH₂Si(OCH₃)₃]₂
CH₃-[Si(CH₃)₂O]ₙ₁Si(CH₃)₂-(CH₂)_{H1}-C(=O)N[CH₂CH₂CH₂Si(OCH₃)₃]₂
CH₃CH₂CH₂CH₂-[Si(CH₃)₂O]ₙ₁Si(CH₃)₂-(CH₂)_{H1}-C(=O)N[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}-C (=O)N[CH₂CH₂CH₂Si(OCH₃)₃]₂
[(CH₃)₃SiO)]₃Si-O-[Si(CH₃)₂O]ₙ₁Si(CH₃)2-(CH₂)_{H1}-C(=O)N[CH₂CH₂CH₂Si(OCH₃)₃]₂
CH₃- [Si(CH₃)₂O]ₙ₁Si(CH₃)₂-(CH₂)_{H1}-O-(CH₂)_{H2}-C(=O)N[CH₂CH₂CH₂Si(OCH₃)₃]₂
CH₃CH₂CH₂CH₂-[Si(CH₃)₂O]ₙ₁Si(CH₃)2-(CH₂)_{H1}-O-(CH₂)_{H2}-C(=O)N[CH₂CH₂CH₂Si(OCH₃)₃]₂
CH₃-[Si(CH₃)₂O]ₙ₁Si(CH₃)₂-(CH₂)_{H1}-N[CH₂CH₂CH₂Si(OCH₃)₃]₂ CH₃CH₂CH₂CH₂-[Si(CH₃)₂O]ₙ₁Si(CH₃)₂-(CH₂)_{H1}-N[CH₂CH₂CH₂Si(OCH₃)₃]₂
[(CH₃)₃SiO)]₂(CH₃)Si-O-[Si(CH₃)₂O]ₙ₁Si(CH₃)₂-(CH₂)_{H1}-N[CH₂CH₂CH₂Si(OCH₃)₃]₂
[(CH₃)₃SiO)]₃Si-O-[Si(CH₃)₂O]ₙ₁Si(CH₃)₂-(CH₂)_{H1}-N[CH₂CH₂CH₂Si (OCH₃)₃]₂
CH₃-[Si(CH₃)₂O]ₙ₁Si(CH₃)2-(CH2)_{H1}-C(=O)NHCH₂C[CH₂CH₂CH₂Si(OCH₃)₃]₃
CH₃CH₂CH₂CH₂-[Si(CH₃)₂O]ₙ₁Si(CH₃)₂-(CH₂)_{H1}-C(=O)NHCH₂C[CH₂CH₂CH₂Si(OCH₃)₃]₃
[(CH₃)₃SiO)]₂(CH₃)Si-O-[Si(CH₃)₂O]ₙ₁Si(CH₃)₂-(CH₂)_{H1}-C(=O)NHCH₂C[CH₂CH₂CH₂Si(OCH₃)₃]₃
[(CH₃)₃SiO)]₃Si-O-[Si(CH₃)₂O]ₙ₁Si(CH₃)₂-(CH₂)m₁-C(=O)NHCH₂C[CH₂CH₂CH₂Si(OCH₃)₃]₃
CH₃-[Si(CH₃)₂O]ₙ₁Si(CH₃)₂-(CH₂)_{H1}-O-(CH₂)_{H2}-C(=O)NHCH₂C[CH₂CH₂CH₂Si(OCH₃) ₃]₃
CH₃CH₂CH₂CH₂-[Si(CH₃)₂O]ₙ₁Si(CH₃)₂-(CH₂)_{H1}-O-(CH₂)_{H2}-C(=O)NHCH₂C[CH₂CH₂CH₂Si(OCH₃)₃]₃
[(CH₃)₃SiO)]₂(CH₃)Si-(CH₂)_{H1}-C(=O)NHCH₂CH₂CH₂Si(OCH₃) ₃ [(CH₃)₃SiO)]₃Si-(CH₂)_{H1}-C(=O)NHCH₂CH₂CH₂Si(OCH₃)₃
[(CH₃)₃SiO)]₂(CH₃)Si-(CH₂)_{H1}-C(=O)NHCH₂CH[CH₂CH₂CH₂Si(OCH₃)₃]₂
[(CH₃)₃SiO)]₃Si-(CH₂)_{H1}-C(=O)NHCH₂CH[CH₂CH₂CH₂Si(OCH₃)₃]₂
[(CH₃)₃SiO)]₂(CH₃)Si-(CH₂)_{H1}-C(=O)NHCH₂CH[CH₂CH₂CH₂CH₂CH₂CH₂CH₂CH₂CH₂CH₂CH₂Si(OCH₃)₃]₂
[(CH₃)₃SiO)]₃Si-(CH₂)_{H1}-C(=O)NHCH₂CH[CH₂CH₂CH₂CH₂CH₂CH₂CH₂CH₂CH₂CH₂CH₂Si(OCH₃)₃]₂
[(CH₃)₃SiO)]₂(CH₃)Si-(CH₂)_{H1}-C(=O)N[CH₂CH₂CH₂Si(OCH₃)₃]₂
[(CH₃)₃SiO)]₃Si-(CH₂)_{H1}-C(=O)N[CH₂CH₂CH₂Si(OCH₃)₃]₂
[(CH₃)₃SiO)]₂(CH₃)Si-(CH₂)_{H1}-N[CH₂CH₂CH₂Si(OCH₃)₃]₂
[(CH₃)₃SiO)]₃Si-(CH₂)_{H1}-N[CH₂CH₂CH₂Si(OCH₃)₃]₂
[(CH₃)₃SiO)]₂(CH₃)Si-(CH₂)_{H1}-C(=O)NHCH₂C[CH₂CH₂CH₂Si(OCH₃)₃]₃
[(CH₃)₃SiO)]₃Si-(CH₂)_{H1}-C(=O)NHCH₂C[CH₂CH₂CH₂Si(OCH₃)₃]₃ 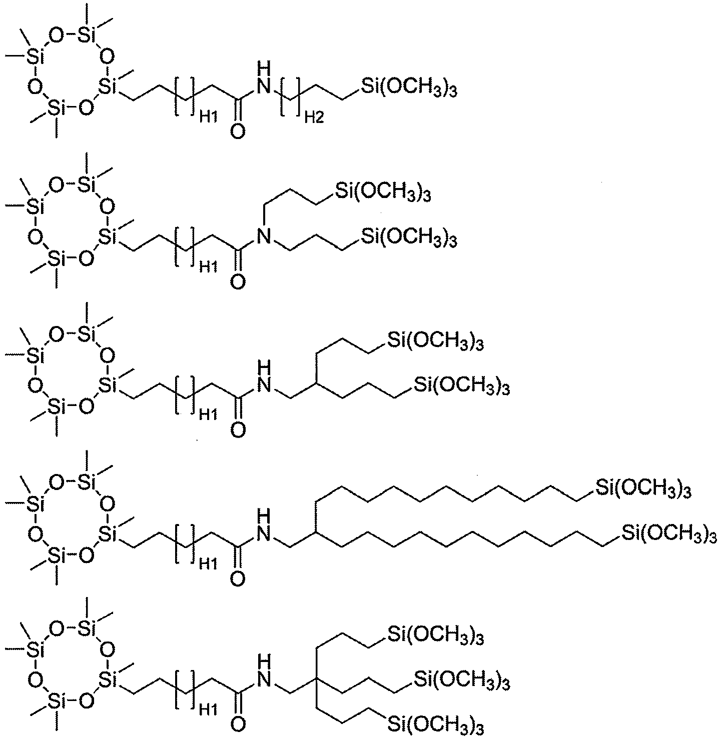
CH₃CH₂CH₂CH₂-[Si(CH₃)₂O]ₙ₁Si(CH3)₂-(CH2)_{H1}-O-(CH2)_{H2}-C(CH₂CH₃)[CH₂OC(=O)NHCH₂CH₂CH₂Si(OCH₃)₃]₂
CH₃-[Si(CH₃)₂O]ₙ₁Si(CH₃)₂-(CH₂)_{H1}-O-(CH₂)_{H2}-C(CH₂CH₃)[CH₂OC(=O)NHCH₂CH₂CH₂Si(OCH₃)₃]₂
CH₃CH₂CH₂CH₂-[Si(CH₃)₂O]ₙ₁Si(CH₃)₂-(CH2)_{H1}-O-(CH2)_{H2}-C(CH₂CH₃)[CH₂OC(=O)NHCH₂CH₂OC(=O)CH(CH₃)CH₂Si(OCH₃)₃]₂
CH₃-[Si (CH₃)₂O]ₙ₁Si(CH₃)₂-(CH2)_{H1}-O-(CH₂)_{H2}-C(CH₂CH₃)[CH₂OC(=O)NHCH₂CH₂OC(=O)CH(CH₃)CH₂Si(OCH₃)₃]₂
CH₃CH₂CH₂CH₂-[Si (CH₃)₂O]ₙ₁Si(CH₃)₂-(CH2)_{H1}-O-(CH2)_{H2}-C[CH₂OC(=O)NHCH₂CH₂CH₂Si(OCH₃)₃]₃
CH3-[(Si(CH₃)₂O)]ₙ₁Si(CH₃)₂-(CH₂)_{H1}-O-(CH₂)_{H2}-C[CH₂OC(=O)NHCH₂CH₂CH₂Si(OCH₃)₃]₃
[CH₃CH₂CH₂CH₂-[(Si (CH₃)₂O)]ₙ₁Si(CH₃)₂-(CH₂)_{H1}-O-(CH₂)_{H2}-]₂-C[CH₂OC(=O)NHCH₂CH₂CH₂Si(OCH₃)₃]₂
[CH₃-[(Si(CH₃)₂O)ₙ₁Si(CH₃)₂-(CH₂)_{H1}-O-(CH₂)_{H2}-]2-C[CH₂OC(=O)NHCH₂CH₂CH₂Si(OCH₃)₃]₂
CH₃CH₂CH₂CH₂-[Si(CH₃)₂O]ₙ₁Si(CH₃)₂-(CH₂)_{H1}-O-(CH₂)H₂-OC(=O)NHCH₂CH₂CH₂Si(OCH₃) ₃
CH₃-[Si(CH₃)₂O]ₙ₁Si(CH₃)2-(CH₂)_{H1}-O-(CH₂)_{H2}-OC(=O)NHCH₂CH₂CH₂Si(OCH₃) ₃
CH₃CH₂CH₂CH₂-[Si(CH₃)₂O]ₙ₁Si(CH₃)₂-(CH₂)_{H1}-O-(CH₂)_{H2}-OC(=O)NHCH₂CH₂OC(=O)CH(CH₃)CH₂Si(OCH₃)₃
CH₃-[Si(CH₃)₂O]ₙ₁Si(CH₃)₂-(CH₂)_{H1}-O-(CH₂)_{H2}-OC(=O)NHCH₂CH₂OC(=O)CH(CH₃)CH₂Si(OCH₃)₃
[CH₃CH₂CH₂CH₂-[Si(CH₃)₂O]ₙ₁Si(CH₃)₂-(CH₂)_{H1}-O-(CH₂)_{H2}-]₃C-CH₂OC(=O)NHCH₂CH₂CH₂Si(OCH₃)₃
[CH₃-[Si(CH₃)₂O]ₙ₁Si(CH₃)₂-(CH₂)_{H1}-O-(CH₂)_{H2}-]₃C-CH₂OC(=O)NHCH₂CH₂CH₂Si(OCH₃)₃
[CH₃CH2CH₂CH₂-[(Si(CH₃)₂O)]ₙ₁Si(CH₃)₂-(CH₂)_{H1}-O-(CH₂)_{H2}-]₂C(CH₂CH₃)[CH₂OC(=O)NHCH₂CH₂CH₂Si(OCH₃)₃]
[CH₃-[(Si(CH₃)₂O)]ₙ₁Si(CH₃)₂-(CH₂)_{H1}-O-(CH₂)_{H2}-]₂C(CH₂CH₃)[CH₂OC(=O)NHCH₂CH₂CH₂Si(OCH₃)₃] wherein
n1 is each independently an integer of 0 to 100, and
H1 and H2 are each independently an integer of 1 to 50.

7. The laminate according to claim 6,
wherein n1 is each independently 0 or 1,
H1 is each independently an integer of 8 to 40, and
H2 is each independently an integer of 1 to 10.

8. The laminate according to claim 6,
wherein n1 is each independently an integer of 5 to 100,
H1 is each independently an integer of 8 to 40, and
H2 is each independently an integer of 1 to 10.

9. The laminate according to claim 4, wherein the compound represented by the formula (1) is any one of the following compounds:
CH₃CH₂CH₂CH₂Si(CH₃)₂O(Si(CH₃)₂O)ₙSi(CH₃)₂CH₂CH₂CH₂OCH₂CON HCH₂CH₂CH₂Si(OCH₃)₃ (wherein n is an integer of 40 to 70);
CH₃CH₂CH₂CH₂Si(CH₃)₂-(OSi(CH₃)₂)ₙ-(CH₂)₃-OCH₂-CONH-CH₂C{CH₂CH₂CH₂Si(OCH₃)₃}₃ (wherein n is an integer of 40 to 70); 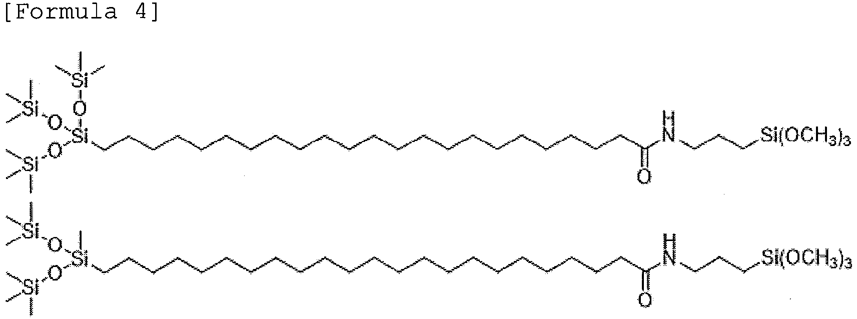
CH₃Si(CH₃)₂O(Si(CH₃)₂O)ₙSi(CH₃)₂(CH₂)₁₀CONHCH₂CH₂CH₂Si(OC H₃)₃ (wherein n is an integer of 10 to 30);
(CH₃)₃Si-(OSi(CH₃)₂)ₙ-(CH₂)₁₀-CON[CH₂CH₂CH₂Si(OCH₃)₃]₂ (wherein n is an integer of 10 to 30);
[(CH₃)₃SiO]₂CH₃SiO(Si(CH₃)₂O)ₙSi(CH₃)₂CH₂CH₂CH₂CH₂CH₂CH₂C H₂CH₂CH₂CH₂CH₂CH₂CH₂CH₂CH₂CH₂CH₂CH₂CH₂CH₂CH₂CH₂CONHCH₂CH[CH₂CH₂ CH₂Si(OCH₃)₃]₂ (wherein n is an integer of 20 to 40);
CH₃[Si(CH₃)₂O]ₙSi(CH₃)₂(CH₂)₂₂CONH-CH₂CH[CH₂CH₂CH₂Si(OCH₃)]₂ (wherein n is an integer of 40 to 70);
CH₃CH₂CH₂CH₂-[Si(CH₃)₂O]Si(CH₃)₂-CH₂CH₂CH₂-O-CH₂-C(CH₂CH₃)[CH₂OC(=O)NHCH₂CH₂CH₂Si(OCH₃)₃]₂ (wherein n is an integer of 40 to 80);
CH₃CH₂CH₂CH₂-[Si(CH₃)₂O]ₙSi(CH₃)₂-CH₂CH₂CH₂-O-CH₂CH₂O-C(=O)NHCH₂CH₂CH₂Si(OCH₃) ₃ (wherein n is an integer of 40 to 80); 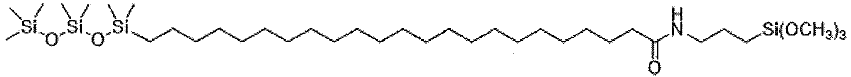 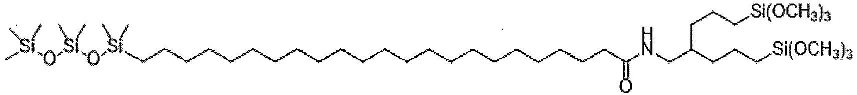
CH₃[Si(CH₃)₂O]ₙSi(CH₃)₂(CH₂)₂₂CON[CH₂CH₂CH₂Si(OCH₃)₃]₂ (wherein n is an integer of 20 to 40);
CH₃(Si(CH₃)₂O)ₙSi(CH₃)₂(CH₂)₂₂CON[CH₂CH₂CH₂Si(OCH₃)₃]₂ (wherein n is an integer of 20 to 50); and
CH₃[Si(CH₃)₂O]ₙSi(CH₃)₂(CH₂)₂₂CON[(CH₂)₃Si(OCH₃)₃]₂ (wherein n is an integer of 40 to 60).

10. The laminate according to any one of claims 1 to 9, wherein the water-repellent layer is a cured product of a mixture of a compound represented by the formula (1) and a compound represented by the following formula (2):
[Formula 5]
R^{A}_{α1}-X^{A}-R^{Si}_{β1} (2)
wherein
R^{A} is a carbon chain containing at least one ethereal oxygen atom,
X^{A} is a single bond, or a di- to decavalent group,
R^{Si} has the same meaning as R^{Si} in the compound represented by the formula (1),
α1 is each independently an integer of 1 to 9, and
β1 is each independently an integer of 1 to 9.

11. The laminate according to any one of claims 1 to 10, wherein a water contact angle of the water-repellent layer is 103° or more.

12. An article comprising the laminate according to any one of claims 1 to 11.

13. The article according to claim 12, comprising, between the substrate and the water-repellent layer, a silicon oxide-containing intermediate layer.

14. The article according to claim 13, wherein the intermediate layer comprises an alkali metal atom.

15. The article according to claim 14, wherein at least some of the alkali metal atoms are sodium atoms.

16. The article according to any one of claims 12 to 15, which is an optical member.

17. The article according to any one of claims 12 to 16, which is a display.

18. A compound represented by any of the following formulae:
(CH₃)₃SiO-Si(CH₃)₂O-Si(CH₃)₂-(CH₂)_{H1}-C(=O)NHCH₂CH₂CH₂Si(OCH₃)₃
(CH₃)₃SiO-Si(CH₃)₂O-Si(CH₃)₂-(CH₂)_{H1}-C(=O)NHCH₂CH[CH₂CH₂CH₂Si(OCH₃)₃]₂
(CH₃)₃SiO-Si(CH₃)₂O-Si(CH₃)₂-(CH₂)_{H1}-C(=O)N[CH₂CH₂CH₂Si(OCH₃)₃]₂
(CH₃)₃SiO-Si(CH₃)₂O-Si(CH₃)₂-(CH₂)_{H1}-C(=O)NHCH₂C[CH₂CH₂CH₂Si(OCH₃)₃]₃
wherein H1 is an integer of 11 to 50.
